(19) Europäisches Patentamt
European Patent Office
Office européen des brevets

(11) EP 0 577 766 B1

(12) **EUROPEAN PATENT SPECIFICATION**

(45) Date of publication and mention
of the grant of the patent:
**29.12.1999 Bulletin 1999/52**

(21) Application number: **92910849.6**

(22) Date of filing: **29.01.1992**

(51) Int Cl.6: **C23C 14/34**, C23C 14/56

(86) International application number:
**PCT/US92/00722**

(87) International publication number:
**WO 92/17621 (15.10.1992 Gazette 1992/26)**

(54) **APPARATUS AND METHOD FOR HIGH THROUGHPUT SPUTTERING**

VERFAHREN UND VORRICHTUNG ZUM SPUTTERN MIT HOHER GESCHWINDIGKEIT

APPAREIL ET PROCEDE POUR PULVERISATION CATHODIQUE A HAUT DEBIT

(84) Designated Contracting States:
**DE**

(30) Priority: **04.04.1991 US 681866**

(43) Date of publication of application:
**12.01.1994 Bulletin 1994/02**

(73) Proprietor: **SEAGATE TECHNOLOGY, INC.
Scotts Valley, California 95067-0360 (US)**

(72) Inventors:
 • **HOLLARS, Dennis, R.
 Los Gatos, CA 95030 (US)**
 • **WALTRIP, Delbert, F.
 San Jose, CA 95125 (US)**

 • **BONIGUT, Josef
 Alamo, CA 94507 (US)**
 • **SMITH, Robert, M.
 Antioch, CA 94509 (US)**
 • **PAYNE, Gary, L.
 Sunnyvale, CA 94086 (US)**
 • **ZUBECK, Robert, B.
 Los Altos, CA 94024 (US)**

(74) Representative: **BROOKES & MARTIN
High Holborn House
52/54 High Holborn
London, WC1V 6SE (GB)**

(56) References cited:
**US-A- 4 663 009       US-A- 4 749 465
US-A- 4 894 133**

**Description**

The present invention relates to high throughput sputtering apparatus and method for providing a single or multi-layered coating.

Through the specification we refer to the following units, and we list herewith the SI equivalents:- microns (for pressure), 1 micron equals 0.001 torr(1 torr equals 133.32 N/m$^2$), angstrom (1 angstrom equals 10 $^{-10}$m), ft/minute (1 ft/minute equals 0.3048m/min), cubic ft (1 cubic ft equals 0.028m$^3$), inch (1 inch equals 25.4 mm), psi (1 psi equals 6.89kn/m$^2$).

1. <u>Field of the Invention</u>

The invention relates to an apparatus and method for depositing multilayer thin films in a magnetron sputtering process. More particularly, the invention relates to an apparatus and method for depositing thin magnetic films for magnetic recording media in a high volume, electronically controlled, magnetron sputtering process, and to productions of an improved magnetic recording disk product thereby.

2. <u>Description of the Related Art</u>

Sputtering is a well-known technique for depositing uniform thin films on a particular substrate.

US 4,663,009 discloses a processing apparatus having a plurality of vacuum deposition chambers along a path and a transporter carries substrates along the path and the substrates are sputtered in the vacuum chambers.

US 4,749,465 discloses a somewhat similar arrangement as does US 4,894,133.

Thus as is shown in the prior documents, sputtering is performed in an evacuated chamber using an inert gas, typically argon, with one or more substrates remaining static during deposition, being rotated about the target (a "planetary" system) or being transported past the target (an "in-line" system).

Fundamentally, the technique involves bombarding the surface of a target material to be deposited as the film with electrostatically accelerated argon ions. Generally, electric fields are used to accelerate ions in the plasma gas, causing them to impinge on the target surface. As a result of momentum transfer, atoms and electrons are dislodged from the target surface in an area known as the erosion region. Target atoms deposit on the substrate, forming a film.

Typically, evacuation of the sputtering chamber is a two-stage process in order to avoid contaminant-circulating turbulence in the chamber. First, a throttled roughing stage slowly pumps down the chamber to a first pressure, such as about 50 microns. Then, high vacuum pumping occurs using turbo-, cryo- or diffusion pumps to evacuate the chamber to the highly evacuated base pressure (about 10$^{-7}$ Torr) necessary to perform sputtering. Sputtering gas is subsequently provided in the evacuated chamber, backfilling to a pressure of about 2-10 microns.

The sputtering process is useful for depositing coatings from a plurality of target materials onto a variety of substrate materials, including glass, nickel-phosphorus plated aluminum disks, and ceramic materials. However, the relatively low sputtering rate achieved by the process solely relying on electrostatic forces (diode sputtering) may be impracticable for certain commercial applications where high volume processing is desired. Consequently, various magnet arrangements have been used to enhance the sputtering rate by trapping electrons close to the target surface, ionizing more argon, increasing the probability of impacting and dislodging target atoms and therefore the sputtering rate. In particular, an increased sputtering rate is achieved by manipulation of a magnetic field geometry in the region adjacent to the target surface.

Sputter deposition performed in this manner is generally referred to as magnetron sputtering.

The magnetic field geometry may be optimized by adjusting the polarity and position of individual magnets used to generate magnetic fields with the goal of using the magnetic field flux paths to enhance the sputtering rate. For example, U.S. Patent No. 4,166,018, issued August 28, 1989 to J. S. Chapin and assigned to Airco, Inc., describes a planar direct current (d.c.) magnetron sputtering apparatus which uses a magnet configuration to generate arcuate magnetic flux paths (or lines) that confine the electrons and ions in a plasma region immediately adjacent to the target erosion region. A variety of magnet arrangements are suitable for this purpose, as long as one or more closed loop paths of magnetic flux is parallel to the cathode surface, e.g., concentric ovals or circles.

The role of the magnetic field is to trap moving electrons near the target. The field generates a force on the electrons, inducing the electrons to take a spiral path about the magnetic field lines. Such a spiral path is longer than a path along the field lines, thereby increasing the chance of the electron ionizing a plasma gas atom, typically argon. In addition, field lines also reduce electron repulsion away from a negatively biased target. As a result, a greater ion flux is created in the plasma region adjacent to the target with a correspondingly enhanced erosion of target atoms from an area which conforms to a shape approximating the inverse shape of the field lines. Thus, if the field above the target is configured in arcuate lines, the erosion region adjacent to the field lines conforms to a shallow track, leaving much of the target unavailable for sputtering.

Even lower target utilization is problematic for magnetic targets because magnetic field lines tend to be concentrated within, and just above, a magnetic target. With increasing erosion of the magnetic target during sputtering, the field strength above the erosion region increases as more field lines 'leak' out from the target, trapping more electrons and further intensifying the plasma close to the erosion region. Consequently, the erosion region is limited to a narrow valley.

In addition to achieving high film deposition rates, sputtering offers the ability to tailor film properties to a considerable extent by making minor adjustments to process parameters. Of particular interest are processes yielding films with specific crystalline microstructures and magnetic properties. Consequently, much research has been conducted on the effects of sputtering pressures, deposition temperature and maintenance of the evacuated environment to avoid contamination or degradation of the substrate surface before film deposition.

Alloys of cobalt, nickel and chromium deposited on a chromium underlayer (CoNiCr/Cr) are highly desirable as films for magnetic recording media such as disks utilized in Winchester-type hard disk drives. However, on disk substrates, in-line sputtering processes create magnetic anisotropies which are manifested as signal waveform modulations and anomalies in the deposited films.

Anisotropy in the direction of disk travel through such in-line processes is understood to be caused by crystalline growth perpendicular to the direction of disk travel as a result of the deposition of the obliquely incident flux of target atoms as the disk enters and exits a sputtering chamber. Since magnetic film properties depend on crystalline microstructure, such anisotropy in the chromium underlayer can disrupt the subsequent deposition of the magnetic CoNiCr layer in the preferred orientation. The preferred crystalline orientation for the chromium underlayer is with the closely packed, bcc (110) plane parallel to the film surface. This orientation for the chromium nucleating layer forces the 'C' axis of the hcp structure of the magnetic cobalt-alloy layer, i.e., the easy axis of magnetization, to be aligned in the film plane. Similarly, the orientation of the magnetic field generated in the sputtering process may induce an additional anisotropy which causes similar signal waveform modulations. See, Uchinami, et al., "Magnetic Anisotropies in Sputtered Thin Film Disks", IEEE Trans. Magn., Vol. MAG-23, No. 5, 3408-10, Sept. 1987, and Hill, et al., "Effects of Process Parameters on Low Frequency Modulation on Sputtered Disks for Longitudinal Recording", J. Vac Sci. Tech., Vol. A4, No. 3, 547-9, May 1986 (describing magnetic anisotropy phenomena).

Several approaches have been taken to eliminate the aforementioned waveform modulation problems while enhancing magnetic properties in the coating, especially coercivity. For instance, U.S. Patent No. 4,816,127, issued March 28, 1989 to A. Eltoukhy and assigned to Xidex Corp., describes one means for shielding the substrate to intercept the obliquely incident target atoms. In addition, Teng, et al., "Anisotropy-Induced Signal Waveform Modulation of DC Magnetron Sputtered Thin Films", IEEE Trans. Magn., Vol. MAG-22, 579-581, 1986, and Simpson, et al., "Effect of Circumferential Texture on the Properties of Thin Film Rigid Recording Disks", IEEE Trans. Magn., Vol. MAG-23, No. 5, 3405-7, Sept. 1987, suggest texturizing the disk substrate surface prior to film deposition. In particular, the authors propose circumferential surface grooves to promote circumferentially oriented grain growth and thereby increase film coercivity.

Other approaches to tailoring film properties have focused on manipulating the crystalline microstructure by introducing other elements into the alloy composition. For example, Shiroishi, et al., "Read and Write Characteristics of Co-Alloy/Cr Thin Films for Longitudinal Recording", IEEE Trans. Magn., Vol. MAG-24, 2730-2, 1988, and U.S. Patent No. 4,652,499, issued March 24, 1987 to J. K. Howard and assigned to IBM, relate to the substitution of elements such as platinum (Pt), tantalum (Ta), and zirconium (Zr) into cobalt-chromium (CoCr) films to produce higher coercivity and higher corrosion resistance in magnetic recording films.

CoCr alloys with tantalum (CoCrTa) are particularly attractive films for magnetic recording media. For example, it is known in the prior art to produce CoCrTa films by planetary magnetron sputtering processes using individual cobalt, chromium and tantalum targets or using cobalt-chromium and tantalum targets.

Fisher, et al., "Magnetic Properties and Longitudinal Recording Performance of Corrosion Resistant Alloy Films", IEEE Trans. Magn., Vol. MAG 22, no. 5, 352-4, Sept. 1986, describe a study of the magnetic and corrosion resistance properties of sputtered CoCr alloy films. Substitution of 2 atomic percent (at.%) Ta for Cr in a Co-16 at.% Cr alloy (i.e., creating a Co-14 at,% Cr-2 at.% Ta alloy) was found to improve coercivity without increasing the saturation magnetization. In particular, a coercivity of 1400 Oe was induced in a 400 Å film. In addition, linear bit densities from 8386 flux reversals/cm to 1063 flux reversals/cm (21300 fci to 28100 fci) were achieved at -3 dB, with a signal-to-noise (SNR) ratio of 30 dB. Moreover, corrosion resistance of CoCr and CoCrTa films was improved relative to CoNi films.

U.S. Patent No. 4,940,548, issued on August 21, 1990 to Furusawa, et al., and assigned to Hitachi, Ltd., discloses the use of Ta to increase the coercivity and corrosion resistance of CoCr (and CoNi) alloys. CoCr alloys with 10 at.% Ta (and chromium content between 5 and 25 at.%) were sputtered onto multiple layers of chromium to produce magnetic films with low modulation even without texturing the substrate surface and highly desirable crystalline microstructure and magnetic anisotropy.

Development of a high throughput in-line system to produce sputtered CoCrTa films with enhanced magnetic and corrosion-resistance properties for the magnetic recording media industry has obvious economic advantages.

Linear recording density of magnetic films on media used in Winchester-type hard disk drives is known to be enhanced by decreasing the flying height of the magnetic recording head above the recording medium. With reduced flying height, there is an increased need to protect the magnetic film layer from wear. Magnetic films are also susceptible to corrosion from vapors present even at trace concentrations within the magnetic recording system. A variety of films have been employed as protective overlayers for magnetic films, including rhodium, carbon and inorganic nonmetallic carbides, nitrides and oxides, like silica or alumina. However, problems such as poor adhesion to the magnetic layer and inadequate wear resistance have limited the applicability of these films. U.S. Patent No. 4,503,125 issued on March 3, 1985 to Nelson, et al. and assigned to Xebec, Inc. describes a protective carbon overcoating for magnetic films where adhesion is enhanced by chemically bonding a sputtered layer of titanium between the magnetic layer and the carbon overcoating.

In the particular case of sputtered carbon, desirable film properties have been achieved by carefully controlling deposition parameters. For example, during the sputtering process, the amount of gas incorporated in the growing film depends on sputtering parameters like target composition, sputtering gas pressure and chamber geometry. U.S. Patent No. 4,839,244, issued on June 13, 1989 to Y. Tsukamoto and assigned to NEC Corp., describes a process for co-sputtering a protective graphite fluoride overlayer with an inorganic nonmetallic compound in a gaseous atmosphere which includes fluorine gas. U.S. Patent No. 4,891,114 issued on January 1, 1990 to Hitzfeld, et al., and assigned to BASF Aktiengesellschaft of Germany, relates to a d. c. magnetron sputtering process for an amorphous carbon protective layer using a graphitic carbon target.

As the wear-resistant layer for magnetic recording media, it is desirable that the carbon overlayer have a microcrystalline structure corresponding to high hardness. In other words, it is desirable during sputtering to minimize graphitization of carbon which softens amorphous carbon films. One means employed to moderate graphitization of sputtered carbon films is by incorporating hydrogen into the film. Such incorporation may be accomplished by sputtering in an argon atmosphere mixed with hydrogen or a hydrogencontaining gas, such as methane or other hydrocarbons.

Magnetron sputtering processes have been developed which have been somewhat successful in achieving high throughput. For example, U.S. Patent Nos. 4,735,840 and 4,894,133 issued to Hedgcoth on April 5, 1988 and April 16, 1990, respectively, describe a high volume planar d. c. magnetron in-line sputtering apparatus which forms multilayer magnetic recording films on disks for use in Winchester-type hard disk technology. The apparatus includes several consecutive regions for sputtering individual layers within a single sputtering chamber through which preheated disk substrates mounted on a pallet or other vertical carrier proceed at velocities up to about 10 mm/sec (1.97 ft/min), though averaging only about 3 mm/sec (0.6 ft/min). The first sputtering region deposits chromium (1,000 to 5,000 Å) on a circumferentially textured disk substrate. The next region deposits a layer (200 to 1,500 Å) of a magnetic alloy such as CoNi. Finally, a protective layer (200 to 800 Å) of a wear- and corrosion-resistant material such as amorphous carbon is deposited.

The apparatus is evacuated by mechanical and cryo pumps to a base pressure about $2 \times 10^{-7}$ Torr. Sputtering is performed at a relatively high argon pressure between 2 and $4 \times 10^{-2}$ Torr (20 to 40 microns) to eliminate anisotropy due to obliquely incident flux.

In optimizing a sputtering process to achieve high throughput, consideration should be given to other time-influenced aspects of the process apart from the sputtering rate. For example, substrate heating is typically accomplished with heaters requiring an extended dwell time to warm substrates to a desired equilibrium temperature. In addition, substrate transport speeds through the sputtering apparatus have been limited with respect to mechanisms using traditional bottom drive, gear/belt-driven transport systems. Such bottom drive systems generally have intermeshing gears and may be practically incapable of proceeding faster than a particular rate due to rough section-to-section transitions which may dislodge substrates from the carrier and/or create particulate matter from gear wear which contaminates the disks prior to or during the sputtering process. Thus, overall process throughput would be further enhanced by the employment of heating and transport elements which require minimal time to perform these functions.

Generally, prior art sputtering devices utilize relatively unsophisticated means for controlling the sputtering processes described therein. Such control systems may comprise standard optical or electrical metering monitored by a system operator, with direct electrical or electro-mechanical switching of components utilized in the system by the system operator. Such systems have been adequately successful for limited throughput of sputtered substrates. However, a more comprehensive system is required for higher throughput sputtering operations. Specifically, a control system is required which provides to the operator an extensive amount of information concerning the ongoing process through a relatively user-friendly environment. In addition, the control system must adequately automate functions both in series and in parallel where necessary to control every aspect of the sputtering system. Further, it is desirable to include within such a control system the capability to preset a whole series of operating parameters to facilitate rapid set-up of the system for processes employing myriad sputtering conditions.

## SUMMARY OF THE INVENTION

The present invention provides a high throughput sputtering apparatus for providing a single or multi-layer coating to the surface of a plurality of substrates, said apparatus comprising:

a plurality of substrate carriers;
a plurality of evacuated sputtering chambers separated by evacuated buffer chambers said sputtering chambers having a pressure within a pressure range which enables sputtering operations;
means for providing a gas in said sputtering chambers in a plasma state and within a pressure range to carry out sputtering operations;
an input end for introducing the substrates mounted on said substrate carriers into said chambers without substantially disrupting said pressure of said chambers:
means for rapid and uniform heating of the substrates to optimize film integrity during subsequent sputtering steps;
means for transporting substrates on said substrate carriers through said buffer and sputtering chambers at at least a first rate and a second, different rate of speed, including a coupling mechanism mounting the substrate carriers at the top thereof such that the substrate carriers are each suspended from the coupling mechanism during movement in the chambers of the apparatus;
shield means disposed between the transporting means and the chambers for shielding the substrates from particulate matter caused by the means for transporting the substrates; and
an output end for removing the sputtered substrates without contaminating said chambers.

The present invention also provides the sputtering process of claim 12. In a preferred embodiment the sputtering process steps comprise the substeps of:

sputtering a chromium underlayer
sputtering a magnetic layer over the chromium layer, and
sputtering a carbon layer over the magnetic layer.

## BRIEF DESCRIPTION OF THE DRAWINGS

The invention will be better understood by reference to the figures of the drawings wherein like numbers denote like parts throughout and wherein:
Figure 1 is a system plan view of the sputtering apparatus of the present invention.
Figure 2 is a cross sectional view along line 2-2 of the sputtering apparatus of the present invention as shown in Figure 1.
Figure 3 is a plan view of the sputtering apparatus of the present invention illustrating the physical relationship of the power supply and pumping subsystem components.
Figure 4 is an overview block diagram of the sputtering process of the present invention.
Figure 5 is a simplified perspective view of the means for texturing disk substrates used in the process of the present invention.
Figure 6 is a cross sectional view along line 6 - 6 of the cam wheel utilized in the means for texturing shown in Figure 5.
Figure 7 is a sectional magnified view of the texturing of a disk surface provided by the means for texturing disclosed in Figure 5.
Figure 8 is a surface view of one embodiment of a pallet for carrying disks through the sputtering apparatus of the present invention.
Figure 9 is a partial, enlarged view of the pallet of Figure 8.
Figure 10 is a partial, enlarged view of one region for carrying a disk in the pallet of Figure 9.
Figure 11 is a cross sectional view along 11-11 of the disk carrying region shown in Figure 10.
Figure 12 is an overview diagram of the pumping system used with the apparatus of the present invention.
Figure 13 is a side, partial cutaway view of a sputtering chamber utilized in the apparatus of the present invention.
Figure 14 is an assembled cross sectional view of the substrate transport mechanism, sputtering shields, and pallet viewed along line 14 - 14 of Figure 13.
Figure 15 is a cross sectional view of the main (or "dwell") heating lamp assembly and chamber.
Figure 16 is a view of the main heating lamp assembly along line 16 -16 in Figure 15.
Figure 17 is a view of the main heating lamp mounting tray and cooling lines along line 17 - 17 in Figure 15.
Figure 18 is a cross sectional view of the secondary (or "passby") heating lamp and chamber assembly.

Figure 19 is a view of the heating lamp assembly along line 19 - 19 in Figure 18.

Figure 20 is a view of the secondary heating lamp, mounting tray and cooling lines along line 20-20 in Figure 18.

Figure 21 is a perspective, partial view of a heat reflecting panel, pallet, and substrate transport system utilized in the apparatus present invention.

Figure 22 is a perspective, exploded view of a portion of a pallet, substrate transport mechanism, sputtering shield, and cathode assembly utilized in the sputtering apparatus of the present invention.

Figure 23 is a top view of the sputtering chamber shown in Figure 13.

Figure 24 is a cross-sectional, side view along line 24 - 24 of Figure 23.

Figure 25 is a partial perspective view of a first surface of the cathode portion of the magnetron of the present invention.

Figure 26 is a perspective view of a second surface of the cathode of the magnetron of the present invention, including cooling line inputs and magnet channels of the cathode.

Figure 27A is a cross-sectional, assembled view of a first embodiment of the magnet configuration in the cathode for a nonmagnetic target of the present invention along line 27 - 27 of Figure 25.

Figure 27B is a cross-sectional, assembled views of a second embodiment of the magnet configuration in the cathode for magnetic target of the present invention along line 27 - 27 of Figure 25.

Figure 28 is a cross sectional view of the multi-layer sputtered thin film created by the process of the present invention.

Figure 29 is a block diagram of the electronic control system of the present invention.

Figure 30 is a block flow chart of functional aspects of the software utilized in the process controller(s) of the present invention.

Figure 31 is a flow chart of the automated cryogenic pump regeneration process of the present invention.

Figures 32A through 32D comprise a single logical flow diagram outlining the software logic controlling the motor assemblies, load lock and exit lock pumping, and heater power during the automatic substrate run mode of the software utilized in the electronic control system of the present invention.

## DESCRIPTION OF THE PREFERRED EMBODIMENT

### A. Introduction

Described herein is an apparatus and method for applying multilayer thin films to a substrate. The apparatus of the present invention is capable of applying the multilayer coatings to any given substrate within a time frame of approximately five minutes. The apparatus and process may provide production throughputs on the order of at least five times greater than those of prior art multi-layer coating processes.

Other advantages of the sputtering apparatus and method for high throughput sputtering include: flexibility with respect to the composition of the multilayer films applied and the types of substrates to which they are applied; easily interchanged coating components; a novel means for heating substrates; a novel sputtering magnetron design; a variable speed, overhead, noncontaminating substrate transportation system; and a comprehensive, centralized, programmable electronic means for controlling the apparatus and process. In addition, when the process and apparatus are used for providing magnetic coatings for substrates, such as disks, to be utilized in hard disk drives using Winchester-type technology, also disclosed herein are: a unique disk texturing method for improving the disk's magnetic recording properties, and a novel disk carrier (or pallet) design which contributes to uniform substrate heating characteristics in a large, single, high capacity pallet.

The high throughput process and apparatus of the present invention accomplishes the objectives of the invention and provides the above advantages by providing a comprehensive in-line sputtering system utilizing matched component elements to process multiple large single sheet or pallet transported discrete substrates in a continuous, variable speed, sputtering process wherein each substrate has a start-to-finish process time which is relatively constant. Such an apparatus and method can process up to 3,000 95mm disk substrates, and 5,300 65mm disk substrates, per hour. In the disk drive industry where cost savings per disk on the order of a few cents are a distinct advantage, the system manufactures 95mm disk substrates at a cost of $8.00 per disk as opposed to $12.00 per disk for other sputtering apparatus. Crucial to this process and apparatus are matching and optimizing such elements as disk preparation, including texturing and cleaning, provision of a sputtering environment with a sputtering apparatus, through an optimal vacuum pump system, transporting disk substrates through the sputtering environment in a high volume, high speed, contaminant-free manner without disturbing the sputtering environment, heating the substrates within the environment to optimal thermal levels for sputtering, and sputtering the substrates through a series of substantially isolated, non-crosscontaminating sputtering steps.

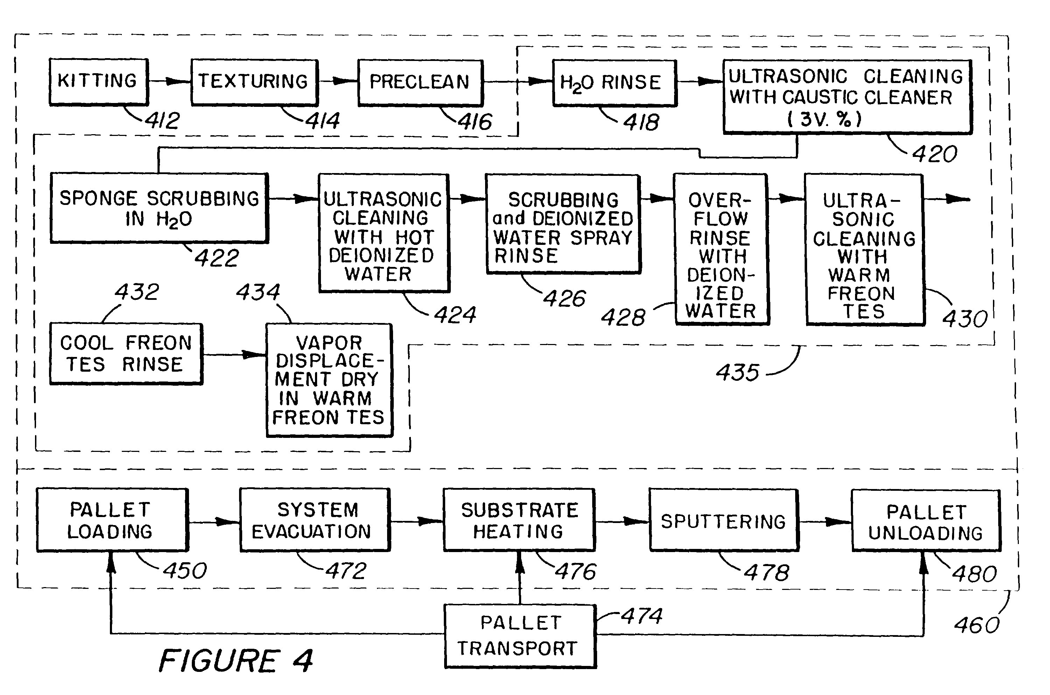

In general, application of multilayer films to a substrate involves two basic steps: preparation of the substrate and film deposition. Figure 4 represents a general overview of the process for applying thin films to a disk substrate according to the present invention. In particular, Figure 4 outlines the process steps for providing a single or multilayer film on a substrate, for example, a nickel-phosphorus plated aluminum disk for use in Winchester-type hard disk drives. It will be recognized by those skilled in the art that the steps outlined in Figure 4 may be modified, as required, depending on the particular type of substrate to be coated or thin film to be applied.

Substrate preparation process of Figure 4 includes: kitting process 412; disk texturing process 414, disk precleaning 416; water rinse 418; ultrasonic cleaning with caustic cleaner 420; a sponge scrubbing in water 422; an ultrasonic cleaning in hot deionized water 424; scrubbing and deionizing water spray rinse 426; overflow deionized water rinse 428; ultrasonic cleaning of the disks with warm FREON TES 430; a cool FREON TES rinse 432; and vapor displacement drying in warm FREON TES 434. Each of the aforementioned steps outlined in Figure 4 is discussed in further detail in Section C of the specification.

Subsequent to the substrate preparation process, the clean, dry disk substrates may be provided to pallet loading process 450, wherein the disk substrates are provided to a substrate carrier which transports the disk substrates through coating process 460.

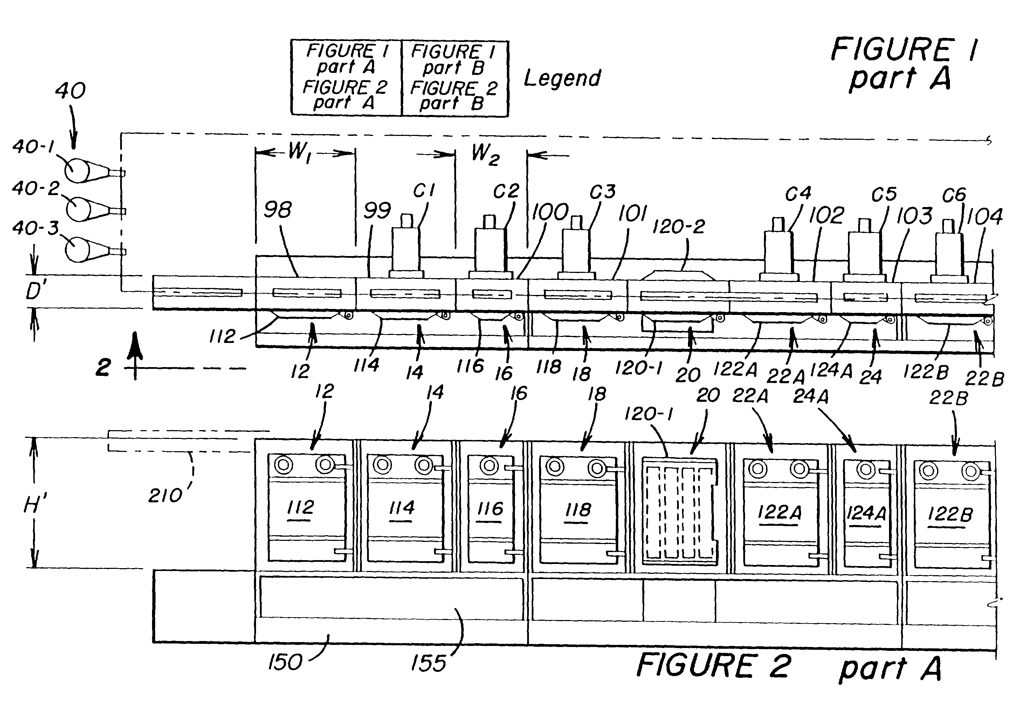

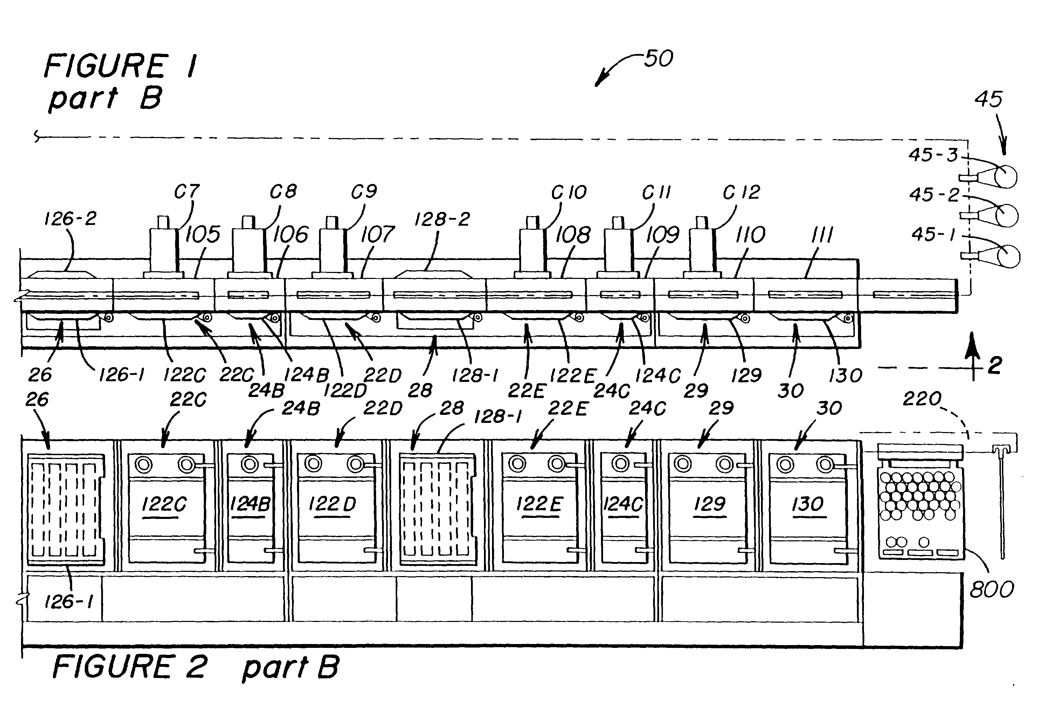

In coating process 460, disk substrates are provided to a coating apparatus, such as sputtering apparatus 10 shown in Figures 1 and 2, for provision of single or multilayer film thereon. The steps involved in coating process 460, such as in, for example, sputtering apparatus of the present invention, involve: a system evacuation process 472 wherein specific chambers of the sputtering system are evacuated to a pressure of approximately $10^{-7}$ Torr and back-filled with a suitable sputtering gas, such as argon; a substrate heating process 476, wherein the substrates are raised to a temperature conducive to optimal film deposition; and a sputtering process 478 wherein the films are deposited on the substrates. Subsequently, the substrates are provided to an unload process 480. A process for transporting pallets 474 provides means for transporting the substrates through the above processes.

Each of the aforementioned steps with respect to applying the multilayer films to the substrates is discussed below in detail in separate sections of this specification.

B. Sputtering Apparatus Overview

Sputtering apparatus, used to apply a single or multilayer film to one or more substrates, will be discussed generally with reference to Figures 1A, 1B, 2A, 2B, and 3. Sputtering apparatus provides a high throughput, in-line, magnetron sputtering process which allows reduced manufacturing costs per substrate by performing the coating sequence in a high volume manner. As will be discussed in detail below, single or multilayer film can be applied to a single side, or both sides, individually or simultaneously, of a single large sheet substrate, or to discrete substrates, such as disks mounted in a rack, pallet or other substrate carrier.

Generally, substrates are provided through multiple sputtering chambers 20, 26, 28 in apparatus at a rate of speed, such as 3-6 feet/minute, and through heater chambers 14,16 and buffer chambers 12, 18, 22A-E, 24A-24C, 29 and 30, at a second rate of speed, such as 12 feet/minute. Through carefully matched elements, each of the substrates has a constant speed through apparatus 10.

Sputtering apparatus includes seventeen (17) chamber modules 12-30 generally comprised of two basic types. A first type is configured for use as lock modules (12, 30), deposition process modules (20, 26, 28) or dwell modules (14, 18, 22A-22D and 29). A second type of module is configured for use as high vacuum buffer modules (16, 24A-24C) to provide process separation between deposition modules as discussed below.

Also shown in Figures 1 and 2 is substrate carrier return path 50 of the transport system of the present invention. Preferably, return path 50 is provided to allow an ample number of substrate carriers to return from exit lock 30 for reuse in sputtering apparatus 10 in a continuous process, thereby reducing production delays and increasing overall process production speed. In addition, Figures 1 and 2 illustrate robotic pallet loading station 40 and robotic pallet unloading station 45, arranged along the transport system return path 50, for automatic loading and unloading, respectively, of the disk substrates into racks or pallets. As discussed in detail below, the substrate transport system utilizes a plurality of individual transport beam platforms, each including one or more optical or proximity position sensors, to move substrates through sputtering apparatus 10 and along return path 50, and to monitor the position of each substrate carrier within the transport system. Transfer speeds of the substrate carriers throughout the transport system may be adjustably varied from 0 to 24 ft/min. It should be noted that the upper limit of substrate carrier transport speed is constrained by the process limits of sputtering apparatus 10. Each individual drive stage (2200, discussed in Section F of this specification) is identical and thus has identical upper and lower speed limits.

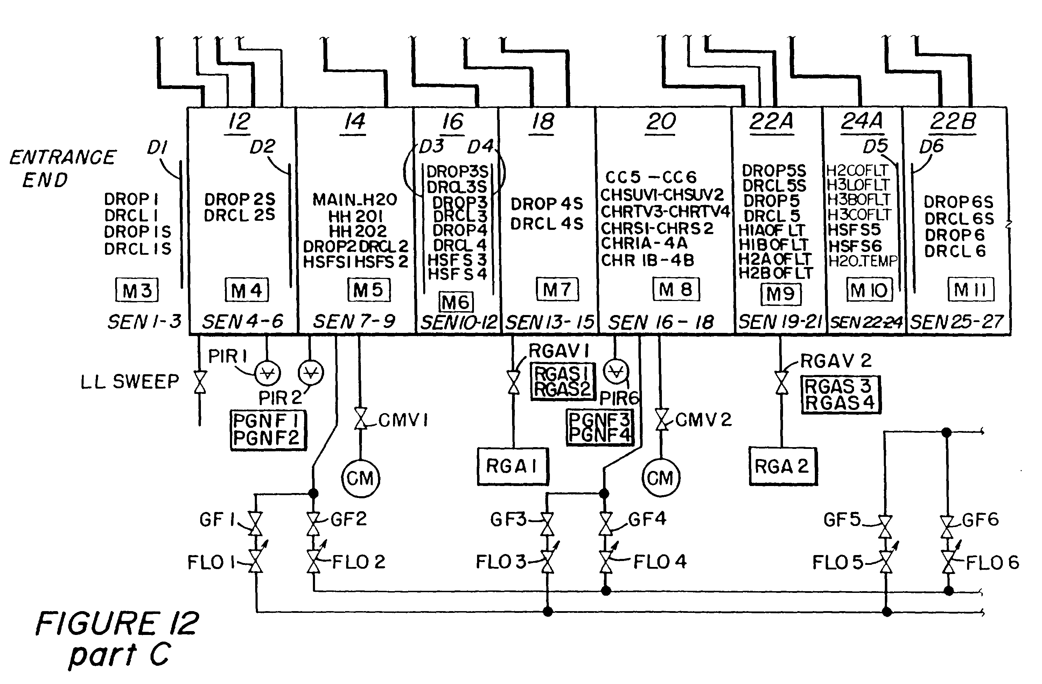

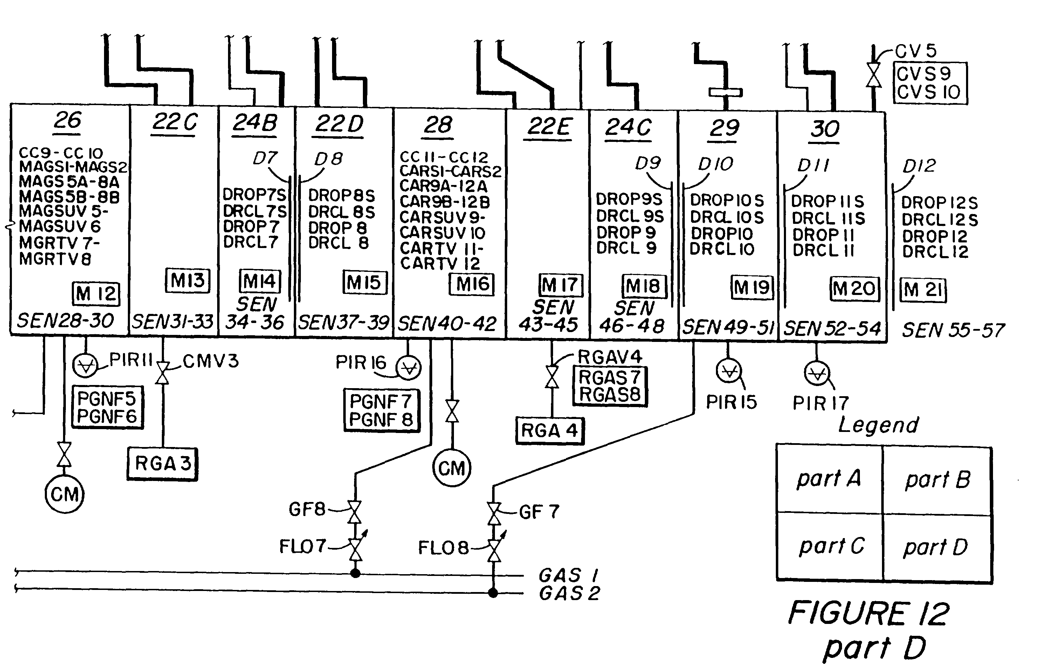

Twelve (12) pneumatically operated doors D1-D12 are placed between specific chamber modules 12-30 of sputtering apparatus 10. Doors D1-D12 are located as generally represented in Figure 12 and are positioned as follows: door D1 isolates chamber 12 from the ambient environment; door D2 isolates load lock chamber 12 from main ("dwell") heating chamber 14; door D3 isolates main heating chamber 14 from first buffer-passby heating chamber 16; door D4 isolates buffer chamber 16 from first dwell chamber 18; doors D5-D6 isolate second buffer chamber 24A from third dwell chamber 22B; doors D7-D8 isolate third buffer chamber 24B from fifth dwell chamber 22D; doors D9-D10 isolate fourth buffer chamber 24C from exit buffer 29; door D11 isolates exit buffer chamber 29 from exit lock chamber 30; and door D12 isolates exit lock chamber 30 from the ambient environment.

With reference to Figures 1-3 and 12, the general arrangement of chamber modules 12-30 will be hereinafter discussed. Load lock chamber 12 is essentially an isolation chamber between the ambient environment and chambers 14-29 of sputtering apparatus 10. Load lock chamber 12 is repeatedly evacuated between a pressure of approximately 50 mTorr and vented to ambient atmospheric conditions. Generally, sputtering within apparatus 10 takes place in an evacuated environment and chambers 16-29 are evacuated to the pressure of approximately $10^{-7}$ Torr, before argon gas is allowed to flow into the chambers to achieve a suitable sputtering pressure. Load lock chamber 12 is constructed of one-inch thick type 304 stainless steel and has a width $W_1$ of approximately 39 inches, length $L_1$ of approximately 49 inches, and a depth $D_1$ of approximately 12 inches as measured at the exterior walls of the chamber. The use of electropolished stainless steel in load lock chamber 12 and all other chambers in apparatus 10 minimizes particulate generation from scratches and other surface imperfections. Chambers 14, 18, 20, 22A-22D, 24A-24C, 26 and 28-30 have roughly the same dimensions. The internal volume of load lock chamber 12 is reduced to approximately three cubic feet by the installation therein of volume-displacing solid aluminum blocks bolted to the chamber door and rear wall (not shown) to facilitate faster evacuation times. Pump-down of load lock chamber 12, and sputtering apparatus 10 in general, is discussed below in Section F of the specification.

After door D1 is pneumatically operated to allow a single large substrate or pallet to enter load lock chamber 12 at the initiation of processing by sputtering apparatus 10, load lock chamber 12 will be evacuated to a pressure of 50 microns (50 mTorr). Chambers 16-29 will have been evacuated to a base pressure of about $10^{-7}$ Torr and then backfilled with argon to the sputtering pressure (approximately 9-12 mTorr) prior to the entrance of a substrate into load lock chamber 12. Chamber 14 will have been evacuated previously to a pressure of approximately $10^{-5}$ - $10^{-7}$ Torr. Load lock chamber 12 is thus mechanically evacuated and pressurized at a level intermediate to that of chambers 14-29, and external ambient pressures, to provide isolation for the downstream sputtering processes occurring in chambers 14-29.

Dwell heating chamber 14 serves two functions: it acts as an entrance buffer between load lock chamber 12 and the internal sputtering environment in chambers 16-29; and it serves as a heating chamber for increasing the substrate temperature to optimize film deposition. Chamber 14 includes eight banks of quartz lamp heating elements, four banks mounted to outer door 114 and four banks mounted opposite thereof on rear chamber wall 99. Door D2, separating load lock chamber 12 and dwell heating chamber 14, is a high vacuum slit valve. Details of the heating banks located in dwell heating chamber 14 are discussed in Section H of this specification.

During processing of a substrate, dwell heating chamber 14 is pumped to a pressure of approximately $10^{-5}$ - $10^{-7}$ Torr before the substrate present in load lock chamber 12 is allowed to pass into dwell heating chamber 14. A pressure of $10^{-5}$ - $10^{-7}$ Torr helps eliminate the effects of outgassing from the substrate in dwell heating chamber 14. Subsequently argon backfilling is provided to raise the pressure to approximately 9-12 mTorr, equalizing the environment in dwell heating chamber 14 with that in chambers 16-29. The substrate may thereafter remain in dwell heating chamber 14 for the duration of time necessary for the exposure of the substrate to the lamps to have its desired effect.

First buffer-passby heating chamber 16 is a chamber module of the second type having a width $W_2$ of approximately 26 inches by a height H' of approximately 49 inches by a depth D' of approximately 12 inches. In general, buffer chambers 16 and 24A-C are positioned between dwell chambers 18A and 22A-D to separate the ongoing sputtering processes within apparatus 10, thereby reducing cross-contamination of coating components.

First buffer-passby heating chamber 16 includes a heating assembly comprising ten banks of quartz lamp heating elements, five mounted to outer door 116 and five to the rear chamber 100 wall opposite thereof. Passby heating chamber 16 is designed to insure uniform substrate temperature prior to film deposition. The structure of the passby heating assembly is discussed in detail in Section H of this specification.

Three coating modules -- chromium deposition chamber 20, magnetic deposition chamber 26, and carbon deposition chamber 28 -- having dimensions roughly equal to those of load lock chamber 12 and constructed of type 304 electropolished stainless steel, may be utilized to sputter single or multilayer films on a substrate passing through apparatus 10. Four pairs of d. c. magnetron sputtering cathodes are mounted, four magnetrons per door, on doors 120-1, 120-2, 126-1, 126-2, 128-1, and 128-2 on both sides of each chamber 20, 26, and 28, respectively. Target materials are mounted to cathodes 2222-2225. Anodes 2338, gas manifolds 2323, and shielding 2230, 2236, 2238 and 2240 are also attached to outer doors 120-1, 120-2, 126-1, 126-2 and 128-1, 128-2. Mounting these components to the doors facilitates target changes and chamber maintenance. Further, conduits (not shown) for power, cooling, and process gases are provided in outer doors 120, 126, 128. Feedthrough conduits are also provided in doors 112, 114, 116, 118, 122A-122E, 124A-124C, 129, and 130 to allow for modification of the sputtering apparatus 10. Details of deposition chambers 20, 26 and 28 are provided in Section I of this specification.

Dwell chambers 18 and 22A-22E are manufactured to have the same dimensions as load lock chamber 12 and provide separation between the buffer modules and the deposition chambers. Dwell modules 18 and 22A-22E allow for substrate transport system runout, if necessary, during multiple substrate processing in sputtering apparatus 10. If desired, additional heating assemblies may be provided in any or all of dwell modules 22A-22E.

Exit buffer module 29 is essentially identical to dwell heating chamber 14, without the dwell heating assembly hardware. Exit buffer module 29 provides a buffer area to facilitate removal of pallets or substrates from sputtering apparatus 10 to exit lock chamber 30 and further isolates the sputtering process from the external environment.

Exit lock chamber 30 is essentially identical to load lock chamber 12 and operates in reverse pumping order, allowing pallets or substrates to be transferred from the evacuated environment of sputtering apparatus 10, to the ambient external environment.

Optimally, sputtering apparatus 10 can simultaneously process up to seven large single sheet substrates or pallets carrying smaller substrates, such as disks. When seven such substrates are simultaneously processed in sputtering apparatus 10, one such substrate is positioned in each of seven chambers, for example, as follows: load lock chamber 12; dwell heating chamber 14; chromium deposition chamber 20; magnetic deposition chamber 26; carbon deposition chamber 28; exit buffer chamber 29; and exit lock chamber 30. The sheer dimensions of sputtering apparatus 10 allow for a plurality of large single sheet substrates, and a plurality of high capacity discrete substrate carrying pallets, or both, to be simultaneously processed. The problems attending the development of such a large scale, high throughput sputtering apparatus, and the solutions adopted, are discussed herein.

Chambers 12-30 are mounted on steel assembly rack 150. Rack 150 includes channels 155 which preferably are used to mount components used with sputtering apparatus 10, such as those used in the electronic control system. It will be understood by those skilled in the art that any suitable arrangement for mounting chambers 12-30 may be made within contemplation of the present invention.

## C. Substrate Preparation

Various materials in the form of large single sheet or discrete substrates may be coated in sputtering apparatus 10. Suitable substrates include polished nickel-phosphorus plated aluminum disks, ceramic disks (available from Kyocera Industrial Ceramics Corporation, Los Angeles, California, or Corning Glass Corporation, Corning, New York), glass substrates (available from Pilkington Corporation Microelectronics, Ltd., Toledo, Ohio, Nederlandse Philips Bedrijven B.V., The Netherlands, or Glaverbel Corporation Data Storage Glass Products, Belgium), or carbon substrates or graphite substrates (Kao Corporation of Japan). The process and apparatus disclosed herein is discussed with regard to preparation and sputtering of polished nickel-phosphorus plated aluminum substrates, such as disks suitable for use in Winchester-type hard disk drives. As will be understood by those skilled in the art, the system is readily adaptable for use with other types of single sheet or discrete substrates as discussed above.

### 1. Kitting

In general, polished nickel-phosphorus plated aluminum disks or similar substrates utilized in the manufacture of magnetic recording media for Winchester-type hard disk drives, such as those available from Mitsubishi Corporation or Seagate Corporation, are shipped to magnetic media manufacturers in standard ribbed or slotted shipping cassettes, 25 substrates per cassette. Transfer of the substrates from the shipping cassettes to process cassettes, used in processing the disks through texturing process 414 and up through precleaning process 416, is known as kitting. Kitting must occur in a class 10,000 clean room environment and is generally performed manually.

### 2. Texturing

It is well known in the art that circumferential texturing or abrading of a substrate surface can cause the hcp "C" axis of a magnetic cobalt-alloy film to orient in a circumferential direction, and thereby supply a more intense and uniform read/back signal to a flying read/write head in a Winchester-type hard disk drive. Texturing the disk substrate also affects the glide properties of the read/write read. Obviously, the texture of the disk surface also provides a limit to the minimum flying height of the read/write head. Texturing of the substrate also prevents stiction which may result should the head land on a smooth, planar area of the disk, thereby resulting in a job-blocking effect, rendering it almost impossible to remove the stuck read/write head from the disk surface, and rendering a disk drive entirely inoperable.

Texturing generally takes place in a class 1,000 clean room and, as previously discussed, any number of well-known methods may be used.

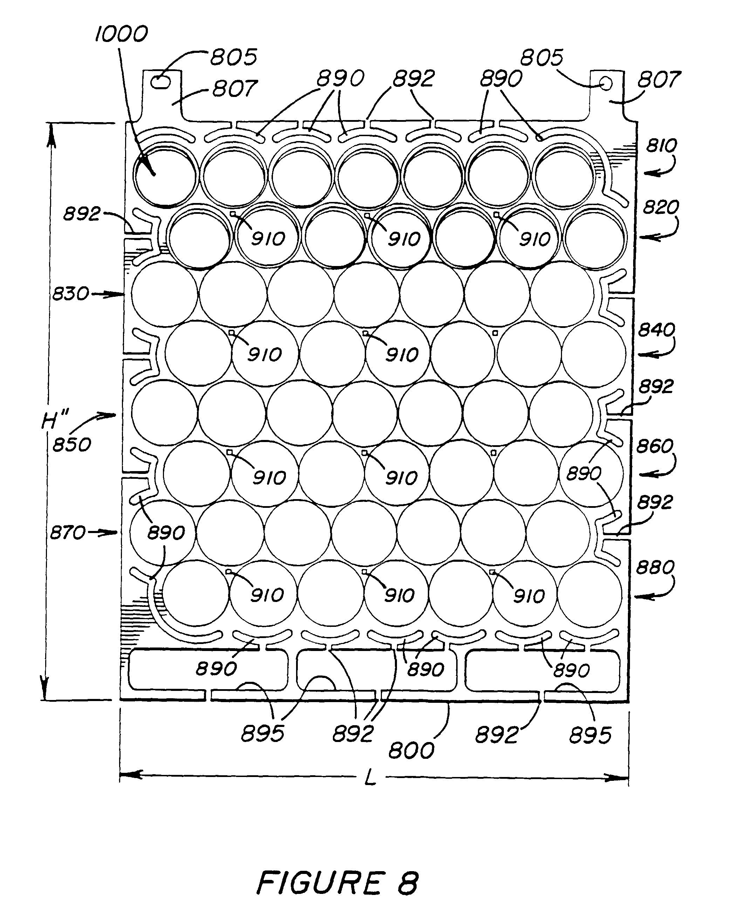

In the preparation of substrates to be coated within sputtering apparatus 10, a plurality of texturing machines, such as Exclusive Design Company's EDC Model C texturing machine, (EDC, 914 South Clairmont, San Mateo, California 94402) are used. A novel modification to each EDC texturing machine provides a unique, diamond-shaped texturing effect. A portion of a disk surface having such texturing is illustrated in Figure 7.

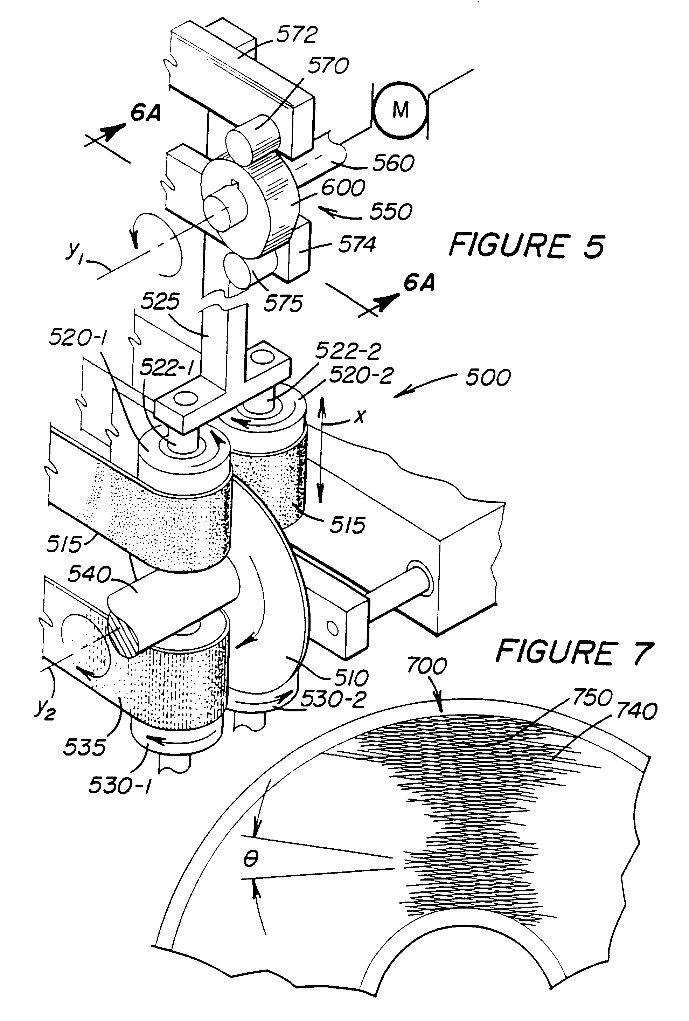

With reference to Figures 5 through 7, texturing process 414 will be hereinafter described in relation to the texturing of discrete disk substrates 510 suitable for use in sputtering apparatus 10.

Figure 5 is a general disclosure of the texturing portion 500 of texturing machine M.

Generally, texturing of disk substrate 510 is performed using two loops of fixed abrasive tape 515 which are stretched about rubber rollers 520-1, 520-2. Abrasive tape 515 for each roller 520 is provided by two reels, one supply reel and one take-up reel (not shown), in a single feed direction with a portion of abrasive tape 515 looped about rollers 520. Abrasive tape 515 makes only one transition from the supply reel to the take-up reel during a normal texturing cycle. Rollers 520-1 and 520-2 rotate about spindles 522-1 and 522-2, respectively, mounted to oscillation arm 525 of machine M.

A second set of rubber rollers 530-1, 530-2, and associated supply and take-up reels, (not shown), allow for mounting a fine cloth tape 535 to remove excess particulate matter generated by abrasive tape 515 as disk 510 is texturized. Like abrasive tape 515, cloth tape 535 is used only once from supply reel to take-up reel.

Cam assembly 550 causes arm 525, rollers 520-1, 520-2, and abrasive tape 515 to oscillate in the direction of axis X. Cam assembly 550 includes cam wheel 600 fixed by two set screws (not shown) to spindle 560 which is rotated in a counterclockwise direction about axis $Y_1$ by machine M. Cam wheel 600 contacts first and second rollers 570, 575, rotatably mounted to support members 572, 574, respectively, to translate the motion defined by rotation of cam wheels 600 to oscillation arm 525.

In operation, disk substrate 510 is mounted on spindle 540 of machine M and rotated in a clockwise direction about axis $Y_2$ passing through the center of spindle 540. To mount a disk substrate 510, machine M causes rollers 520 and 530 to linearly separate in opposing directions along paths parallel axes $Y_{1-2}$ allowing disk substrate 510 to be inserted and removed by an automatic loading apparatus (not shown) onto spindle 540. Disk substrate 510 is then rotated about axis $Y_2$ in a clockwise direction. Simultaneously thereto, abrasive tape 515 and cloth tape 535 are rotated about rollers 520-1, 520-2 and 530-1, 530-2, respectively, such that rollers 520-2 and roller 530-1 rotate in a clockwise direction, and rollers 520-1 and 530-2 rotate in a counterclockwise direction. Thus, opposing rollers 520-1, 520-2 and 530-1, 530-2 rotate in directions opposite to each other and in a direction opposing the direction of rotation of disk substrate 510, to provide optimal disk texturing and cleaning. As rollers 520 and 530 are rotated, machine M simultaneously rotates spindle 560, and hence cam wheel 600, causing rollers 520 to oscillate about axis X.

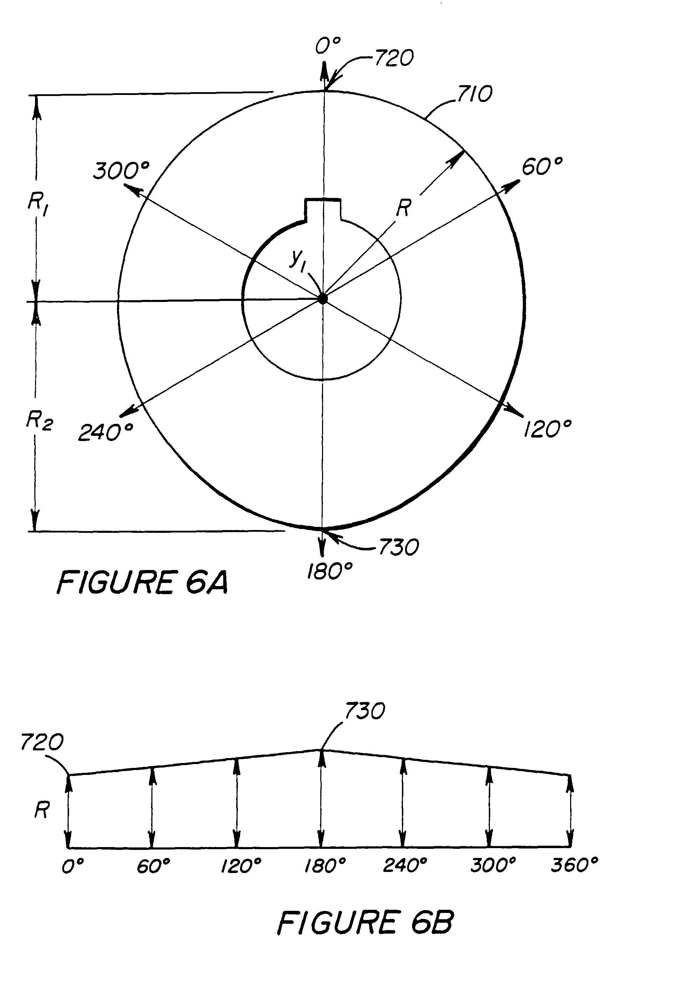

As a result of the unique shape cam wheel 600, discussed with reference with Figures 6A-6B, a novel cross-hatched type texturing 700 results. With reference to Figure 7, texturing process 414, discussed above, generally forms diamond-shaped areas 750 defined by a plurality of crossing texture lines 740 provided to a depth of 60 $\mu$m. When lines 740 intersect, they define a plurality of angles $\theta$ in a range of approximately 6 to 10 degrees. It has been determined that an angle greater than 10 degrees, while providing generally excellent properties of low dynamic friction and low stiction, results in problems with the magnetic recording properties such as bit dropouts or shifts in areas adjacent to intersecting texturing lines. To compensate, a higher coercivity alloy is required on the substrate. These problems are within acceptable levels when angle $\theta$ is within a range of 4°-10°. An angle of 6 degrees or less improves the magnetic recording capability of the record media, but sacrifices in stiction and running friction properties of the disk are made for $\theta$ less than 6 degrees. Preferably, when rotation $Y_1$ of cam wheel 600 is approximately 6 Hertz, angles $\theta$ of approximately 6° will result.

The structure of cam wheel 600 is detailed in Figure 6A and 6B. Figure 6A shows cross-section cam wheel 600 along line 6-6 in Figure 5. Cam wheel 600 has a shape wherein the radial distance R between axis $Y_1$ and outer edge 710 is at a minimum distance R1 at reference point 720, and at a maximum distance R2 at point 730, 180° opposite point 720.

Currently, two types of cams are used in the machine M for texturing disk substrates 510, depending on the size of disk substrate 510. In one embodiment, the distance R2 equals one inch and distance R1 = .760 inch. Figure 6B illustrates the distance of all points along outer edge 710 from axis $Y_1$. As can be seen therein, radial distance R from outer diameter 710 to axis Y1 is evenly sloped from the point 720 to point 730, of 180° opposite from point 720. Assuming a line from axis $Y_1$ to point 720 is used as a reference, the distance of all points along outer edge 710 from axis $Y_1$ in one embodiment is as follows: the distance R1 at point 720 = .756 inch, the distance at 60° and 300° angles from point 720 = .840 inch, the distance at 120° and 240° from point 720 = .920 inch, and the distance R2 at 180° from point 720 (point 730) = 1.00 inches.

In the above embodiment, cam wheel 600 may be manufactured by beginning with a completely circular cam wheel and removing outer edge 720 of cam wheel 600 in equal linear to rotational increments. For example, at point 730, no material is removed, moving 3 degrees to the left or right, the cutting device is adjusted to move in a distance toward axis $Y_1$ of approximately .004 inch, and is thereafter moved .004 inch closer to axis $Y_1$ for every 3° of rotational movement about axis $Y_1$. In this manner, one embodiment of cam wheel 600 may be manufactured; those skilled in the art will reccgnize that various sizes and types of cam wheels may be manufactured in like manner for various sizes of disk substrates 510.

3. Disk Cleaning

Following texturing, the disk surface is cleaned to facilitate uniform film deposition, for example, by performing the following steps, represented as stage 416 in Figure 4.

During precleaning process 416, each disk surface is rubbed with a polyurethane soap pad. In an automated process, textured disk substrates are removed from process cassettes and placed in a precleaning machine such as the Model MDS1, commercially available from Speed Fam Corporation of Tempe, Arizona. In the Speed Fam machine described above, a plurality of disk substrates is arranged about a large pad assembly in a cylindrical tank, thereby allowing rapid disk cleaning (up to 350 95-mm disks per hour) by performing precleaning process 416 on a number of disk substrates simultaneously.

An additional preparation step involves taking disk substrates through a multi-staged cleaning process 435. This process is illustrated generally in Figure 4 as stages 418 through 434. Each stage, for example, may represent a separate tank process wherein all tanks are connected with a conveyor system. In addition, transfer between individual stages may be performed by robots.

Specifically, disk substrates 510 are rinsed in water at stage 418, followed by several ultrasonic cleaning stages (420, 424 and 430) and sponge scrubbing stages (422 and 426). The multistage cleaning process 435 processing stages include water rinse 418; ultrasonic cleaning with caustic cleaner 420; a sponge scrubbing in water 422; an ultrasonic cleaning in hot deionized water 424; ultrafiltered deionized water spray rinse 426; overflow deionized water rinse 428; ultrasonic cleaning of disk substrates with warm FREON TES 430; a cool FREON TES rinse 432; and vapor displacement drying in warm FREON TES 434.

Application of ultrasonic power is particularly useful in scouring the newly-applied fine cross-texturing grooves on the disk surface. Stages 420, 424 and 426 combine ultrasonic action in liquids with alkali and aqueous cleaning agents for thorough cleaning. Stage 430 combines ultrasonic action with a degreasing solvent like DuPont's FREON TES.

Multistage cleaning process 435 is preferably performed by a Speed Fam Model MD08 cleaning machine. The Speed Fam model MD08 with certain modifications, is suitable for performing this final cleaning process, to maintain the high level of substrate cleanliness prior to film deposition. Specifically, modifications to the Speed Fam MD08 machine include passivated stainless steel tanks and recirculation lines, brush materials such as polyvinylalcohol, and a highly efficient tank filtration system. In addition, standard process cassette rollers are replaced with highly wear-resistant plastics like DuPont's DELRIN polymethylene oxide. The process regimen 410, as illustrated by Figure 4, was found to be capable of handling approximately 550-750 disks per hour, using two Speed Fam model MDS1 polishing machines and one Speed Fam model MD08 cleaning machine. Higher processing rates would result with additional process hardware, but may be limited because of the release of FREON TES, a chlorinated fluorocarbon, to the environment.

D. Pallet Design

A unique rack or "pallet" for carrying a number of discrete substrates such as disks utilized in Winchester-type hard disk technology will be discussed with reference to Figures 8-11.

Generally, a plurality of magnetic disk sizes are manufactured for Winchester-type hard disk drives; two of the most common include 65 mm and 95 mm diameter disks. It will be understood that the general principles of pallet 800, described herein with reference to a pallet for carrying 95 mm disks, are applicable for pallets equally capable of handling disk substrates of other sizes.

Pallet 800, shown in Figure 8, shows 56 substrate carrying regions 1000 for carrying 95 mm diameter disk substrates 510. A pallet designed to carry 65 mm diameter disk substrates has 99 substrate-carrying regions 1000. Pallet 800 may be manufactured from 6061-T6 aluminum, available from the Aluminum Corporation of America (Alcoa), Pittsburg, Pennsylvania or other suitable material. Pallet 800 has a height H'' of approximately 34.56 inches, a length L of approximately 31 inches, and a depth DD of approximately 0.25 inch. These dimensions reflect the maximum size pallets or single sheet substrates which may be utilized if sputtering apparatus 10 is made to have dimensions as discussed herein.

In utilizing pallets having the above-mentioned dimensions, several problems arise. Achieving a uniform temperature profile across the surface of the pallet is difficult, especially where thermal expansion of the pallet material occurs at a different rate than that of disk substrates carried therein because of the pallet's greater thickness. Specifically, thermal expansion of the pallet material causes inherent warping of the pallet. Further, thermal expansion reduces the clearance within each substrate-carrying region 1000 around each disk substrate 510, constricting and warping disk substrates 510 undergoing their own thermal expansion, and ultimately precluding uniform film deposition. Addressing thermal expansion incompatibilities between the pallet and disk substrates is more than an issue of material selection. For a high throughput sputtering system, maximizing the substrate-carrying capacity of pallet 800 is equally desirable.

To minimize warping while maximizing the substrate-carrying capacity of pallet 800, substrate-carrying regions 1000 are arranged in a staggered, hexagonal fashion, providing the densest arrangement of disk substrates 510 within the established dimensions of pallet 800. As such, substrate-carrying regions 1000 are arranged in rows 810-880, wherein each substrate-carrying region 1000 in a particular row (e.g., 810) is offset from another substrate-carrying region 1000 in an adjacent row (e.g., 820) by a distance equalling one-half of the total horizontal width of each substrate-carrying region 1000.

In an effort to minimize thermal losses from disk substrates 510 to pallet 800, slots 890 and cavities 895 are provided. Cavities 895 in the lower portion of pallet 800 reduce the surface area of pallet 800 which is subject to thermal expansion, without reducing the substrate-carrying capacity of pallet 800 as the lower portion of pallet 800 does not carry disks beyond the extent of the sputtering flux. Notches 892 compensate for nonuniform thermal expansion across pallet 800 as a result of nonuniform heating across the pallet surface. Specifically, notches 892 allow relatively unrestricted expansion of the edges of pallet 800, thereby avoiding pallet warping.

Reference notches 910 in pallet 800 are provided for use with robotic loading and unloading stations 40 and 45. Specific operation of these stations 40 and 45 is discussed in Section E of the specification.

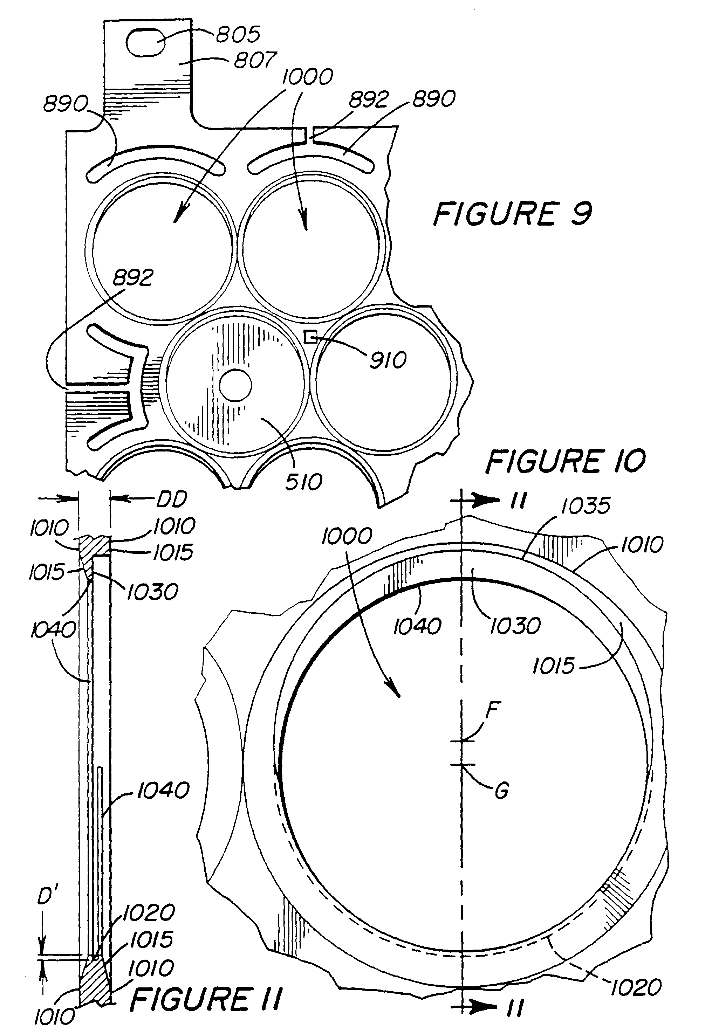

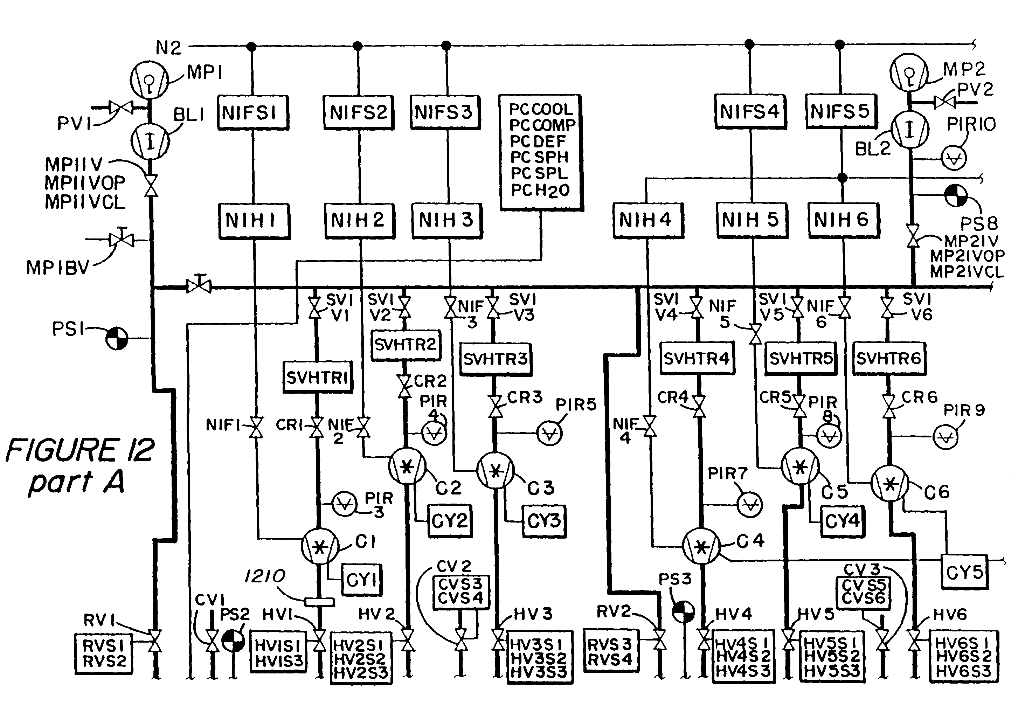

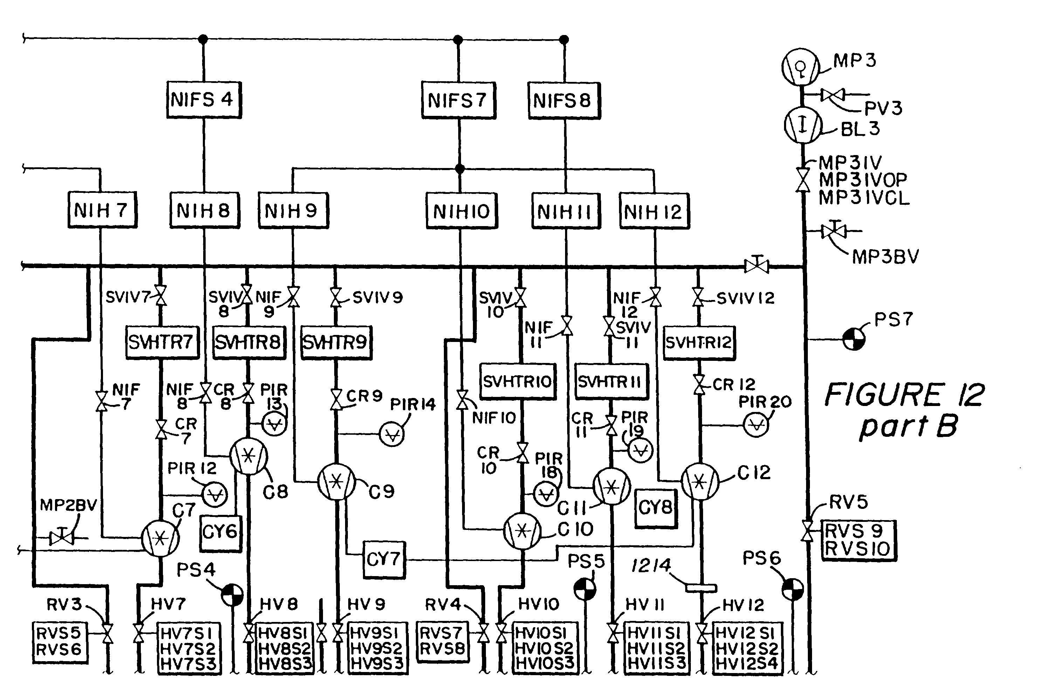

With reference to Figures 10 and 11, details of disk substrate-carrying regions 1000 are hereinafter discussed. Each substrate-carrying region 1000 has a roughly circular orifice with an outer circumferential edge 1010 defined by a beveled edge 1015. Beveled edge 1015 reduces any shielding effect pallet 800 may have on disk substrate 510 mounted in substrate-carrying region 1000 during sputtering. Notch mounting groove 1020 in the lower half of region 1000 allows disk substrate 510 to be seated therein. Lip 1030, at the upper portion of substrate-carrying region 1000, allows manual insertion of disk substrates 510 into substrate-carrying regions 1000. As shown in Figure 10, lip 1030 defines a semi-circular arc 1035 having a radial distance from axis F of 1.9 inches in the 95 mm embodiment of pallet 800, shown in Figures 8-11. Inner edge 1040 is defined by one end of beveled edge 1015 and has a radial distance from axis G of approximately 1.859 inches. Groove 1020 likewise has a semi-circular shape and is positioned a radial distance of 1.883 inches from axis G. Groove 1020 has a depth D' of approximately .012 inches.

In practice, disk substrate 510 is seated in groove 1020 and is securely held in place therein. During processing, pallet 800 is relatively stable and disk substrate 510 is securely maintained in substrate-carrying region 1000. The radial distance between axis F and axis G is approximately 0.12 inch, and thus the radial distance between lip region arc 1035 and the base of groove 1020 is 3.903 inches, a distance which is greater than the diameter of a 95 mm disk (3.743 inches). This excess space facilitates disk loading and allows for thermal expansion of disk substrate 510 relative to the pallet 800 during the heating process.

It should be noted that pallet 800 may be passed through sputtering apparatus 10 many times before cleaning, especially of grooves 1020, is required to insure substrate-carrying security within substrate-carrying regions 1000. After approximately 100 production cycles, edge 1040 and groove 1020 must be cleaned due to buildup of deposited layers from constant sputtering in sputtering apparatus 10.

### E. Substrate Loading

As discussed briefly with reference to Figure 1, disk substrates 510 may be provided in pallet 800 by means of an automatic loading process which preferably occurs at a point along transport system return path 50. Robotic loading station 40 is arranged to load disk substrates 510 into pallets 800 just prior to entrance of pallets 800 into load lock chamber 12. Robotic unloading station 45 is preferably positioned to remove disk substrates 510 from pallets 800 just after exit of pallets 800 from exit lock chamber 30.

In the automatic loading/unloading process of the present invention, an automatic pallet loading station 40 and an unloading pallet station 45 built by Intelmatic Corporation of Fremont, California are utilized. Each station uses three Adept Model One robots, controlled by Adept Model CC Compact Controllers and an Elmo Controller operating under conventional control software, tailored for apparatus 10 by Intelmatic Corporation software for controlling the loading processing and sequencing pallet movement. Three robots 40-1, 40-2, 40-3 load pallets 800 in a top to bottom manner, with first robot 40-1 loading the top third of pallet 800, second robot 40-2 loading the middle third of pallet 800 and a third robot 40-3 loading the bottom third of pallet 800. Likewise, three robots 45-1, 45-2, 45-3 unload substrates from pallet 800 in a reverse order to that of robots 40-1, 40-2, 40-3. Specifically, robot 45-1 unloads the bottom third of pallet 800, robot 45-2 then unloads the middle portion of pallet 800 and finally robot 45-3 unloads the top third of pallet 800. Loading and unloading of pallets 800 in this manner ensures that no particulate matter present on pallet 800 or disk substrates 510 falls from the upper portion of pallet 800 to deposit on disk substrates 510 loaded in lower portions of pallet 800 during the loading or unloading process.

The Adept Model One robot and Intelmatic software utilize reference notches 910 in pallet 800 to locate the approximate center of each substrate-carrying region 1000. The Adept robots utilize a single finger-type loading mechanism which engages disk substrates 510 by protruding through the center of each disk substrate 510 and lifts and places disk substrates 510 into grooves 1020 within each substrate-carrying region 1000.

Automatic robots 40-1, 40-2, 40-3 and robots 45-1, 45-2, 45-3 in conjunction with the Intelmatic system, have the capability of loading and unloading, respectively, up to 2,500 disk substrates per hour. Sputtering apparatus 10 has a capability of producing 3,000 95mm thin magnetic film coated disks per hour. Automatic loading and unloading stations 40, 45 thus represent constraints on production throughput for the present embodiment of the overall sputtering process discussed herein. As will be recognized by those skilled in the art, additional stations may be provided to increase production loading to match apparatus 10 throughput rates.

Pallet 800 may also be manually loaded and unloaded. In manual loading, lip 1030 is used to align the surface of disk substrate 510 with the planar surface of pallet 800 to more accurately provide disk 510 substrate into groove 1020.

## F. Pumping System

Sputtering apparatus 10 incorporates a highly efficient, high capacity vacuum pump system, represented schematically in Figure 12. Preparing sputtering apparatus 10 to carry out the sputtering operation described by the present invention requires that the vacuum pump system achieve two purposes. First, the vacuum pump system must furnish a highly evacuated environment for substantially unobstructed paths between the bombarding species and the target surface, and between dislodged target species and the substrates. Second, the vacuum pump system must minimize contaminant circulation inside sputtering apparatus 10 in order to maintain high film integrity. These goals are achieved simultaneously by virtue of the design of the pumping system of the present invention.

The overall vacuum pump system comprises three mechanical or roughing pumps MP1-MP3, with blowers BL1-BL3, and twelve (12) cryo pumps, C1-C12 including seven 8-inch diameter pumps (C3, C4, C6, C7, C9, C10, and C12), four 10-inch diameter cryo pumps (C2, C5, C8, and C11) for process isolation, and one 16-inch diameter cryo pump C1. A cryo pump model such as is available from CTI Cryogenics, a division of Helix Corporation of Santa Clara, California, is suitable for use in the pumping system of the present inventions. Eight compressors Cyl-CY8 provide helium gas to cryo pumps C1-C12, with: CY1 supplying C1; CY2 supplying C2; CY3 supplying C3; CY4 supplying C5; CY5 supplying C4, C6 and C7; CY6 supplying C8; CY7 supplying C9, C10 and C12; and CY8 supplying C11.

The overall vacuum system also features a network of valves. Five chamber vent valves CV1-CV5 vent the internal environment of sputtering apparatus 10 to atmosphere. Roughing valves RV1-RV5 isolate mechanical pumps MP1-MP3 and blowers BL1-BL3 from sputtering apparatus 10. Chamber vent valves CV1-CV5 and roughing valves RV1-RV5 allow the apparatus 10 to be divided into five sections allowing each individual section to be vented and pumped down as desired, to facilitate maintenance of sputtering apparatus 10. (See Section K, System Control Software.) High vacuum valves HV1-HV12 isolate cryo pumps C1-C3 from apparatus 10 to allow controlled pump-down sputtering apparatus 10 from atmospheric pressure. Valves MP1IV-MP3IV isolate one or more of mechanical pumps MP1-MP3 from the pumping system conduits, allowing flexibility in the number of mechanical pumps operating at a given time. Cryo pump roughing valves CR1-CR12 control contamination out of cryo pumps C1-C12 during a cryopump regeneration.

In operation, mechanical pumps MP1-MP3 and blowers BL1-BL3 perform a pump-down of sputtering apparatus 10 from atmospheric pressure to a level of about 50 mTorr. During the pump-down, high vacuum valves HV1 through HV12 are closed, roughing valves RV1 through RV5 and chamber isolation doors D2 through D11 are open and doors D1 and D12 are closed. Pumps MP1-MP3 and blowers BL1-BL3 evacuate sputtering apparatus 10 to a "crossover" point, which has been selected to be between about 50 microns to 150 microns (50 mTorr to 150 mTorr). When the internal pressure reaches the desired crossover point, the system operator, through the electronic control system, closes roughing valves RV1-RV5 and opens high vacuum valves HV1-HV12. Cryo pumps C1-C12, working in conjunction with compressors Cyl-CY8, evacuate the system to about $10^{-5}$ to $10^{-8}$ Torr (0.01 microns to 1 x $10^{-5}$ microns). Argon gas flow is thereafter provided through gas manifolds 2323 into chambers 14-29 to a sputtering pressure about 9-12 mTorr (9-12 microns).

When a pallet 800 loaded with disk substrates 510 is ready to proceed into sputtering apparatus 10 through load lock chamber 12, chamber 12 is at atmospheric pressure, and chambers 14 through 29 are at about 10 mTorr (10 microns). Pallet 800 enters from a class 10,000 clean room environment where robotic loading station 40 is positioned. Because the clean room environment is more sterile than that of load lock chamber 12, nitrogen gas is provided through valve LLSWEEP and a vent valve (not shown) in load lock 30 is opened to create a positive outflow from the clean room into load lock chamber 12, prohibiting contaminants from entering the clean room's environment. Ceramic filters are also provided to trap particulate matter generated when nitrogen backfill is provided through LLSWEEP into load lock chamber 12. Sturdy filters, such as Membralox 0.01 micron sintered alumina filters, available from Aluminum Company of America (Alcoa) Separations Technology, Warrendale, Pennsylvania, resist flexing over many pumping cycles even at pressures higher than 2000 psi and thereby contribute to the maintenance of a contaminant-free environment within the sputtering apparatus.

After pallet 800 enters load lock chamber 12 and door D1 closes, mechanical pump MP2 and blower BL3 evacuate the load lock chamber 12 down to about 100 mTorr (100 microns). When the crossover point is reached, D2 opens, allowing pallet 800 to proceed into dwell heating chamber 14 where pallet 800 and disk substrates 510 will be preheated in preparation for film deposition. During the heating cycle, some outgassing from pallet 800 and disk substrates 510 occurs, particularly if pallet 800 has been recycled, i.e., has passed through sputtering apparatus 10 at least once without undergoing scheduled cleaning. The carbon remaining on pallet 800 acts as a sponge for water which may be absorbed from the atmosphere when pallet 800 is at any point along return path 50 from a previous sputtering run. Water outgassed (known as 'drag in') in dwell heating chamber 14 is removed from the internal environment of sputtering apparatus 10 by 16-inch cryo pump C1, evacuating dwell heating chamber 14 back down to about $10^{-5}$ Torr (0.01 microns). At this time, a pressure differential on the order of 10 microns (10 mTorr) exists between dwell heating chamber 14 and passby heating chamber 16. Because such a pressure differential can destabilize downstream sputtering processes, argon is used to backfill dwell heating chamber 14 in order to equalize the pressures, as monitored by Pirani gauge PIR2. Once this pressure differential is equalized, door D3 opens, permitting pallet 800 and disk substrates 510 to proceed into dwell chamber 18. A pump, such as model PFC-1000 from Polycold Systems of San Rafael, California, connected into dwell chamber 18, removes any residual water outgassed from pallet 800 and disk substrates 510, following additional heating performed in passby heating chamber 16. Removal of this residual water is crucial to eliminate oxidation of the chromium target and underlayer in chromium sputtering chamber 20. Pallet 800 and disk substrates 510 continue through sputtering apparatus 10 and the sputtering operation proceeds as described in Section L.

After the multilayer film is deposited, pallet 800 and disk substrates 510 approach exit lock chamber 30 from exit buffer chamber 29. A pressure differential exists between chambers 29 and 30, on the order of that described in connection with dwell heating chamber 14 and passby heating chamber 16. Argon is used to backfill exit buffer chamber 29 to equalize pressures across door D11, as monitored by Pirani gauge PIR15. Once equalization is accomplished, door D11 opens, allowing pallet 800 with disk substrates 510 to proceed through exit lock chamber 30 and out of sputtering apparatus 10.

Periodically, cryo pumps C1-C12 must be cleaned in order to regenerate the cryogenic capacity of the pumps. More specifically, such cleaning involves clearing the cryo pumps of gases frozen therein. For sputtering apparatus 10, cryo pump regeneration typically takes place during machine down-time scheduled for replacing targets in sputtering chambers 20, 26 and 28.

The cryo pump regeneration process of the present invention is discussed more particularly in Section K of this specification. Generally, cryo pump regeneration is initiated by first closing off all of high vacuum pump valves HV1-HV12, opening roughing sieve valves SVIV1-SVI15 and turning on sieve heaters SVNTR1-SVNTR12, mechanical pumps MP1-MP3 and blowers BL1-BL3. Simultaneously, warm nitrogen ($N_2$) is fed from supply $N_2$ through valves NIF1-NIF12 via heaters NIH1-NIH12 to cryo pumps C1-C12. The nitrogen flow defrosts frozen gases in pumps C1-C12 when C1-C12 reach 290°K, pump MP2 and blower BL2 discharge the contents to the atmosphere external to sputtering apparatus 10. Sieve traps SVIV1-SVIV12 and cryo roughing valves CR1-CR12 insure vapors from hydrocarbon pump oils used in the mechanical pumps do not backflow into and contaminate the internal sputtering environment during the regeneration process. By these means, disk substrates 510 already at various stages within the sputtering apparatus are protected from ambient contaminants accompanying subsequent pallets which enter the sputtering apparatus.

G. Transport Mechanism

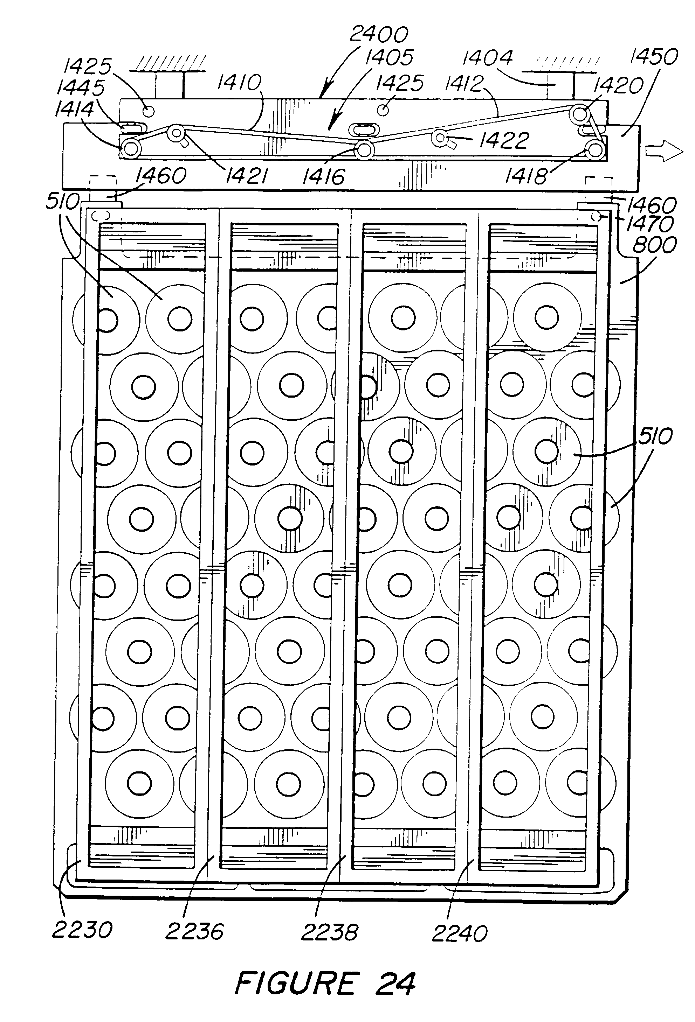

With reference to Figures 1, 13, 14, and 24, a system for transporting substrates through sputtering apparatus 10 and along return path 50 utilized in the apparatus and process of the present invention, will be hereinafter described.

The transport system of the present invention utilizes a plurality of individually powered transport platforms 2400. Each transport platform 2400 may be individually controlled with respect to motion and speed by controlling a motor assembly (not shown) associated with each platform. Hence, at any given time, only those motor assemblies associated with platforms which are transporting substrates along their lengths at any given time need be powered. Additionally, the transport speed of each individual platform 2400 is user-controlled, with transfer speeds generally selectable within a specific range, allowing substrate transport within sputtering apparatus 10 and return path 50 at varying rates. Each transport platform 2400 is provided with one or more proximity sensors (not shown) which output pallet position signals to the electronic control system of the present invention. This allows the electronic control system and the system operator to identify the location of each and every substrate in sputtering apparatus 10 and along return path 50 at any given time. Three such proximity sensors per transport platform 2400 are provided for each of the 19 platforms used in conjunction with sputtering apparatus 10: 17 platforms in chamber modules 12-30 and two additional platforms at entrance platform 210, at the entrance to load lock chamber 12, and exit platform 220, outside exit lock chamber 30. Twenty (20) transport platforms 2400 are provided along return path 50, each such platform stage along return path 50 having one proximity sensor per platform.

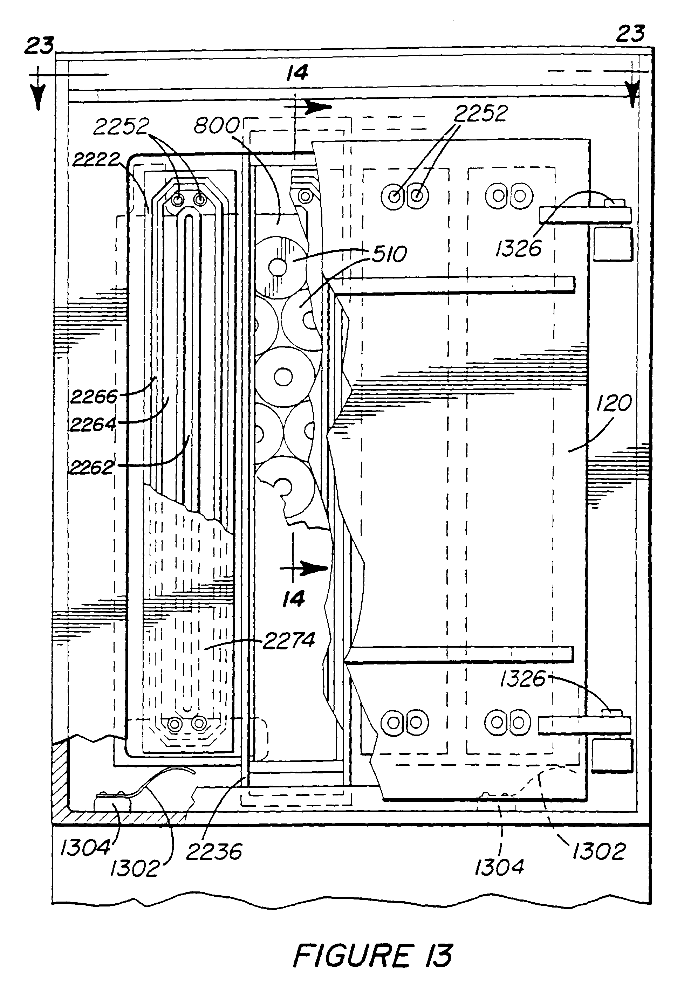

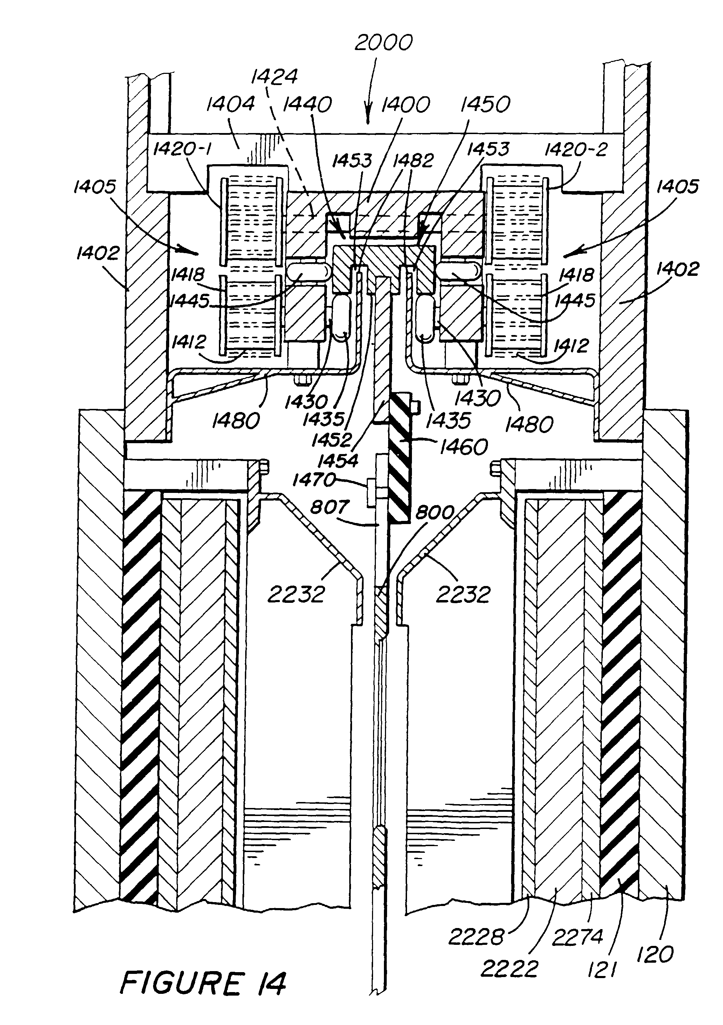

With reference to Figures 13, 14, and 24, each transport platform 2400 includes a motor assembly (not shown) coupled to timing chain assembly 1405, including chains 1410 and 1412, and sprocket wheels 1414-1422, mounted on transport beam 1400. An identical timing chain assembly 1405 is located on the opposite side of each transport platform 2400 (as shown in Figure 14).

Generally, sprocket wheels 1421 and 1422 have a single set of teeth and are mounted to beam 1400 to provide tension adjustment for timing chains 1410 and 1412, respectively. Wheel 1416 has a double set of teeth, one set engaging timing chain 1410 and one set engaging timing chain 1412. Timing chains 1410 and 1412 may be manufactured from polyurethane; however, in load lock chamber 12 and exit lock chamber 30, stainless steel timing chains are required due to reduce excessive particulate matter generated and circulated during repetitive pump-down and venting cycles when using polyurethane timing chains. Alternatively, stainless steel chains may be utilized throughout the system.

Sprocket wheels 1414 and 1418 may have single or double sets of teeth, as needed. Wheels 1414, 1416 and 1418 are coupled to spindles 1430, passing through beam 1400, which are in turn coupled to rubber roller wheels 1435 in cavity 1440 of beam 1400. Sprocket wheel 1420-1 is coupled to a spindle 1424 passing through beam 1400 into cavity 1440 to translate the motion of sprocket wheel 1420-1 to sprocket wheels 1420-2 located on the opposite side of transport platform 2400. Wheels 1420 generally have two sets of teeth, one set engaging timing chain 1412, the other set engaging a chain or gear assembly coupled to the motor assembly associated with the particular transport platform for powering timing chain assemblies 1405. Through bores 1425 are provided in beam 1400 adjacent to the upper portion of each transport beam 1400 to allow sprocket wheels 1420 to be positioned at any of three points along transport platform 2400 as the positioning of the motor assembly relative to transport platform 2400 requires.

It should be noted that the distance between wheels 1414 and 1416, and the distance between wheels 1416 and 1418, is equal. Further, when assembled into a complete transport system encompassing, for example, both apparatus 10 and return path 50, the distance between respective end wheels 1414 and 1418 on adjacent platforms is equal to the distance from wheels 1414 and 1418 to wheels 1416. Thus, the inter-roller spacing of rubber wheels 1435 is equal through the entire transport system.

Substrate carrier 1450 is receivable in interior cavity 1440 of transport beam 1400. Substrate carrier 1450 includes E-beam assembly 1452 and substrate mounting member 1454. E-beam assembly 1452 enters cavity 1440 seated atop rubber wheels 1435 and is transported along the path of each platform 2400 when the individual motor assembly for that platform drives gears 1420 into motion. Guide wheels 1445 are provided to ensure alignment of substrate carrier 1450, and especially E-beam assembly 1452, within cavity 1440.

Each transport platform 2400 is mounted to a wall portion 1402 of sputtering apparatus 10 by a cross beam 1404 and hex nuts 1406. Dual insulating members 1460 isolate substrate carrier 1450, and individual transport platforms 2400, from thermal and electrical energy which is transferred to pallet 800 during transport through sputtering apparatus 10. Insulating members 1460 may be manufactured from an insulating material such as DuPont's DELRIN thermoplastic elastomer. Insulating members 1460 are preferably bolted to substrate mounting member 1454 and include a T-shaped mounting pin 1470 for securing pallet 800. Apertures 805 are provided on extensions 807 of pallet 800 to allow pins 1470 to pass therethrough and pallet 800 to be mounted on carrier 1450.

Maintaining a contaminant-free environment within sputtering apparatus 10 is crucial to quality control in the provision of multi-layer coatings on substrates. Utilization of an overhead drive transport system in the system of the present invention allows a large variety of substrates to be coated within a single apparatus. However, such overhead systems suffer from excessive particulate generation which may fall from the transport system to contaminate disk substrates carried below. The transport system of the present invention is provided with unique shielding to prevent particulate contaminants generated by the overhead transport drive system from entering chamber modules 12-30 of sputtering apparatus 10. As shown specifically in Figure 14, contaminant shields 1480 are bolted on the lower portion of transport platform 2400 in the interior of chamber modules 12-30. Shields 1480 are shaped so as to bar particulate contaminants generated by each transport platform 2400 from the interior of chamber modules 12-30. In addition, E-beam assembly 1452 is specifically designed such that ends 1482 of shields 1480 are interposed in grooves 1453 of E-beam assembly 1452, minimizing entry of particulate matter into the interior of chambers 12-30.

The transport system described herein further minimizes particulate generation by eliminating metal-to-metal contact. This particular feature of the transport system provides excellent electrical isolation of the substrate, thus providing the added advantage of allowing the substrate to be biased during, for example, carbon sputtering in chamber 28, thereby improving the quality of the carbon coating deposited.

Each individual transport platform 2400 can move substrate carrier 1450 at a velocity ranging up to 24 ft/min along the entire transport path. Optimally, transport speeds within chambers 12-30 of sputtering apparatus 10 are adjustable up to 24 ft/min. Adjustment of drive speeds and each transfer platform 2400 is controlled by the electronic control system as discussed in Section K of this specification.

H. Substrate Heating System

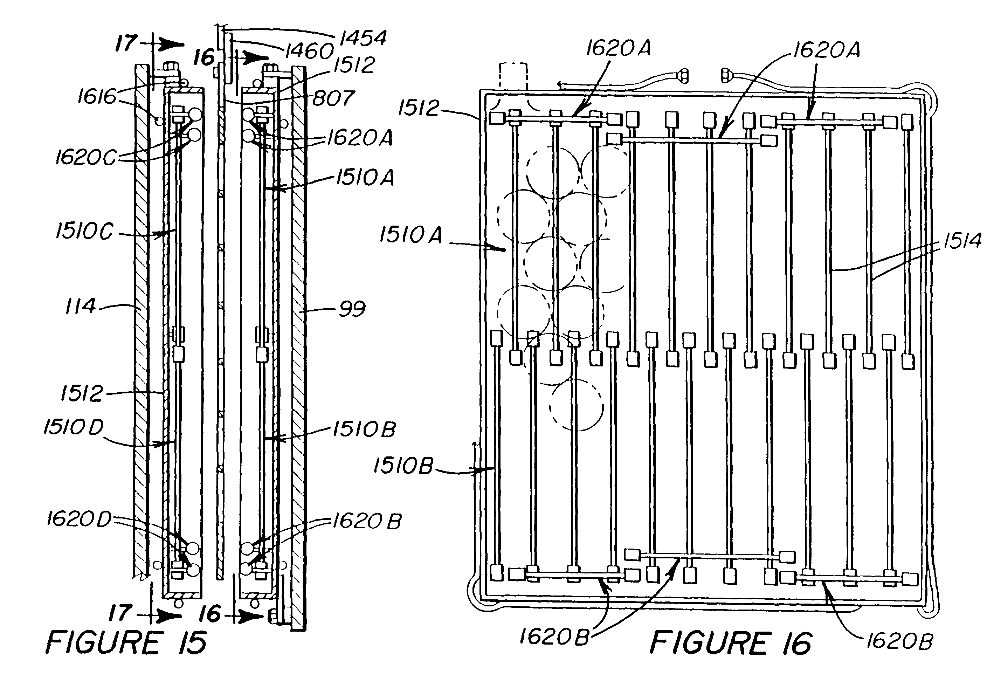

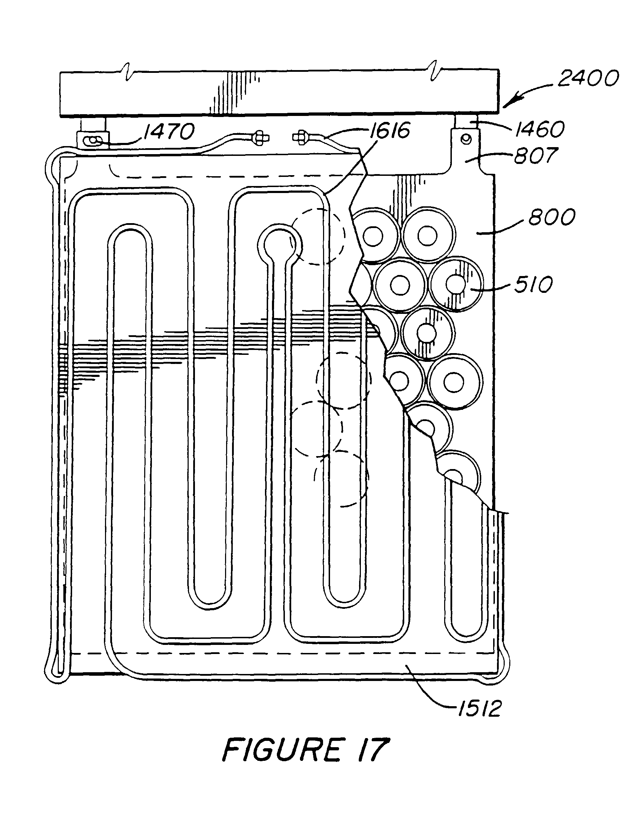

Uniform substrate temperature is crucial to producing a superior thin film by sputtering processes. Figures 15 through 21 illustrate a heating assembly configuration which accomplishes this goal in sputtering apparatus 10.

Specifically, sputtering apparatus 10 includes a heating assembly whose elements are distributed between dwell heating chamber 14, passby heating chamber 16 and dwell chambers 18 and 22.

As shown in Figures 15 through 17, dwell heating chamber 14 features eight horizontal banks 1510A, 1510B, 1510C, 1510D, 1620A, 1620B, 1620C, 1620D of tubular quartz radiant heating lamps 1514. Banks 1510A, 1510B, 1620A and 1620B are housed in one shallow gold-plated stainless steel tray 1512 and banks 1510C, 1510D, 1620C and 1620D are housed in a second shallow gold-plated stainless steel tray 1512. Each bank 1510A, 1510B, 1510C, 1510D includes eleven 1.5 kW lamps 1514 connected in parallel, vertically aligned and interdigitated to overlap lamp ends between the banks. Individual lamps are separated horizontally by a distance of 3 inches. Each bank 1620A, 1620B, 1620C and 1620D includes three 1.5 kW lamps 1514 connected in parallel, horizontally aligned and interdigitated to overlap lamp ends within each bank. Tubular quartz radiant heating lamps such as those commercially available from General Electric Corporation Lamp Division of Albany, New York are suitable for this purpose.

Within each tray 1512, banks 1510A, 1510B, 1620A and 1620B, and banks 1510C, 1510D, 1620C and 1620D are arrayed vertically. Trays 1512 measure 37.5 in. long (l) by 2-5/8 in. deep (d) by 32-3/8 in. wide (w), with one tray 1512 mounted on chamber door 114, and the other mounted on rear chamber wall 99. Each tray 1512 is protected from overheating by a circulating coolant fluid provided through cooling lines 1516.

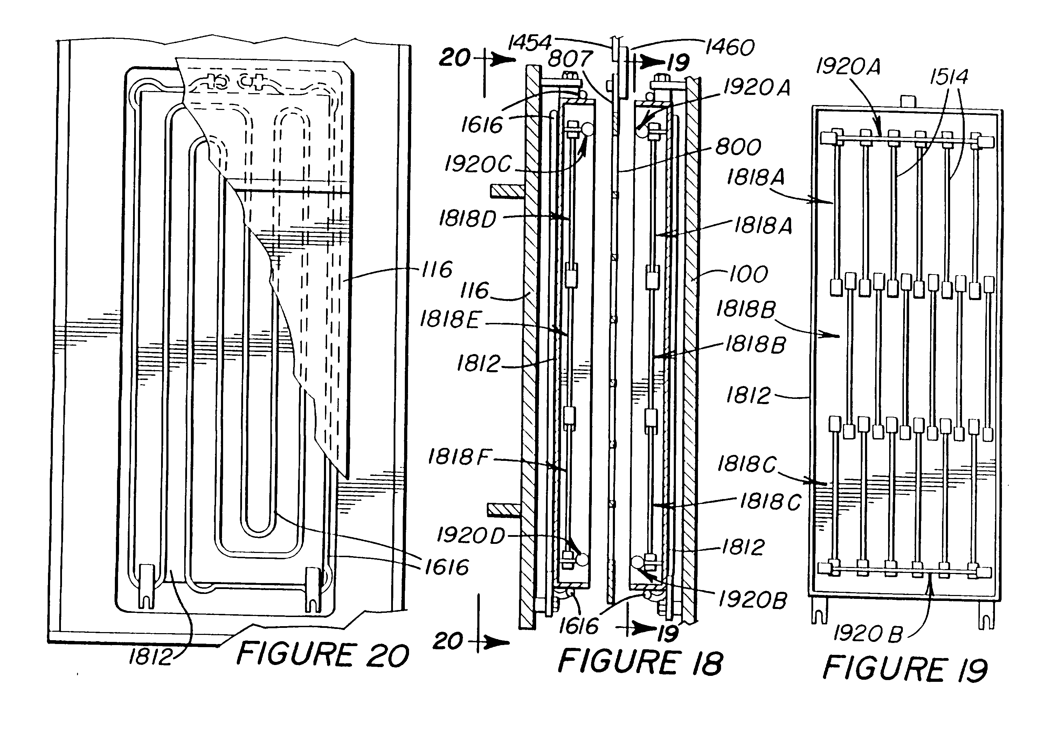

As shown in Figures 18 through 20, passby heating chamber 16 includes ten horizontal banks 1818A, 1818B, 1818C, 1818D, 1818E, 1818F, 1920A, 1920B, 1920C, and 1920D of tubular quartz radiant heating lamps 1514. Each bank 1818A, 1818B, 1818C, 1818D, 1818E, and 1818F features six 1.5 kW lamps 1514 of the same type and mounted in the same fashion as those in dwell heating chamber 14. Individual lamps 1514 are separated by a distance of 2 inches. Each bank 1920A and 1920B features a single horizontally aligned 1.5 kW lamp 1514.

Banks 1818A, 1818B, 1818C, 1920A and 1920B, are arrayed vertically in gold-plated stainless steel tray 1812 and banks 1818D, 1818E, 1818F, 1920C and 1920D are arrayed vertically in a second gold-plated stainless steel tray 1812. With the exception of housing five horizontal banks each, instead of four, trays 1812 are identical in measurement and respective mounting to chamber door 116 and rear chamber wall 100 as trays 1512 in dwell heating chamber 14. Likewise, trays 1812 feature cooling lines 1716 to provide protection from overheating.

The output from banks 1510A, 1510B, 1510C, 1510D, 1620A, 1620B, 1620C, 1620D, 1818A, 1818B, 1818C, 1818D, 1818E, 1818F, 1920A and 1920B, may be set and monitored for individual lamp operating voltages and currents via the electronic controlling system, described fully in Section K, to operate at desired power levels and for desired periods of time. In the present embodiment, heater banks 1510A-1510D, 1620A-1620B, 1818A-1818F, and 1920A-1920D are operated in sets, wherein each set comprises banks 1510A/1510B, 1510C/1510D, 1620A/1620C, and 1620B/1620D, operated in parallel. Alternatively, bank sets 1620A/1620C, 1620B/1620D, 1510A/1510C, and 1510B/1510D, may be operated in parallel. Similarly, opposing banks 1818A/1818D, 1818B/1818E, 1818C/1818F, and 1920A/1920D are adjustably controlled in parallel. Preferably, independent control of each bank 1510A-1510D, 1620A-1620B, 1818A-1818F, and 1920A-1920B, may be provided by the electronic control system. Such control of banks 1510A, 1510B, 1510C, 1510D, 1620A, 1620B, 1620C, 1620D, 1818A, 1818B, 1818C, 1818D, 1818E, 1818F, 1920A, 1920B, 1920C, and 1920D facilitates adjustment of heating power to meet the preheating requirements of different substrate materials.

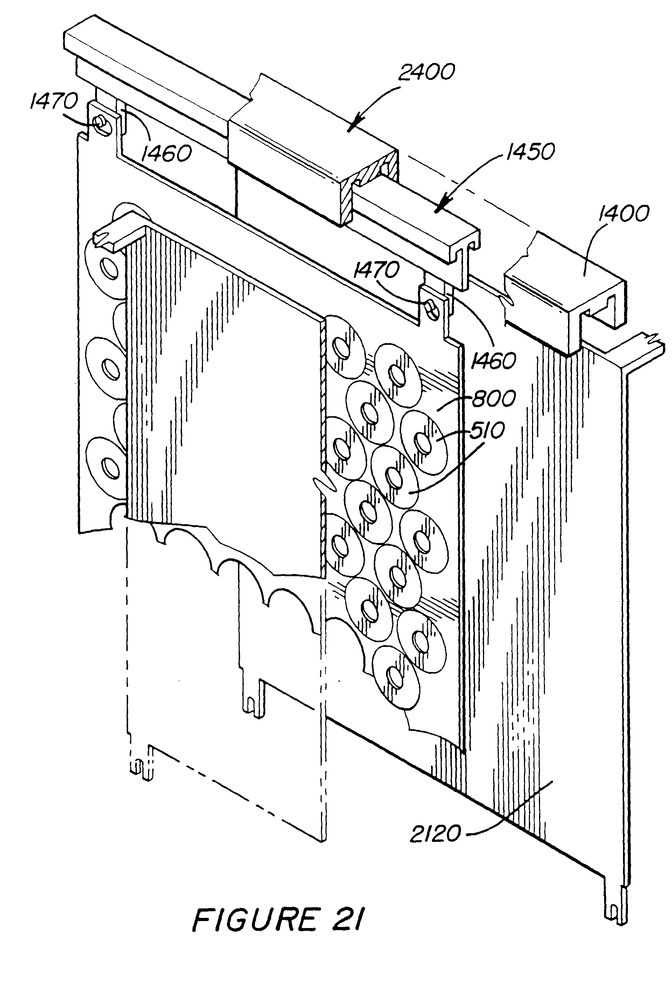

As shown in Figure 21, dwell chambers 18 and 22A and 22B each have two gold-plated stainless steel reflecting panels 2120, one each on opposite chamber walls 118, 122A, and 122B and rear chamber walls 101, 102 and 104. Reflecting panels 2120 measure 34-3/8 in. in length by 28 in. in width by 0.09 in. thick.

The heating assembly cooperates with the other elements of sputtering apparatus 10 to contribute to the overall high throughput and high quality sputtered films produced. Specifically, as pallet 800 proceeds through dwell heating chamber 14, banks 1510A, 1510B, 1510C, 1510D, 1620A, 1620B, 1620C and 1620D rapidly commence heating to warm both sides of disk substrates 510 before film deposition. If, for example, the desired substrate temperature is about 200°C, the heating time in dwell heating chamber 14 is approximately 30 seconds. Heating lamp warmup time is negligible since low power (about 143 W) is delivered continuously to the lamps to keep lamp filaments warm.

In the geometrically uniform array of heating lamps created by banks 1510A, 1510B, 1510C and 1510D, more heat is radiated towards disk substrates 510 carried in the center of pallet 800 as compared to disk substrates 510 carried in rows 810, 820, 870 and 880. In combination with efficient heat reflection from gold-plated stainless steel trays 1512, there is a need to equalize across pallet 800 the amount of heat radiated to individual disk substrates 510. Banks 1620A and 1620B serve as 'trim heaters' to boost the amount of heat radiated to disk substrates 510 carried in rows 810, 820, 870 and 880 of pallet 800. Although such trim heaters are not required, through equalization of heat distribution across pallet 800, trim heaters 1620A and 1620B allow control of coercivity of the deposited film to within about 60 Oe.

To further insure uniform substrate temperature prior to film deposition, a second heating cycle is performed in passby heating chamber 16. Pallet 800 enters passby heating chamber 16 through door D3. The electronic control system enables high power input to banks 1818, 1920, for example, through internal software timers or by reading the output of optical sensor SEN10 (shown generally in Figure 12) capable of detecting pallet motion through the sputtering apparatus 10. As pallet 800 begins to depart passby heating chamber 16, the electronic control system reduces the power of those lamps 1514 positioned at the leading edge of pallet 800 or turns off power to those lamps entirely in response to timing parameters incorporated in the electronic control system software, or sensor SEN13, in order to avoid relative overheating of the trailing edge of the pallet 800.

Banks 1818A, 1818B, 1818C, 1818D, 1818E, 1818F, 1920A and 1920B are initiated and will deliver heat for a preset, empirically determined time as monitored by a software timer in the electronic control system. In addition, a software delay timer is triggered to control the opening of door D3, allowing pallet 800 to proceed into passby heating chamber 16. As a result, when pallet 800 triggers SEN13 in dwell chamber 18, after a certain period, lamps 1514 on the leading edge of pallet 800 are reduced in power or turned off entirely, depending on the transport speed through dwell chamber 18. In addition, a Mikron temperature sensor (not shown) may be positioned at the entrance of passby heating chamber 16, allowing the system operator through the electronic control system to adjust the power output of banks 1818A, 1818B, 1818C, 1818D, 1818E, 1818F, 1920A, 1920B, 1920C and 1920D to compensate for thermal variations between disk substrates 510 and across pallet 800. In this manner, a uniform temperature profile is established across the surface of pallet 800 and between individual disk substrates 510, thereby avoiding higher coercivities for those substrates positioned on the trailing edge of pallet 800.

Radiative heat losses from pallets and substrates proceeding through sputtering apparatus 10 are minimized by virtue of gold-plated stainless steel reflective panels 2120.

The cooperation of these elements in the heating assembly contributes to the high throughput of sputtering apparatus 10 by promoting rapid and uniform heating of substrates before film deposition. The heating assembly also efficiently maintains the desired substrate temperature by minimizing radiative heat losses as disk substrates 510 proceed through sputtering apparatus 10. Moreover, integration with the electronic control system introduces added flexibility with respect to selecting and adjusting dwell times and heating rates as required by different substrates and sputtered films.

I. Sputtering Chambers in General

As shown in Figures 1 and 2, the present invention includes three in-line sputtering chambers 20, 26, and 28 to deposit a multilayer film, including chromium, CoCrTa and carbon thin films, respectively. Those skilled in the art will recognize that the application of the following principles to design a sputtering apparatus with greater or fewer sputtering chambers or with the capability to deposit more or fewer films is within the contemplation of the present invention. Moreover, all of the sputtering chambers within a particular sputtering apparatus need not be devoted to sputtering films. Indeed, any given sputtering chamber may participate in the overall process solely to the extent of serving as a pressurized inert passageway for substrates.

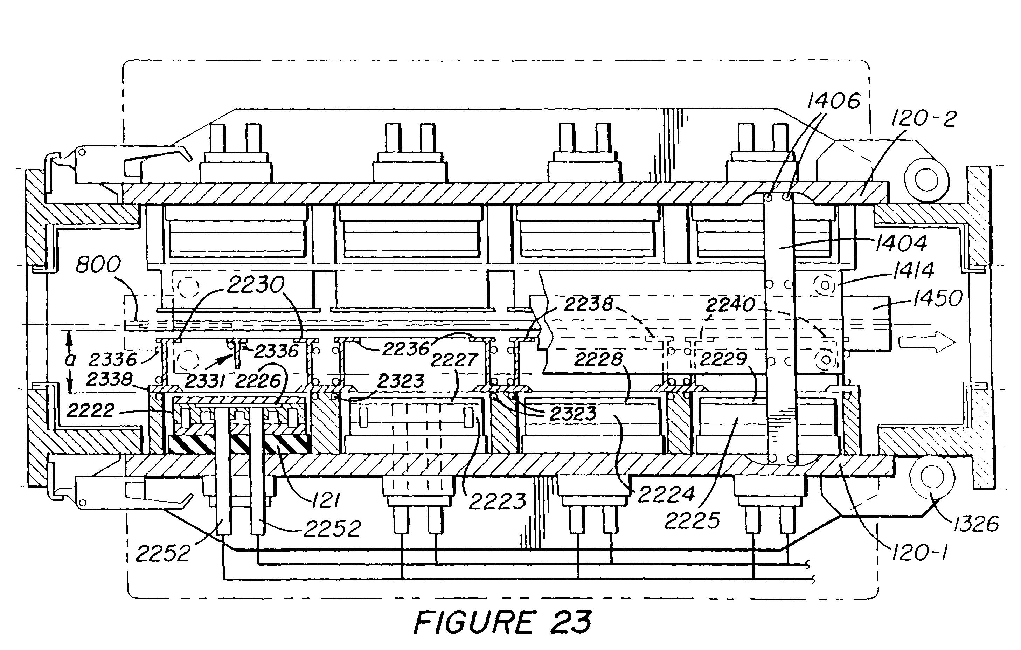

The following description relates to the internal configuration of each sputtering chamber, which is symmetrical about the line of pallet travel through the sputtering apparatus 10. Figures 13, 14 and 23 through 28 illustrate various aspects of the sputtering chambers and will be referred to as necessary.

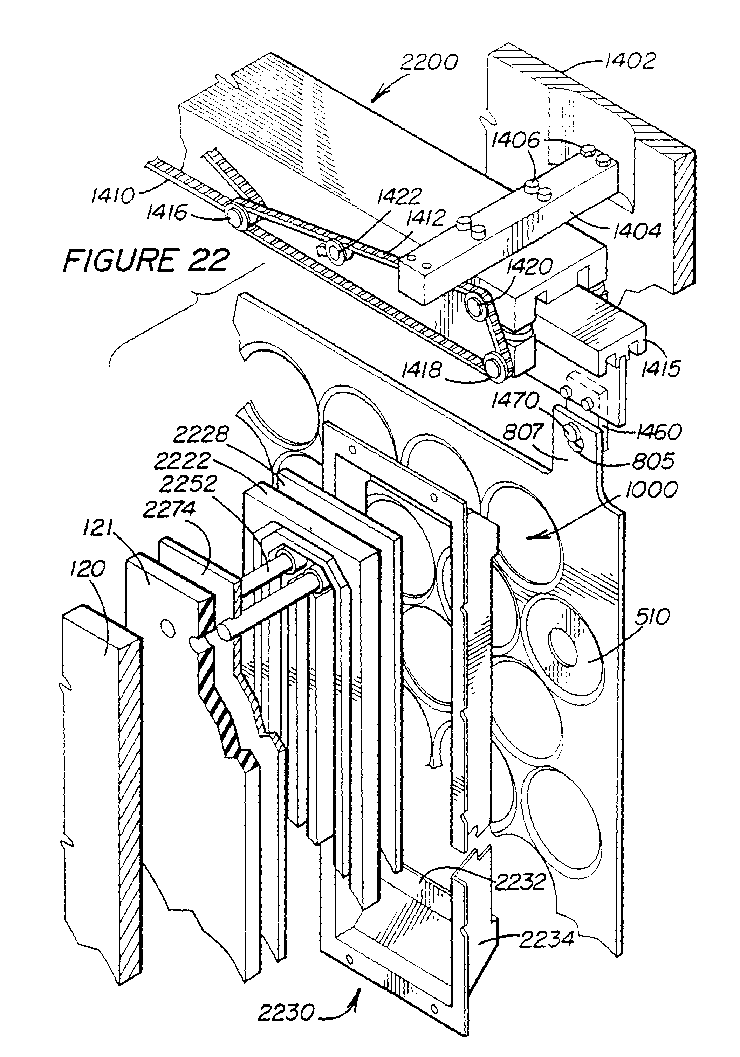

Referring to Figures 13, 14, 22 and 23, sputtering chamber 20 generally represents the internal configuration of sputtering chambers 20, 26 and 28. By way of explanation, only chromium sputtering chamber 20 will be hereafter described. Only one-half of the chamber is described with the understanding that the description applies to both halves.

Four planar (rectangular) cathodes 2222, 2223, 2224 and 2225 are mounted through insulative layer 121 to door 120. Door 120 is rotatable about hinge 1326 to allow access to the interior of chromium sputtering chamber 20, for example, for maintenance purposes. Interlocked protective cover 2305 interrupts the power supply to chromium sputtering chamber 20 when door 120 is opened.

Cathodes 2222-2225 may be composed of a material such as copper and measure about 36 inches in length by 5-1/2 inches in width by 1.125 inches thick. Cathodes 2222-2225 are provided with cooling lines 2552 to protect against overheating. Cooling lines 2552 supply a cooling fluid such as water along cooling conduits 2554 in cathode surface 2550.

As illustrated in Figures 14, 22 and 23, targets 2226-2229 are mounted one per cathode 2222-2225, with the target being nearest the line of pallet travel through chromium sputtering chamber 20. Within any given sputtering chamber, the composition of all four targets depends upon the film to be deposited, but may be chromium, a magnetic alloy or carbon. Likewise, the thickness of the targets depends upon the type and the thickness of the film to be deposited. In the case of the chromium and magnetic sputtering chambers 20 and 26, the target-to-substrate distance 'a' is about 2-3/4 inches and the target-to-substrate distance 'a' for carbon targets is 2-11/16 inches because the chromium and magnetic targets are thicker than the carbon target.

Referring now to Figures 21 through 24, shields 2230, 2236, 2238 and 2240 are mounted one per cathode 2222-2225. Shields 2230, 2236, 2238 and 2240 may be composed of a material such as copper and are generally rectangular in shape with peripheral flanges 2232 and 2234. Shield extension 2231 extends from shield 2230 into the chamber interior. Shields 2230, 2236, 2238 and 2240 are cooled by cooling lines 2336. A combined anode and dark space shield 2338 is incorporated into each shield 2230, 2236, 2238 and 2240.

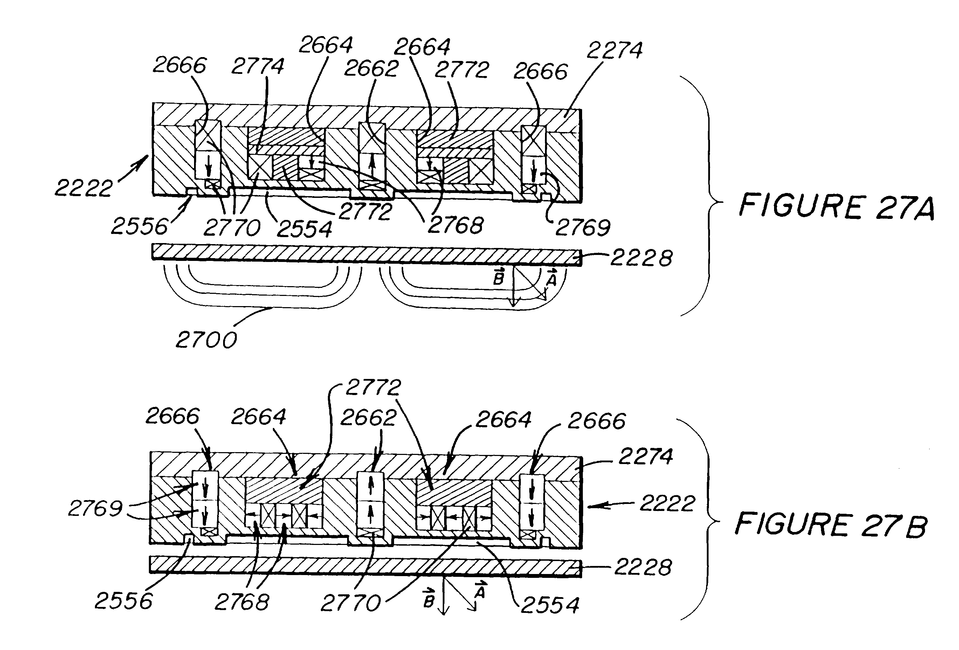

The sputtering process occurs with the targets sputtering in a sideways fashion, depositing the desired film on each side of disk substrates 510 as pallet 800 proceeds through each sputtering chamber. As Figures 27A and 27B show, during sputtering, flux (represented by vectors $\vec{A}$ and $\vec{B}$) leaves the target surface diffusely, depositing on the disk substrates and other surfaces within the sputtering chamber. As discussed previously, in-line sputtering of disk substrates can introduce undesirable magnetic anisotropies into the deposited film. Shields 2230, 2236, 2238 and 2240 intercept the obliquely incident flux (vector $\vec{A}$) from targets 2226-2229 such that only flux substantially normal to the surface of target 2228 (vector B) is deposited on disk substrates 510. Specifically, peripheral flanges 2232 and 2234, extending the length of each shield, project toward the line of pallet travel through any given sputtering chamber. Shield 2230 also features shield extension 2231 which similarly projects toward the line of pallet travel. Peripheral flanges 2232 and 2234 and shield extension 2231 block deposition from high- and low-angle flux (vector $\vec{A}$) as disk substrates 510 enter and exit each sputtering chamber, while providing an unhindered path for normal flux (vector $\vec{B}$) to the substrates.

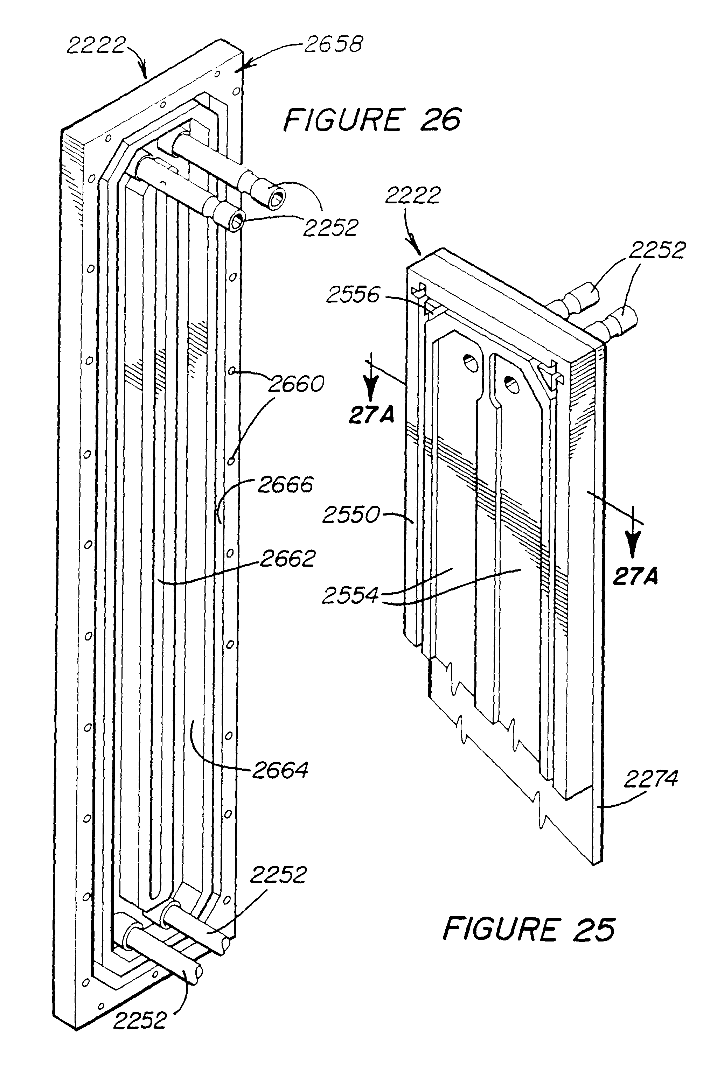

Figures 25 and 26 illustrate the configuration of cathode 2222 in more detail. Cooling lines 2552 discharge cooling fluid along surface 2550 in shallow channels 2554 and an O-ring (not shown) disposed in channel 2556 prevents coolant leakage outside of channels 2554. On the reverse side of cathode 2222, surface 2658 is adapted to receive screws in holes 2660 for mounting cathodes 2222-2225 onto chamber doors 120-1 and 120-2. Surface 2658 is configured to support and receive a magnet and magnetic pole piece assembly to produce the desired magnetic field. The assembly is created in a network of channels in surface 2658 consisting of center channel 2662, intermediate circumferential channel 2664 and outer circumferential channel 2666. Channels 2664 and 2666 are configured as concentric closed loops or ovals surrounding center channel 2662.

Typically, target utilization in sputtering operations are about 15-20% for nonmagnetic materials and about 30-35% for magnetic materials. Considering the high costs associated with the purchase and replacement of target materials, optimal target utilization is another prime concern in sputtering operations. Magnet and magnetic pole piece assemblies used in the present invention substantially improve target utilization, enhancing both production throughputs and cost-effectiveness.

Figures 27A and 27B illustrate in greater detail the magnet and magnetic pole piece assemblies for nonmagnetic (e.g., chromium and carbon) and magnetic (e.g., CoCrTa) targets, respectively. Each magnet 2768 is 1-inch long by 5/16-inch wide by 3/16-inch thick and magnets 2769 are 1-inch-long by 5/16 inch wide by 3/8-inch thick, with north and south pole directions indicated by arrows pointing up and down, respectively. Ferritic magnets of neodymium, iron and boron (NeFeB or "Neo iron") are preferred in the present invention.

Along with magnets 2768 and 2769, magnetic pole pieces 2770 and 2774 are arrayed in channels 2662, 2664 and 2666. Magnetic pole pieces 2770 may be adapted to receive screws therethrough for securing the magnet and pole piece assembly within the channels as necessary. A nonmagnetic material 2772, such as aluminum in block or continuous form, is positioned so as to fill the channels as necessary and preclude shunting of the magnetic flux between adjacent magnetic pole pieces 2770. Iron plate 2274 serves as a backing plate for the magnetic and pole piece assembly.

For a nonmagnetic target layout, center channel 2662 of each cathode contains about 25 magnets 2769 separated by 1/4-inch spaces and 25-inch pole piece strips 2770 above and below magnets 2768. Intermediate circumferential channel 2662 contains about 35 magnets 2768 separated by 1-inch spaces, two 31-inch pole piece strips 2770, two 31-inch pole piece strips 2774 adjacent to aluminum filler 2772 with additional pole pieces 2770 for fitting the cropped corners of intermediate channel 2664. Outer circumferential 2666 contains about 33 magnets 2769 and two 33-inch pole piece strips 2770 with additional pole pieces 2770 for fitting the cropped corners of outer circumferential channel 2666. The overall effect of the magnet and the pole piece assembly for the nonmagnetic target shown in Figure 27A is to produce a magnetic field strength above the target surface of 400 Gauss at the center of the erosion region.

For a magnetic target layout, center channel 2662 contains about 25 magnets 2769 with one overlying 25-inch pole piece 2770. Intermediate circumferential channel 2664 contains about 35 magnets 2768 overlaid with two 31-inch pole pieces 2770 and additional pole pieces 2770 for fitting the cropped corners of intermediate channel 2664. Aluminum filler material 2772, in block or continuous form, occupies remaining vacancies in intermediate channel 2664. The overall effect of the magnet and pole piece assembly for a magnetic target shown in Figure 27B is to produce a magnetic field strength of about 400 Gauss at the center of the erosion region.

As noted above, the purpose of the magnetic field is to trap electrons and ionized species in the plasma and enhance the sputtering rate induced by the circulating plasma above the target surface. The magnetic field 2700 generated by the magnet and magnetic pole piece assemblies used in the present invention approximate an ideal magnetic field 2700 where the vertical components of the magnetic fields above the nonmagnetic (Figure 27A) and magnetic (Figure 27B) targets are reduced. As a result, greater target utilization is obtained since the magnetic fields and plasma are focused across a relatively greater portion of the target surface.

Target utilization may be further improved by increasing the magnet loading density within the channel network. For example, by loading intermediate channel 2664 with 24 magnets 2768 separated by 1/2-inch spaces, nonmagnetic target utilization increases to between 50% and 65%. For magnetic targets, an increased utilization of between 35% to 50% may result.

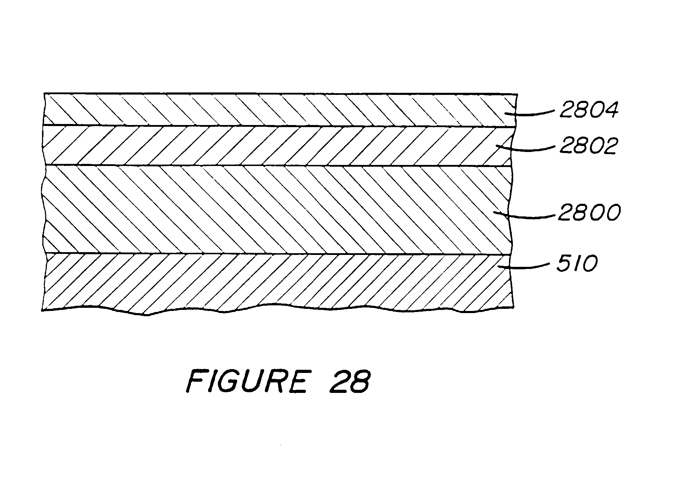

Figure 28 illustrates the film structure which may be produced by the present invention on nickel-phosphorus plated aluminum disk substrate 510. A 800Å to 2000Å (1000Å preferably) chromium underlayer 2800 is deposited first on disk substrate 510. A 500Å to 850Å CoCrTa magnetic layer 2802 may be deposited over the chromium underlayer. As a result of the circumferential texturing of the disk surface as discussed previously in Section C.2, the 'C' axis of the hcp structure of the magnetic cobalt alloy is aligned in the film plane. Finally, a 350Å carbon overlayer 2804 may be deposited, incorporating some hydrogen, as discussed in Section J.

## J. Carbon Sputtering

Sputtering chamber design in sputtering apparatus 10 for carbon films requires additional refinements to optimize wear and corrosion resistance properties. These refinements are discussed herein with reference to Figure 13, as necessary.

Experiments have shown that the incorporation of hydrogen into sputtered carbon films improves wear-resistance properties. In sputtering apparatus 10, hydrogen incorporation is achieved by sputtering in an argon atmosphere containing up to about 15% of a hydrocarbon gas. In particular, carbon films sputtered in the presence of ethylene/argon or acetylene/argon showed a 300% improvement in wear resistance as compared to carbon films sputtered in pure argon atmospheres. Thus, as compared to chromium and magnetic sputtering chambers 20 and 26, carbon sputtering chamber 28 uses a gas line for argon/hydrocarbon gas mixture to supply hydrocarbon gas flow during sputtering.

A second type of chamber refinement in the carbon sputtering chamber relates to the need for substrate bias. As noted above, during sputtering, primary or "fast" electrons dislodge from the target and join the plasma. These fast electrons are constrained to field lines in the plasma where they may ionize argon atoms or may be attracted to positively biased regions within the sputtering chamber. Deposition of dielectric target materials, such as carbon, on surfaces other than the substrate can reduce the electrical conductivity of those surfaces and inhibit the electron grounding thereon. As a result of the reduced electrical conductivity, fast electrons either scatter and ionize argon, or are therefor available to impinge on the substrate, whether positively biased or grounded. In the event of the latter, the substrate may be heated sufficiently by electron bombardment to cause graphitization of the growing carbon film.

One means of avoiding graphitization resulting from electron bombardment of the substrate is to apply a negative bias to the substrate to repel any stray electrons. As shown in Figure 13, arcuate phosphorus-bronze fingers 1302 depending from insulating block 1304 and connected to an external voltage source (not shown) provide an electrical contact to pallet 800 by which a negative bias may be applied. More specifically, as pallet 800 proceeds through carbon sputtering chamber 28, phosphorus-bronze fingers 1302 brush against the bottom edge of pallet 800 and establish the desired negative bias. At least one phosphorus-bronze finger 1302 maintains contact with the moving pallet while pallet 800 is in carbon sputtering chamber 28.

A third refinement relates to a reduction of pallet transport speed through carbon sputtering chamber 28. As a target surface is increasingly eroded during sputtering, the once-flat surface eventually develops a depression which mirrors the magnetic field lines. As a result, the magnetic field lines emerging from the target are no longer perpendicular to the electric field lines at the target surface. The significance of the growing erosion region is that during sputtering, target species continue to leave the erosion region in a path perpendicular to the surface, i.e., according to a cosine distribution, even where the eroded target surface is no longer uniformly flat. Therefore, an increasing portion of the flux leaving the target surface is intercepted by shields 2230 as otherwise obliquely incident flux. In other words, a correspondingly decreasing portion of the flux is deposited on disk substrates 510 (and pallet 800) as the desired normally incident flux, thereby decreasing the overall film deposition rate. In general, such a decrease in deposition rate may be compensated for directly by increasing the power supplied to the cathodes. For carbon targets, it has been discovered that this method of compensation is impracticable because increased power input to and resultant heat from the cathodes would induce undesirable graphitization.

The carbon target is also altered by redeposition of carbon from the flux into the erosion region. Specifically, since carbon is a dielectric material, such redeposition reduces the electrical conductivity of the target, further decreasing the carbon sputtering rate and may cause arcing. For conductive target materials like metals, redeposition is not similarly problematic.

Accumulations of the redeposited carbon, which appear as large blemishes or warts, may be removed by grinding the carbon surface. However, such a solution to the redeposited carbon problem is time- and labor-intensive, and consequently is not preferred because it detracts from the high throughput capability of the sputtering operation of the present invention. A much more manageable and attractive solution directly minimizes graphitization by holding deposition power to the cathodes constant and reducing the pallet transport speed from the typical rate of 3 feet/minute, via the electronic control system to, for instance, about 2.8 ft/min, to compensate for the lower deposition rate.

K. Electronic Control System

The electronic control system for sputtering apparatus 10 and the process of the present invention provides one or more system operators with the means to comprehensively and efficiently control production throughput, applied sputtering power, and other sputtering apparatus parameters. The electronic control system is preferably programmable to allow a plurality of different operating parameter settings to be stored for each of the adjustably controlled elements of the sputtering process. Thus, the electronic control system generally performs two major functions: (1) monitoring sputtering apparatus 10 by reading data input from every aspect of sputtering apparatus 10, and providing status data to the system operator(s); and (2) controlling the sputtering process by providing user-controlled and automatically generated control signals to the functional elements of sputtering apparatus 10.

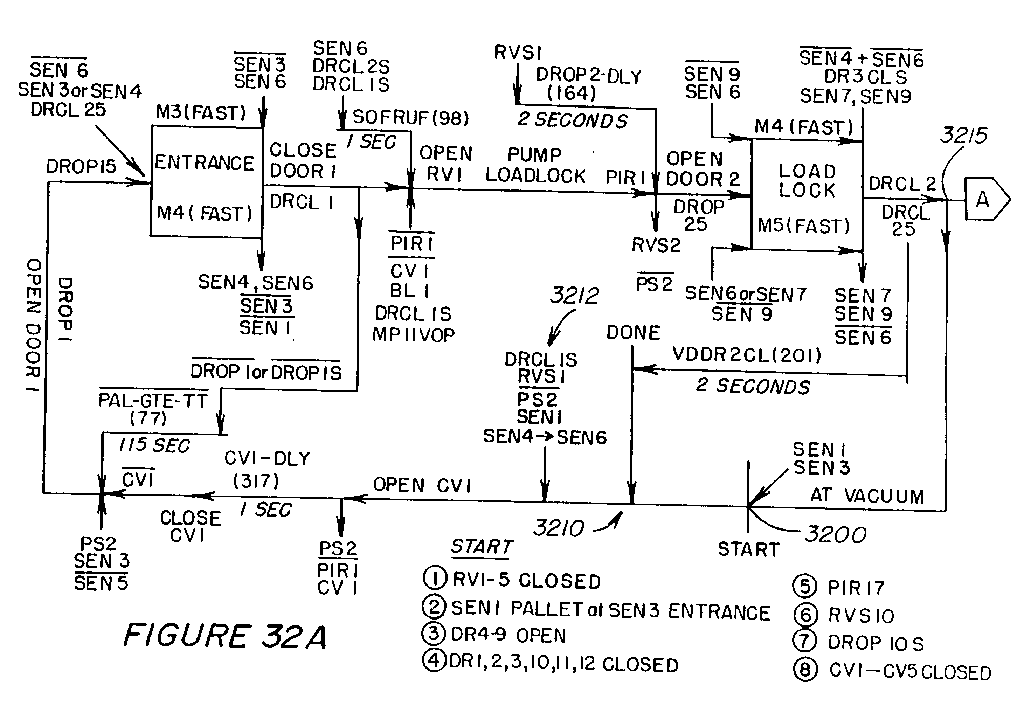

The electronic control system of the present invention will be described with regard to Figs. 12, 29 and 30. Figure 12 is a diagram of the vacuum and chamber pumping system of the present invention, including general representations of the location of the various signals and components controlled, or read by, the digital input/output of programmable logic controller 2902. Figures 32A-B represent a logical flow diagram of the programmable logic software controlling the motor assemblies powering transport platform arranged in chambers 12-30 in apparatus 10 of the present invention.

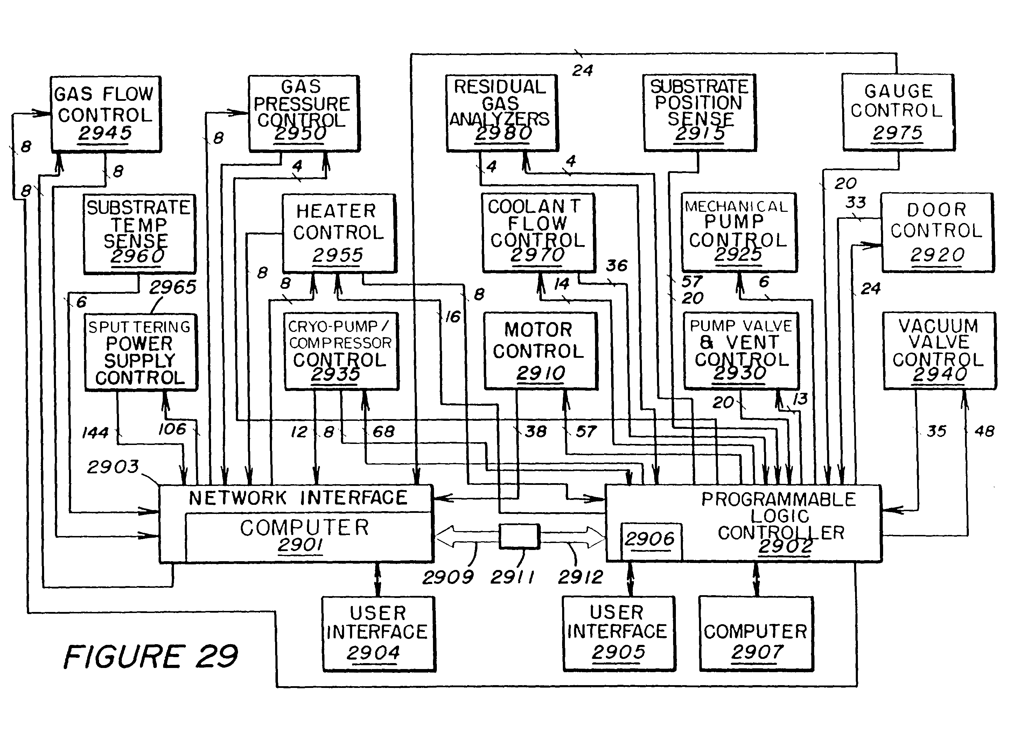

Referring to Figure 29, the major functional elements of the control system of the present invention are shown. Since both digital and analog input/output must be provided for in one embodiment, two main process controllers are used: a programmable process logic controller 2902, preferably an Allen Bradley PLC-5 programmable process logic controller, and an IBM-compatible, Intel-type 80386 or 80486 microprocessor based, computer 2901. It should be understood by those skilled in the art after review of the specification that the particular choice of process controllers is not crucial to the invention, as long as the process controller(s) can sufficiently handle input/output (I/O) in both analog and digital form to meet the comprehensive requirements of the control system described herein.

The Allen Bradley PLC-5 is manufactured by Allen Bradley Company, Milwaukee, Wisconsin, and includes at least one PLC-5 processor module and a number of input/output modules attached thereto. The input/output modules provide an expandable number of inputs and outputs to handle any number of digital I/O signals.

Programmable logic controller 2902 monitors digital input and provides digital output to those elements of the sputtering apparatus which require two-state control signals. These elements are described in detail below. Allen Bradley PLC-5 uses logic control software configured as "ladder" logic table diagram, a copy of which is included in Section M, to control input and output. In general, this software allows programming of the sensory input and output in a Boolean-type fashion along a series of horizontal timing "rungs". The entire "ladder" is scanned, top to bottom, every .030-.040 second, and each addressed element of I/O is examined by the processor. Each rung is programmed with both internal and external I/O, and generates an output command -- either internal or external -- if each element in the horizontal rung is "true". In this manner, it will be recognized that horizontally linked elements are ANDed together, while vertically linked elements are ORed. Each rung may be cross-referenced and nested to other individual rungs to achieve the desired logical output. The output of each rung may comprise an "enable," "latch" or "unlatch" signal, depending on the nature of the timing utilized in the particular program.

Computer 2901 primarily controls analog input/output to the various elements of sputtering apparatus 10 via a SIXNET network interface 2903, such as that manufactured by Digitronix SIXNET, Inc., Clifton Park, New York, although some digital input/output functions are handled by the computer 2901. The SIXNET network interface 2403 is coupled to computer 2902 via 307,200 baud SIXNET Model 60-232/N-DL network modem (not shown) coupled to a RS-232 serial port on, for example, a peripheral extension card provided in an expansion slot of computer 2901. Such an extension card may comprise, for example, an IBM Real Time Interface Co-Processor (ARTIC) card manufactured by International Business Machines, Boca Raton, Florida.

In order to handle a sufficient quantity of digital and analog I/O, the network interface 2903 comprising a SIXNET I/O network may include eight SIXNET 60 I/O MUX-FEB multiplex stations, each of which may include two RS-232 serial ports or alternative expansion capability, and sixteen dedicated I/O terminals. The multiplex stations are interlinked by the 307K baud SIXNET network interface. Data I/O of each such station may be configured as the constraints of the physical facility and sputtering apparatus 10 require to couple the necessary I/O signals to the network interface 2903. Network interface 2903 may include SIXNET 60-A/D 16-32 analog-to-digital converters, 6-D/A 12B-8 digital-to-analog converters, and 6-I032 FET digital/analog input/output modules to handle additional digital and analog I/O as required.

Programmable logic controller 2902 and computer 2901 may communicate via a data highway 2911, utilizing an RS-232 serial bus coupled between one RS-232 serial port of the ARTIC peripheral card (discussed above) located in computer 2901, and an Allen Bradley 1171-KF2-B communications interface 2911. Interface 2911 is coupled to programmable logic controller 2902 via serial data highway 2912.

Computer 2901 utilizes a user interface and system control software to monitor, control, generate alarms and store data for apparatus 10. One such software suitable for this purpose is "The Fix", produced by Intellution Corporation, Norwood, Massachusetts. The software allows development of a graphic interface environment for data input/ output by creating signal control databases linking the particular interface environment to specific control signals output from, and data sensing signals input to, computer 2901. Thus, input data is transmitted via network interface 2903 from the various components of apparatus 10 to computer 2901 to be provided as direct readout to the user I/O environment created using the interface and control software to provide easily readable data to the system operator and/or to create output flags to programmable logic controller 2902.

A limited number of output signals are provided by The Fix software to programmable logic controller 2902. These signals comprise combinational results of specific input signals and act as triggers for programmable logic controller 2902. This specific programming code utilized in "The Fix" software to generate these signals is included as Section N.

As with the particular process controllers utilized in the present invention, it will be noted by those skilled in the art that the particular software utilized in the process controllers to provide data input/output is not crucial to the substance of the invention; any suitable process control software may be utilized within the scope of the invention to generate any number of suitable user interfaces.

A second, IBM compatible computer 2907 is coupled to programmable logic controller 2902. Computer 2907 may be utilized as a separate programming computer allowing on-line monitoring, debugging, and programming of the ladder logic software in programmable logic controller 2902 utilizing a debugging software, such as that manufactured by ICOM Incorporated, Milwaukee, Wisconsin.

User interfaces are provided for both programmable logic controller 2902 and computer 2901. User interface 2905 coupled to programmable logic controller 2902 may comprise a NEMATRON touch screen, manufactured by NEMATRON, Inc., Ann Arbor, Michigan, which allows data input/output through a series of custom designed, touch sensing, display screens. When utilizing the NEMATRON touch-screen with the Allen Bradley PLC-5, a BASIC module 2906 is provided in the Allen Bradley and coupled to the NEMATRON. The BASIC module is utilized for selecting the display screens on the NEMATRON and for linking particular screen input/output to the data input/output of the Allen-Bradley PLC-5.

Computer 2901 is coupled to user interface 2904, which preferably comprises a standard high resolution graphics display monitor and keyboard. An EGA or VGA type high-resolution graphics display, such as the NEC Multisync II, manufactured by NEC Information Systems, Inc., Boxborough, Massachusetts is suitable for use as user interface 2904. Again, it should be understood that any conventional input/output interface may be utilized with the process controllers of the electronic control system while remaining within the scope of the invention.

The electronic control system of the present invention governs three major functions: movement of the substrate through apparatus 10; sputtering process control within apparatus 10; and status indication for apparatus 10. Referring to Figure 29, movement of the pallet 800 and disk substrate 510 through the process is governed by the electronic control system through motor control system 2910, position sensing system 2915, and door control system 2920. Process control and status indication are governed by mechanical pump control system 2925, pump valve and vent control system 2930, cryogenic pump and compressor control system 2935, vacuum valve control system 2940, gas flow control system 2945, gas pressure control system 2950, heater control system 2955, substrate temperature sensing system 2960 sputtering power supply control system 2965, coolant control system 2970, gauge control system 2975 and residual gas analyzers 2980.

With reference to Figure 29, the elements of the electronic control system, and their relationship to programmable logic controller 2902, computer 2901, and network interface 2903 are hereinafter described. It should be understood by those skilled in the art that the elements defined in Figure 29 are arranged in the manner shown for explanation purposes only; various modifications of the system are contemplated as being within the scope of the invention.

## 1. Motor Control System 2910

Movement of the substrate through in-line sputtering apparatus 10 is controlled by the substrate transport system. As noted therein, each separate transport platform 2400 has a variable speed motor assembly associated therewith and coupled thereto controlling the velocity of the substrate movement at that specific platform in the transport system loop.

With respect to apparatus 10, nineteen (19) individual transport platforms are provided to carry the substrate through the seventeen (17) chambers of sputtering apparatus 10, and load and unload ramps, 210, 212, respectively. Nineteen motors M3-M21 are controlled by three BAM-8 Berkeley Axis Machine (BAM) multi-access servo controllers (not shown). Each BAM-8 can simultaneously control up to eight axis of high performance servo motors, and provide multiple, preset, user-defined motor speeds for each axis, allowing digital input signals to activate preprogrammed control sequences for each axis controlled by each particular BAM-8. Each BAM-8 provides eight separate variable voltage output signals, one per axis, to the motor assemblies to control motor speed and, consequently, the velocity of the target substrate at each particular platform in the transport system. Each BAM-8 is preferably coupled by one RS-232 port from one of the eight SIXNET multiplex stations to each BAM-8.

Two sets of nineteen digital outputs from programmable logic controller 2902 provide motor velocity control signals M3F-M21F, M3S-M21S to the BAM-8 motor controllers. The two-bit control signal provided by signals M3F-M21F, M3S-M21S allows two individual forward speed settings, start/stop, and, forward/reverse direction to be controlled by programmable logic controller 2902. Nineteen additional digital outputs from programmable logic controller 2902 provide motor interrupt signals M3I-M21I to the BAM motor controllers.

Thirty-eight (38) analog output signals DMOTLO1-DMOTLO21, DMOTHI1-DMOTHI21 are provided for selection of individual motor speed set points of motors M3-M21. The high and low speed setpoints defined by DMOTL01-DMOTLO21, DMOTHI1-DMOTHI21 define the motor speeds controlled by signals M3F-M21F, M3S-M21S from programmable logic controller 2902; once set, the BAM-8 automatically controls each motor to meet the desired setpoint state. Optimal motor setpoints are listed in Table 1:

TABLE 1

| Motor # | Setpoints (ft./minute) | |
| --- | --- | --- |
| | Fast | Slow |
| M3 | 12.0 | 7.5 |
| M4 | 12.0 | 7.5 |
| M5 | 12.0 | 6.0 |
| M6 | 6.0 | 6.0 |
| M7 | 6.0 | 6.0 |
| M8 | 6.0 | 6.0 |
| M9 | 12.0 | 6.0 |
| M10 | 12.0 | 6.0 |
| M11 | 12.0 | 6.2 |
| M12 | 12.0 | 6.2 |
| M13 | 6.0 | 6.2 |
| M14 | 6.0 | 6.0 |
| M15 | 6.0 | 2.7 |
| M16 | 6.0 | 2.7 |
| M17 | 12.0 | 2.7 |
| M18 | 12.0 | 6.0 |
| M19 | 12.0 | 6.0 |
| M20 | 12.0 | 6.0 |
| M21 | 12.0 | 6.0 |

Hence, motor control system 2910 provides multiple velocity movement of a substrate through the sputtering apparatus which is useful for controlling a plurality of substrates moving through the sputtering system simultaneously.

2. Substrate Position Detection System 2915

Substrate position detection system 2915 represents the capability of electronic control system to detect and monitor movement of all substrates entering, exiting, or passing through apparatus 10. Fifty-seven pallet position sensors SEN1-SEN57 may be provided in chamber modules 12-30, and entrance and exit platforms 210, 220 to inform programmable logic controller 2902, (and the system operator) of the exact position of each substrate in apparatus 10. Generally, three sensors per pallet platform are provided. Preferably, optical position sensors are utilized in chambers 14 and 16 due to their ability to withstand the high temperatures present in those chambers. It should be recognized that it is preferable to provide three sensors per platform for greater accuracy in determining substrate position; in the present embodiment, to improve durability, only two position sensors are utilized in chambers 14 and 16 to reduce sensor failure rates. Each sensor SEN1 - SEN57 provides a digital output signal to programmable logic controller 2902 indicating the presence or absence of a substrate at the sensor's position. Such a comprehensive position detection system provides fault detection in the event a substrate becomes jammed at any point in the sputtering process, permitting the user to compensate for such problems and forestall problems on subsequent substrates in apparatus 10.

Twenty-one additional pallet position sensors (not shown) are provided on the twenty transport platforms utilized in return path 50 (two on the last platform before load station 40). Each such sensor output signal may be provided to programmable logic controller 2902, as shown in Figure 12; alternatively, return path sensor signals may be provided to a separate programmable logic controller.

3. Door Control System 2920

Twelve chamber isolation doors D1-D12 are provided to separate certain individual ones of compartment chamber modules 12-30. Each door D1-D12 is operated by a pair of pneumatic cylinders (not shown), each cylinder having a pair of solenoid triggers responsive to DROP and DRCL signals to each cylinder in a direction to open or close the door, respectively. Movement of each of doors D1-D12 is governed and detected by door control system 2920. Twenty-four (24) dedicated digital outputs from programmable logic controller 2902 provide pulsed control signals to door open solenoids DROP1-DROP12, and door close solenoids DRCL1-DRCL12.

Additionally, door position sensors are provided to detect each door's opened or closed state for the control system software. Door open sensors DROP1S-DROP12S and door closed sensors DRCL1S-DRCL12S provide direct digital output signals to twenty-four (24) digital inputs of programmable logic controller 2902.

A high pressure air supply (not shown) is used in the sputtering apparatus to provide the requisite air pressure for the pneumatic valves, including door cylinders, high vacuum valves, and other such system components. Primary air sensor APS detects the existence of the high pressure air supply and the absence of a ABS detection signal input to one input of programmable logic controller 2902 initiates a system shutdown override. In addition, eight pressure switches PS1-PS8 are provided to check for the existence of discrete pressure states at various points in the pumping system and apparatus 10. Switches PS1-PS8 redundantly check for a lack of evacuation pressure in pumping conduits in apparatus 10 in the position as shown. Eight digital output signals indicating the detection, or lack thereof, each discrete pressure state are input to programmable logic controller 2902.

4. Mechanical Pump Control System 2925

Three mechanical roughing pumps MP1-MP3 and blowers BL1-BL3 provide initial vacuum pumpdown of sputtering apparatus 10, and explosive pumpdown in load lock 12 and exit lock 30 in accordance with the description of the pumping system discussed in section F of this specification. Mechanical pumps MP1-MP3 provides high speed pumping up to approximately 20-50 mTorr, while blowers BL1-BL3 provide pumping down to about 1 mTorr before the cryo pumps engage. Mechanical pumps MP1-MP3 and blowers BL1-BL3 thus act in concert to provide rapid pumping of apparatus 10.

On/off controls for mechanical pumps MP1, MP2, and MP3, and blowers BL1, BL2, and BL3, are provided by six digital output signals from programmable logic controller 2902.

5. Mechanical Pump Valve and Vent Control System 2930

Five roughing valves RV1-RV5 isolate mechanical roughing pumps MP1-MP3 and blowers BL1 - BL3 from chambers 12-30 of sputtering apparatus 10. In addition, five chamber vent valves CV1-CV5 allow for venting chambers 12, 18, 22B, 22D, and 30 between the evacuated, sputtering atmosphere and the ambient environment outside apparatus 10.

Mechanical pump valve and vent control 2930 controls roughing valves RV1-RV5, monitored by roughing valve sensors RVS1-RVS10, and chamber vent valves CV1-CV5, monitored by chamber vent sensors CVS3-8. In the absence of sensors associated with any valves, the on/off condition of any valve can be determined by referencing the software output commands (for example, for valves CV1 and CV5).

Thirteen outputs of programmable logic controller 2902 are provided to mechanical pump valve and vent control 2930. A first set of five outputs controls the open/close state of roughing valves RV1-RV5, a second set of five outputs controls the open/close state of chamber vent valves CV1-CV5, and a third set of three outputs controls the open/close state of pump vent valves PV1-PV3. In addition, twenty dedicated digital inputs of programmable logic controller 2902 are provided for signals received from roughing valve sensors RVS1-RVS10 and chamber vent valves sensors CVS3-CVS8. Roughing valve sensors RVS1-RVS10 and chamber vent valve sensors CVS3-CVS8 provide state signals to programmable logic controller 2902 to indicate the state of each respective valve CV2-CV4 monitored, thereby allowing the user and the system to more accurately monitor pumpdown and venting of the system. Additional chamber vent valve sensors may be provided on chamber vent valves CV1 and CV5, however because of the high usage of these values, sensor failure occurs rapidly.

6. Compressor and Cryogenic Pump Regeneration Control System 2935

The electronic control system includes a cryogenic pump regeneration and compressor control 2935 which controls the start/stop function of compressors CY1-CY12, nitrogen supply N2, and nitrogen heaters NIH1-NIH12. In addition, cryogenic pump and compressor control 2935 provides on/off control to sieve heaters SVHTR1-SVHTR12 and sieve valves SVIV1-SVIV12, used in flushing contaminants from cryogenic pumps C1-C12 during the cryogenic pump regeneration process discussed above. Nitrogen supply N2 and heaters NIH1 - NIH12 are also used to flush and clean cryogenic pumps C1-C12.

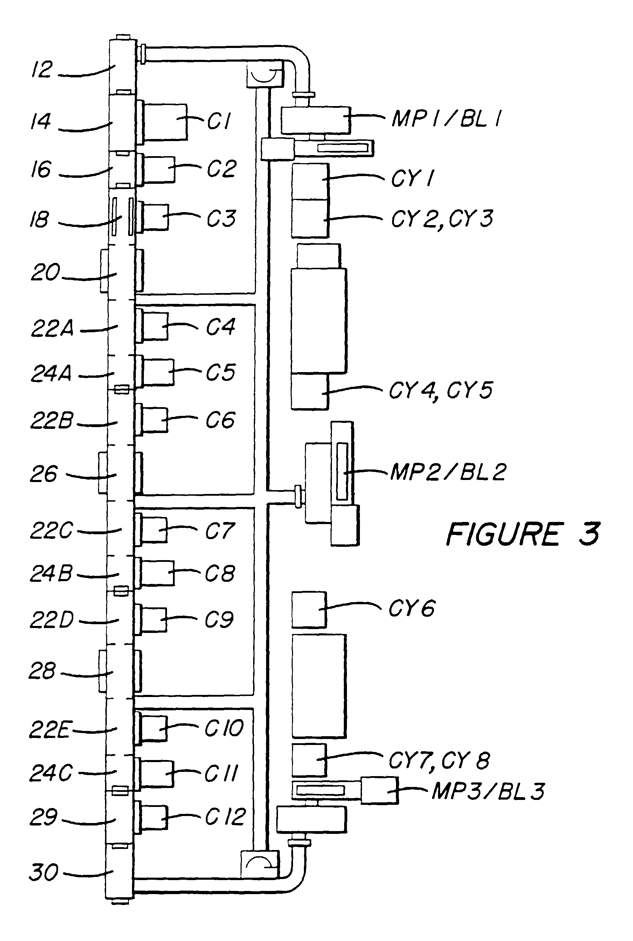

As discussed above in section F of this specification, cryogenic pumps C1 - C12 are provided to create an evacuated environment in chambers 12-30 in accordance with the sputtering process of the present invention. Compressors CY1-CY8 (Figs. 3 and 12) provide helium gas to cryogenic pumps C1 - C12 to enable cryogenic pumps C1 - C12 to create the necessary vacuum in sputtering apparatus.

Eight outputs of programmable logic controller 2902 control the start/stop state of compressors CY1-CY8.

Eight nitrogen flow sensors NIFS1-NIFS8 detect and insure the presence of nitrogen to nitrogen flow heaters NIH1 - NIH12. Eight programmable logic controller 2902 digital inputs receive flow detection signals from sensors NIFS1-NIFS8. Twelve digital outputs of programmable logic controller 2902 control the start/stop functions for nitrogen heaters NIH1-NIH12. An additional twelve digital outputs of programmable logic controller 2902 provide open/close state control over nitrogen flow valves NIF1-NIF12.

Also included in cryo regeneration and compressor control 2935 are sensors, not shown, coupled with cryo pumps C1 - C12 to monitor the temperature of cryo pumps C1 - C12 during the cryo regeneration process and during the sputtering process. Twelve analog network interface 2403 inputs receive the analog temperature signals TD1-TD12, over a range of 3°K - 350°K.

Cryo roughing valves CR1-CR12 are provided to control outgassing of cryogenic pumps C1-C12 through sieve heaters SVHTR1-SVHTR12. As noted above, cryo roughing valves CR1-CR12 function in concert with sieve heaters SVHTR1-SVHTR12 in removing contaminants from cryo pumps C1-C12 during the cryo regeneration process. The open/close states of cryo roughing valves CR1-CR12 are controlled by twelve digital outputs of programmable logic controller 2902.

Control of sieve heaters SVHTR1-SVHTR12 and sieve valves SVIV1-SVIV12 is provided by 24 digital outputs of programmable logic controller 2902: twelve (12) digital outputs of programmable logic controller 2902 control the start/stop functions of sieve-heaters SVHTR1-SVHTR12; twelve outputs of programmable logic controller 2902 control sieve-isolation valves SVIV1-SVIV12.

7. Vacuum Valve Control 2940

Vacuum valve control 2940 provides on/off switching control for, and receives feedback from, high vacuum valves HV1-HV12 coupled between cryogenic pumps C1 - C12, and sputtering apparatus 10. Feedback for high vacuum valves HV1-HV12 is provided by 32 high vacuum sensors HV1S1, HV1S3, HV2S1, HV2S2, HV2S3, ... HV12S1, HV12S2, HV12S3.

High vacuum valves HV2-HV11 are three state (OPEN, CLOSED, and THROTTLE) operation valves. The THROTTLE state is used during operation of the sputtering system to maintain the vacuum level sputtering apparatus, subsequent to initial pumpdown, as the needs of each particular chamber require. High vacuum valve HV1 operates as a two-state (open/closed) valve, and is utilized with baffle 1210. Twenty-four (24) digital outputs (HV1_1, HV1_2, HV2_1, RV2_2, ... , HV12_2) are dedicated by programmable logic controller 2902 to provide twelve, two-bit control signals for high vacuum valves HV1-HV12 and baffles 1210, 1214, to select one of the three states of valve operation discussed above for valves HV2-HV12, or two states for valve HV1, and enable/disable baffles 1210, 1214. Thirty-five (35) digital inputs of programmable logic controller 2902 monitor high vacuum sensors HV1S1 -HV12S3 for respective valves HV1-HV12. One sensor is provided for each operational state of each high vacuum value as applicable.

8. Gas Flow Control 2945

Gas flow control system 2945 controls the sputtering gas supply for apparatus 10.

Flow control for the primary and secondary gasses, discussed above, may be accomplished through use of eight MKS Instruments, Inc., (Andover, Massachusetts) model 2259B mass flow meters and flow controllers, including MKS model 246 readout displays. Eight isolation valves GF1-GF8 are located between each 2259B mass flow meter and its associated model 246 display. Eight flow control valves FLO1-FLO8 control the flow rate of the primary and secondary gases.

Eight digital outputs of programmable logic controller 2902 are dedicated to control the open/close state of isolation valves GF1-GF8. Computer 2901 receives eight analog input (0-5 volt) flow measurement signals (designated FLO1-FLO8 by "THE FIX") to monitor gas flow via the model 2259B mass flow meters. Flow setpoints of flow controller valves FLO1-FLO8 of the model 2259B mass flow meters are controlled by eight 0-5 volt output signals FLOST1-FLOST8 through network interface 2903 under the control of computer 2901.

9. Gas Pressure Control System 2950

In conjunction with gas flow control system 2945, discussed above, gas pressure control system 2950 monitors and controls pressure in apparatus 10 through a series of four capacitance manometers CM1-CM4, each capacitance manometer CM1-CM4 being separated from apparatus 10 by an associated isolation valve CHV1-CHV4. Each capacitance manometer CM1-CM4 and isolation valve CHV1-CHV4 may comprise, for example, MKS model 390H and 270B capacitance manometers manufactured by MKS Instruments, Inc., supra. MKS model 390H and 270B capacitance manometers include outputs providing analog output signals to computer 2901 for monitoring the gas pressure measured thereby, and digital signal inputs to allow for variable control of the metering range of each capacitance manometer or CM1-CM4. Generally, capacitance manometers CM1-CM4 monitor pressure in apparatus 10 subsequent to evacuation of chambers 14-29 by mechanical pumps MP1-MP3. Specifically, gas pressure monitoring during pump-down of apparatus 10 is provided by twenty pirani gauges PIR1 - PIR20; at crossover, the point at which evacuation by mechanical pumps MP1-MP3 blower BL1-BL3 ceases and pumping by cryogenic pumps C1-C12 begins, capacitance manometers CM1-CM4 are used.

Four outputs of programmable logic controller 2902 are dedicated to control open/close states of isolation valves CMV1-CMV4. Four inputs of network interface 2903 receive analog pressure readouts (designated CM1-CM4 by "THE FIX") of capacitance manometers CM1-CM4. Eight discrete outputs of network interface 2903 are dedicated to provide 2-bit digital signals CMR1.1, CMR2.1, CMR1.2, CMR2.2, CMR1.3, CMR2.3, CMR1.4, CMR2.4 to control the pressure metering range of capacitance manometers CM1-CM4.

10. Heater Control System 2955

Substrate heating, including dwell heating in chamber 14 and passby heating in chamber 16, to maintain a uniform temperature gradient over the substrate surface is governed by heater control system 2955. Control of both the "dwell" and "passby" heater banks 1510A, 1510B, 1510C, 1510D, 1620A, 1620B, 1620C, 1620D, 1818A, 1818B, 1818C, 1920A, 1920B, 1920C, 1920D, discussed in Section H of this specification, may be provided by eight Emerson Spectrum III Heater Controllers, manufactured by Emerson Industrial Controls, Grand Island, New York. The Emerson Spectrum III controllers allow digital heater temperature setpoint control of the quartz lamp heating elements discussed in section H. Thus, heater setpoints once set will be maintained by each Spectrum III.

In the present embodiment, heater control system 2955 thus utilizes: eight digital outputs of programmable logic controller 2902 providing on/off control signals RH1A-RH3C to the Emerson Spectrum III controllers; eight digital outputs of programmable logic controller 2902 controlling high/low output enable RH1A-RH3C for the Emerson Spectrum III controllers; eight inputs of programmable logic controller 2902 receiving heater fault signals H1A0FLT-H3C0FLT; eight analog outputs from network interface 2903 controlling the voltage setpoints of heater bank sets 1510A/1510B, 1510C/1510D, 1620A/1620B, 1620C/1620D, 1818A/1818D, 1818B/1818E, 1818C/1818F, 1920A/1920B, and 1920C/1920D, and eight analog inputs to network interface 2903 monitoring each heater bank set's current setpoint output HSP1-HSP8.

A preferable embodiment of heater control system 2955 would provide individual control of each of heater banks 1510A-1510D, 1620A-1620B, 1818A-1818D, and 1920A-1920D. Such an embodiment would include additional hardware lines to control each of the heater banks coupled to the electronic control system. In an embodiment using Emerson Spectrum 3 controllers, sixteen such controllers would be utilized and sixteen digital outputs of programmable logic controller 2902 would be needed to provide on/off control signals, sixteen digital outputs of programmable logic controller 2902 would be required to provide high/low output enable signals, sixteen additional outputs of programmable logic controller 2902 would be utilized for heater FALSE signals, sixteen analog outputs from network interface 2903 would be needed to control voltage setpoints of the heater banks, and eight analog input signals to network interface 2903 would be utilized to monitor each heater banks current setpoint output.

11. Substrate Temperature Sensing System 2960

Six Mikron temperature sensors (not shown) may be provided at various locations throughout the sputtering apparatus in a movable configuration to measure the temperature gradient over the surface of the substrate as it proceeds through various sections of the sputtering apparatus. The Mikron sensors provide 0-5 volt analog output signals TEMP1-TEMP6 through network interface 2903 for output to user interface 2904, thereby allowing the system operator to monitor at every cycle and react each heater bank 1818A-1818C output to maintain a uniform temperature gradient across the surface of the substrate as it proceeds through the apparatus. In general, sensors may be provided in chamber 16 or 18.

12. Power Supply Control System 2965

Power supply control system 2965 controls twenty-four (24) designated forty-eight (48) actual, in master-slave configuration), power supplies PS1A, PS1B, ... PS12A, PS12B which provide high power output to the sputtering magnetrons utilized in Chambers 20, 26 and 28 of sputtering apparatus 10. Power supplies PS1A-PS12B may be Model MDX-20X 20KW DC Plasma Power Supplies, Manufactured by Advanced Energy Industries Corporation, Fort Collins, Colorado, capable of providing constant current, power, or voltage, and remote control thereof.

Control signals for power supply control 2965 are entirely controlled by computer 2901 through network interface 2903. One hundred sixty-eight inputs of network interface 2903 are utilized as follows:

| # of INPUTS | Signal Designation | Function |
| --- | --- | --- |
| 24 | PSLS1A-PSLS12A PSLS1E-PSLS12E | read power supply set point level |
| 24 | PSVO1A-PSVO12A PSVO1E-PSVO12E | read power supply voltage output |
| 24 | PSCO1A-12A PSC01B-12B | read power supply current output |
| 24 | PSO1A-12A PSO1B-12B | read power supply power output |
| 24 | PSTL1A-12A PSTL1B-12B | read sputtering target life calculation in power supply |
| 24 | PSARC1A-12A PSARC1B-12B | read power supply arc detect sense from power supply |
| 24 | PSSR1A-PSSR12A PSSR1B-PSSR12B | read power supply set point signal reached |

One hundred six analog and digital outputs of network interface 2903 are provided to the power supplies as follows:

| # of INPUTS | Signal Designation | Function |
| --- | --- | --- |
| 24 | PSSP1A-12A PSSP1B-12B | (analog) power supply level set signals |

(continued)

| # of INPUTS | Signal Designation | Function |
|---|---|---|
| 24 | PSM1.1-1.12<br>PSM2.1-2.12 | (digital) mode control signals (12 x 2) |
| 24 | PSON1A-12A<br>PSON1B-12B | (digital) on/off signals (12 x 2) |
| 3 | PSIV1-3 | (digital) indicating vacuum chamber interlocks intact |
| 3 | PSIW1-3 | (digital) indicating water interlocks intact |
| 3 | PSIX1-3 | (digital) indicating heater cover interlocks intact |
| 1 | PSRES | (digital) emergency stop restore |

The aforesaid input signals to network interface 2903, including level set point signals, voltage output signals, current output signals, power output signals, target life signals, arc out signals, and set point reached signals, yield precise data feedback for provision to both the user and the control system software to monitor power supply performance. Interlock control signals PSTV1-PSTV3, PSTW1-PSTW3, PSTX1-PSTX3 are coupled to sensors (not shown) on interlock protective covers 2305 of sputtering apparatus 10 to cut out power supply output if the signals are tripped by an open interlock protective cover 2305 thereby preventing operator injury.

13. Coolant Control 2970

Circulating coolant fluid, such as water, is provided to various components of the sputtering apparatus to maintain temperatures within acceptable operating levels during production thereby forestalling rapid depletion of these system components. Specifically, coolant is provided to heaters 1512, shields 2230, compressors Cyl-CY8, and sputtering cathodes 2222.

Coolant control system 2970 monitors the temperature level of the circulating coolant flow in the coolant system and controls the open/close states of coolant flow control valves. While the particular layout of the coolant flow system is not shown, it will be understood by those skilled in the art that any suitable number of coolant control schemes may be utilized within the scope of the present invention. The location of coolant flow sensors CHR1A/CHR1B - CHR4A/CHR4B; MAG5A/MAG5B - MAG8A/MAG8B; CAR9A/CAR9B - CAR12A/CAR12B, is shown in general form in Fig. 12.

Coolant flow control 2970 includes 24 magnetron cathode coolant flow sensors CHR1A/CHR1B - CHR4A/CHR4B; MAG5A/MAG5B - MAG8A/MAG8B; CAR9A/CAR9B -CAR12A/CAR12B, six sputtering shield coolant flow sensors CHRS1-CHRS2; MAG1-MAG2, and CARS1-CARS2, and six heat shield coolant flow sensors HSFS1-HSFS6. Each of these sensors provides a digital output signal to one input of programmable logic controller 2902. Six water supply flow control valves CHSUV1-CHSUV2, MAGSUV5-MAGSUV6, and CARSUV9-CARSUV10, two supply valves per sputtering chamber, and six water return path valves CHRTV3 CHRTV4, MGRTV7-MGRTV8, CARTV11-CARTV12, two return path valves per sputtering chamber, are provided. Twelve outputs from programmable logic controller 2902 control the open/close states of the water supply valves and the water return path valves.

In addition, two main coolant on valves HH201 and HH202 are controlled by programmable logic controller 2902.

### 14. Pirani and Ion Gauge Control 2975

Gauge control 2975 also monitors the outputs of each pirani gauges PIR1-PIR20 and ion gauges monitoring residual ion contaminants in sputtering apparatus.

Vacuum pressure during the pumpdown process prior to crossover between mechanical pumps MP1-MP3, blowers EL1-EL3 and cryogenic pumps C1-C12, is monitored by twenty (20) pirani gauges PIR1 - PIR20 provided in the pumping conduits linking cryo pumps C1 - C12 with sieve valves SVIV1 - SVIV12, in chambers 12, 14, 20, 26, 28, 29 and 30 of sputtering apparatus 10, and in the conduit linking pump MP2 and blower BL2 with apparatus 10. Twelve pirani gauges PIR3-5, PIR7-9, PIR12-14 and PIR18-20 monitor pressure during outgassing in the region between cryo pumps C1-C12 to cryogenic roughing valves CR1-CR12. Seven pirani gauges PIR1, PIR2, PIR6, PIR11, PIR16, PIR15, and PIR17 to pressure monitor of chambers 12, 14, 20, 26, 28, 29 and 30.

Analog signals in the range of 0-10 volts are output from gauges PIR1-PIR20 to indicate the measured pressure reading of each gauge and are provided to the network interface 2903. Twenty digital signals (designated PIR1 - PIR20) provided to programmable logic controller 2902 inputs to indicate the crossover point set for switchover between mechanical pumps MP1-MP3, blowers BL1-BL3, and cryogenic pumps C1-C12.

Four ion gauges IG1-IG4 (not shown) measure the level of background gas (i.e., water contamination) in chambers 14, 20, 26 and 28 of sputtering apparatus 10. Analog output signals ION1-ION4 are provided by gauge control 2975 network interface 2903 for output to user interface 2904 to provide the system operator with data for controlling the pump-down process.

In the preferred embodiment of the present invention, the pirani gauges and ion gauges are coupled through INFICON gauge monitor subsystems, manufactured by Leybold-Heraeus, Hanau, Germany, which provide an independent power source and hardware for use with the pirani gas and ion gauges discussed above.

### 15. Residual Gas Analyzers 2980

Residual gas analyzers RGA1 - RGA4 are utilized with sputtering apparatus 10 to monitor system status. Isolation of the residual gas analyzers RGA1 - RGA4 is controlled by the electronic control system by means of four isolation valves RGAV1 - RGAV4. Four dedicated outputs of programmable logic controller 2902 are provided to residual gas analyzers RGA1-RGA4 to open and close analyzer isolation valves RGAV1-RGAV4.

Sensors RGAS1-RGAS4 are provided to four inputs programmable logic controller 2902 to provide a status indication of residual gas analyzer valves RGAV1-RGAV4 indicating valve's opened or closed state.

### System Control Software

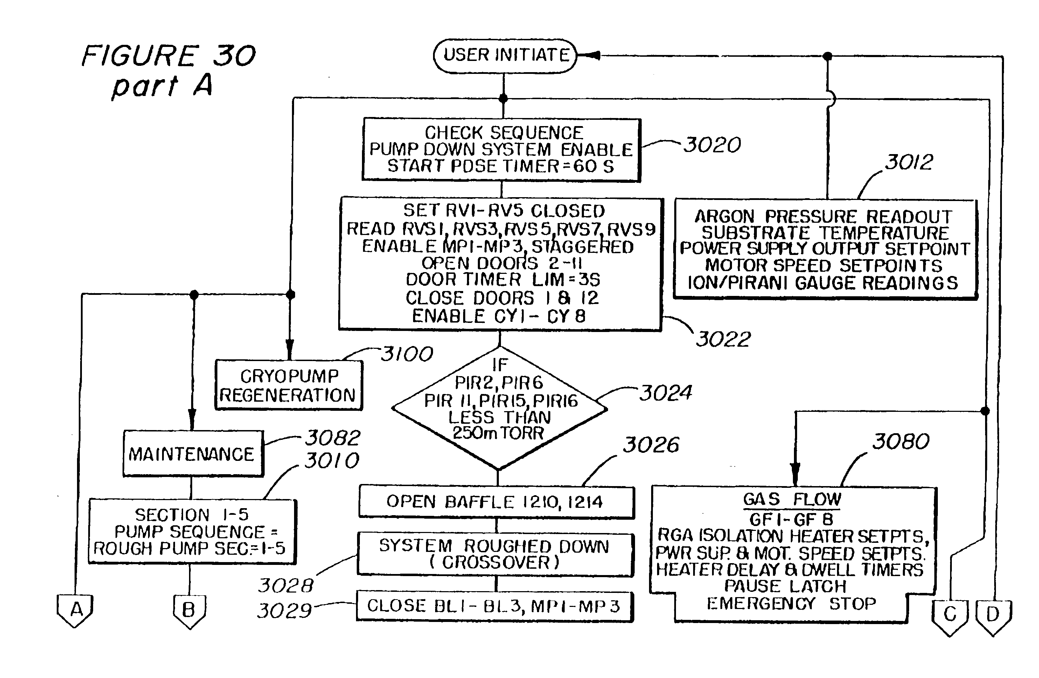

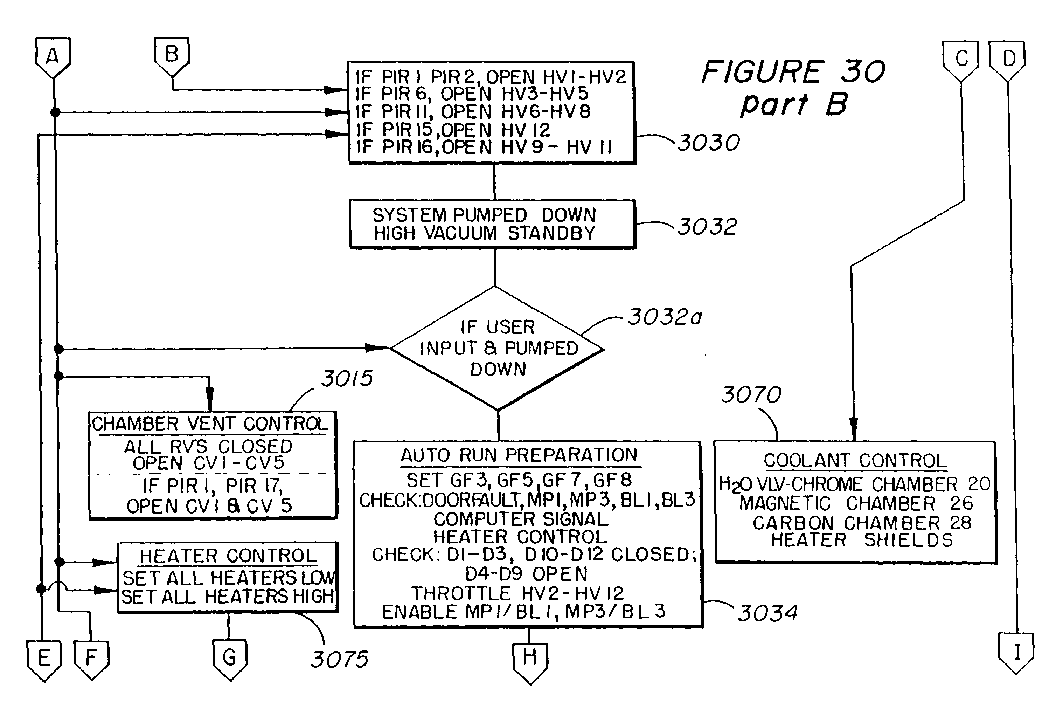

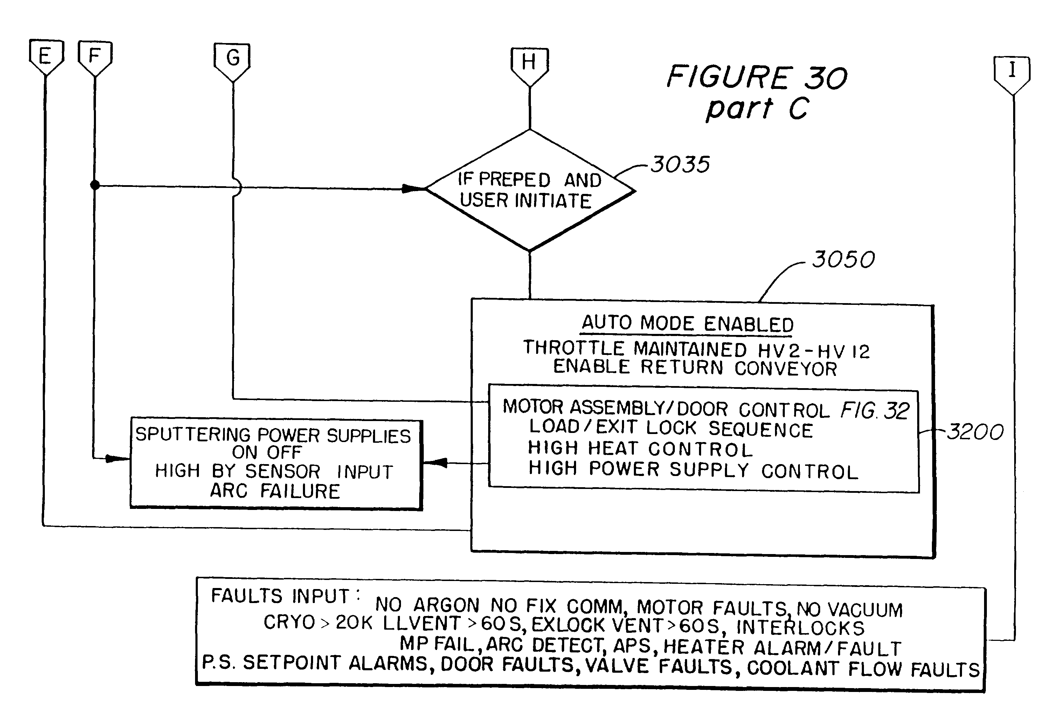

Figure 30 is an overview flow-chart diagram of the system control software of the present invention. It should be noted that the following description is intended to be a general discussion of the capabilities and functions of the system software. Specific software functions and capabilities will be understood by one skilled in the art after a review of the source code in Sections M and N. It should be further noted that the following discussion does not differentiate between those functions controlled by programmable logic controller 2902 and computer 2901. As will be recognized by those skilled in the art, any of the functions described with respect to Figures 30-32 may be performed by a single process controller or multiple process controllers. The preferred embodiment for performing each of the functions outlined in Figure 30 is shown in Figure 29 and detailed in the source code sections.

As shown in Figure 30, the software architecture is designed to allow both manual and automatic control of select system functions. Certain processes are automated while others depend on comprehensive feedback provided to the user (system operator) allowing the system operator monitor and react to such feedback to make adjustments in particular operating parameters (such as heater power level, and sputtering power supply output levels, etc.) to obtain optimal sputtering characteristics.

In the embodiment of the control software shown in Figure 30, the user or system operator manually controls: gas flow valves GF1-GF8, residual gas analyzer isolation valves (RGAV1-RGAV4); passby and dwell heater setpoints (HSP1-HSP8); power supply and motor speed setpoints (PSSP1A-PSSP12B, DMOTLO1-DMOTLO21, DMOTHI1-DMOTHI21); the amount of time spent by a substrate in dwell heater chamber 14 (HTR1TMR); the amount of time the passby heater is on while a pallet is passing therethrough (HTR2ON_DLY); and an emergency stop and pause latch commands.

In addition, other elements such as coolant control, venting control, heater control, power supply control and cryo-pump system evacuation are manually initiated. Specifically, coolant control functions 3070 initiate coolant flow to heater shields 2230 and cathodes 2222-2225 in chambers 20, 26, and 28 upon manual power up of the system. Further, manual control is provided for some heater control functions 3075, such as selection of low and high heater setpoints. Manual control of the heater setpoints allows the user to monitor the output of the (Mikron) substrate temperature sensors and make adjustments to individual heater bank setpoints and/or substrate heating duration timers to achieve an optimal thermal effect on individual substrates moving through heater chambers 14 and 16. Additionally, manual control of some chamber vent functions 3015 allows for apparatus 10 to be vented in whole or in sections for machine maintenance.

Feedback block 3012 provides the user with such data as: argon pressure readout, substrate temperature, power supply output setpoints, motor speed setpoints, an ion & pirani gauge readouts. Additional data, such as that described above with respect to Figure 29, is also provided to the system operator.

Referring to Figure 30, apparatus 10 is generally maintained in a standby state 3028 at full vacuum, e.g., 1 x $10^{-7}$ Torr. At system standby 3028, apparatus 10 has been pumped down to a high vacuum level by mechanical pumps MP1-MP3, blowers BL1-BL3 and cryopumps C1-C12. The system stand-by condition is usually maintained due to the time required to perform total system pumpdown.

As noted briefly above, system maintenance 3082 may be performed when apparatus 10 is on a section by section basis while venting only those sections necessary for maintenance purposes. In such cases, apparatus 10 is divided into five sections. Generally these sections comprise: chambers 12-14; chambers 18-24A; chambers 22B-24B; chambers 22D-24C; and chambers 29-30. Each of the five sections can be individually vented and pumped down under user control as required, depending on what access to apparatus 10 is required. In this regard, the chamber vent control functions 3015 allow the user to individually control of the opened or closed state of chamber vent valves CV1-CV5 depending on which section is to be vented. Automated section pump sequences 3010 are provided to control roughing down of each section 1-5 using pumps MP1-MP3 and blowers BL1-BL3, and high vacuum valves sequence 3030 to control valves HV1-HV12 as required, to reduce individual sections to high vacuum. Section pump sequence 3010 also ensures that doors D1-D12 are in their required opened or closed states with respect to the pumping or venting of the particular stage as required:

| | DOORS CLOSED | |
|---|---|---|
| STAGE | PUMP | VENT |
| 1 | D1 - D3 | D1 - D4 |
| 2 | D4 - D6 | D3 - D5 |
| 3 | D5 - D8 | D6 - D7 |
| 4 | D7 - D10 | D8 - D9 |
| 5 | D9 - D12 | D10 - D12 |

In the instance where chambers 12-30 of apparatus 10 have been fully vented and are at ambient atmosphere, an automated pump down sequence is provided to reduce the pressure of chambers 12-30 to approximately 50 mTorr. The user initiates the pump down system enable sequence 3020 which provides a check and setup for the pump-down process. A pump down timer PDSTMR is initialized which allows the pump down enable process to run for a maximum of 60 seconds before issuing a fault.

The enable process (PDSE) 3022 comprises: closing RV1-RV5; checking RVS1, RVS3, RVS5, RVS7, RVS9 to ensure valves RV1- RV5 are closed; enabling MP1-MP3; opening doors D2 - D11 (within a limit of 3 seconds before outputting a fault); closing doors D1 and D12; and enabling compressors Cyl-CY8. A pirani gauge check 3024 is performed to ensure that PIR2, PIR6, PIR11, PIR16, and PIR15 are less than 125 mTorr (or equivalent preset level between 100-250 mTorr) before the system opens baffles 1210 and 1214. At this point, apparatus 10 has reached a roughed down state 3028 wherein each chamber 12-30 is at a pressure of approximately 50 mTorr, and blowers BL1-BL3 and mechanical pumps MP1-MP3 are disabled (3029).

To reduce the pressure in apparatus 10 to a level conducive to sputtering, high vacuum valves HV1-HV12 must be fully opened to allow cryogenic pumps C1-C12 to pump apparatus 10. This sequence 3030 is initiated by a manual user input 3030a assuming the system has reached the roughed, crossover point 3028. At stage 3030, pirani gauges PIR2, PIR6, PIR11, PIR16, and PIR15, corresponding to individual pump sections 1-5, are checked before opening each respective high vacuum valve sets HV1-HV2, HV3-HV5, HV6-HV8, HV9-HV11, and HV12, respectively associated therewith. Once high vacuum valves HV1-HV12 are opened, cryogenic pumps C1-C12 will evacuate the internal environment of chambers 12-30 to a pressure of approximately $1 \times 10^{-7}$ - $2 \times 10^{-7}$ Torr.

When apparatus 10 has achieved a pumped down state 3032, the auto run preparation mode 3034 must be initiated by a manual user input 3032a. Auto run preparation sequence 3034 involves: providing argon backfilling by opening GF3, GF5, GF7, and GF8; checking for no doorfaults ($\overline{\text{DOORFAULT}}$); check/enable mechanical pumps MP1 & MP3, and blowers BL1 and BL3; check and set dwell and passby heaters to low power setpoints; check and/or set doors D1-D3, D10-D12 closed, and doors D4-D9 open; and throttle HV2-HV12.

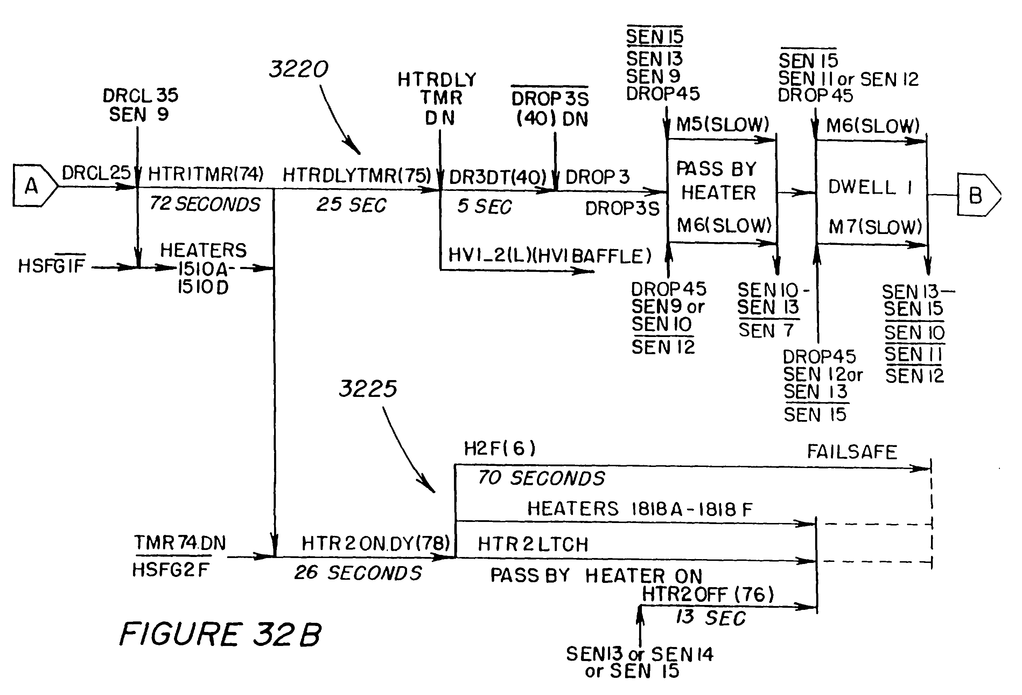

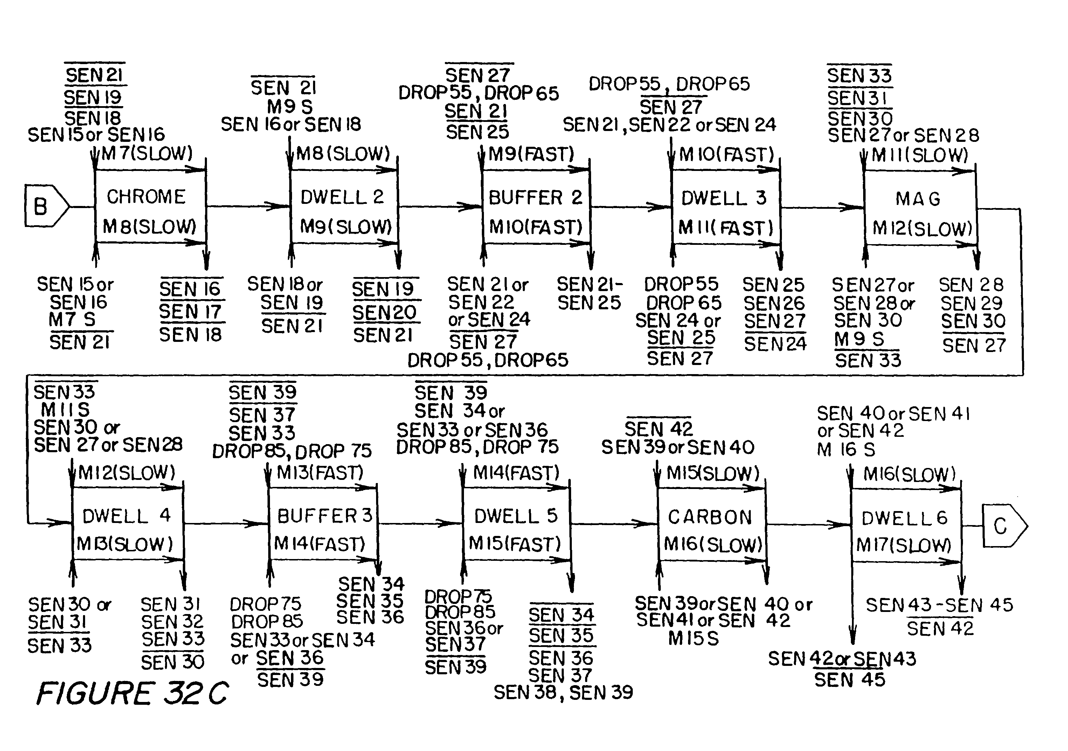

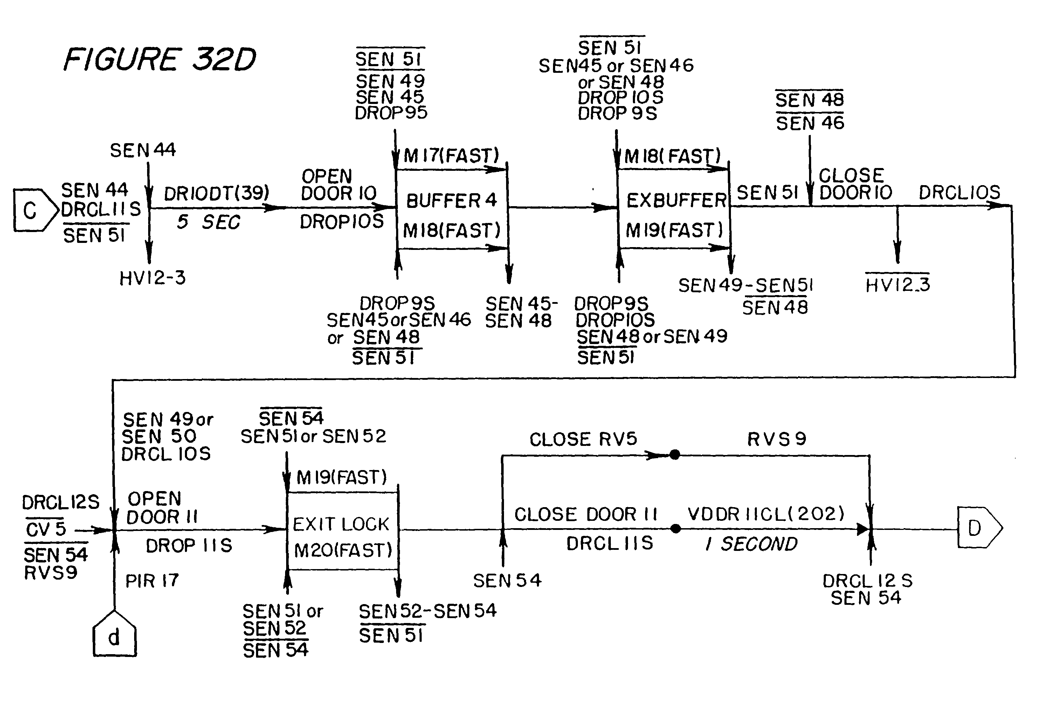

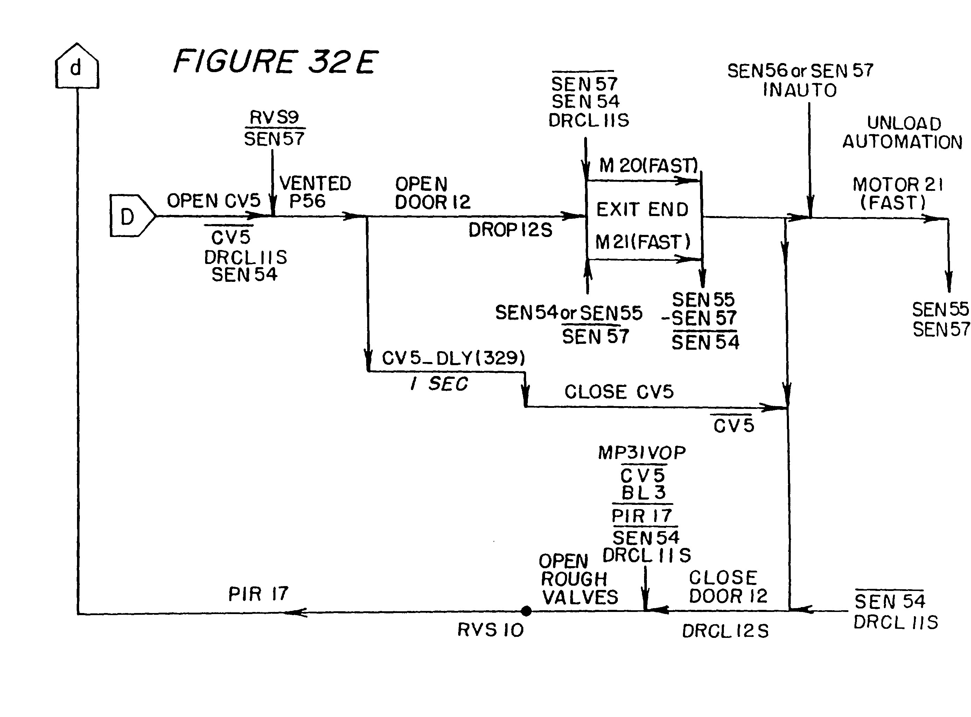

Once the system is prepared for auto run mode operation, a user input 3035 is required before the auto run mode 3050 is enabled. If the user input is made and the system is prepared, the auto mode is enabled. Auto mode functions 3050 include throttling high vacuum valves HV2-HV12 and enabling the transport stages of return conveyor path 50. In addition, auto mode 3050 includes the automatic run sequence 3200 controlling motor assemblies, door operation, load/exit lock pumping and venting, and high power supply/heat control described in Figure 32. Sputtering power supplies PS1A-PS12B will have been manually preset to low power. It is noteworthy that coolant control sensors CHR1A-CHR4B, MAG5A-MAG5B, and CAR9A-CAR12B must indicate the presence of circulating coolant in cathodes 2222-2225 before power supplies PS1A-PS12B will be enabled.

Upon exiting auto mode 3050, apparatus 10 returns to a standby state wherein the dwell and passby heaters in chambers 14 and 16, respectively, are automatically switched off and auto run mode is disabled.

The software also provides a number of fault flags to the user to allow the user to correct potential problems or to hold processing of other logic rungs until correction of the fault is completed. Such faults may include, for example, argon gas flow failure detection (NO ARGON); a failure in communications between computer 2901 and programmable logic controller 2903 (NO FIX COMM); motor assembly faults; internal system pressure failures (NO VACUUM); cryogenic pump failures (CRYO > 20°K); load lock and exit lock venting problems (LLVENT > 60 s, EXLOCK VENT > 60s); open protective covers on sputtering chambers 20, 26, 28, (INTERLOCKS); mechanical pump and blower failures (MP FAIL); power supply arc (ARC DETECT); air supply failsafe (APS); heater alarm/fault; power supply setpoint alarms; door faults (DOORFAULT); valve faults; and coolant flow faults.

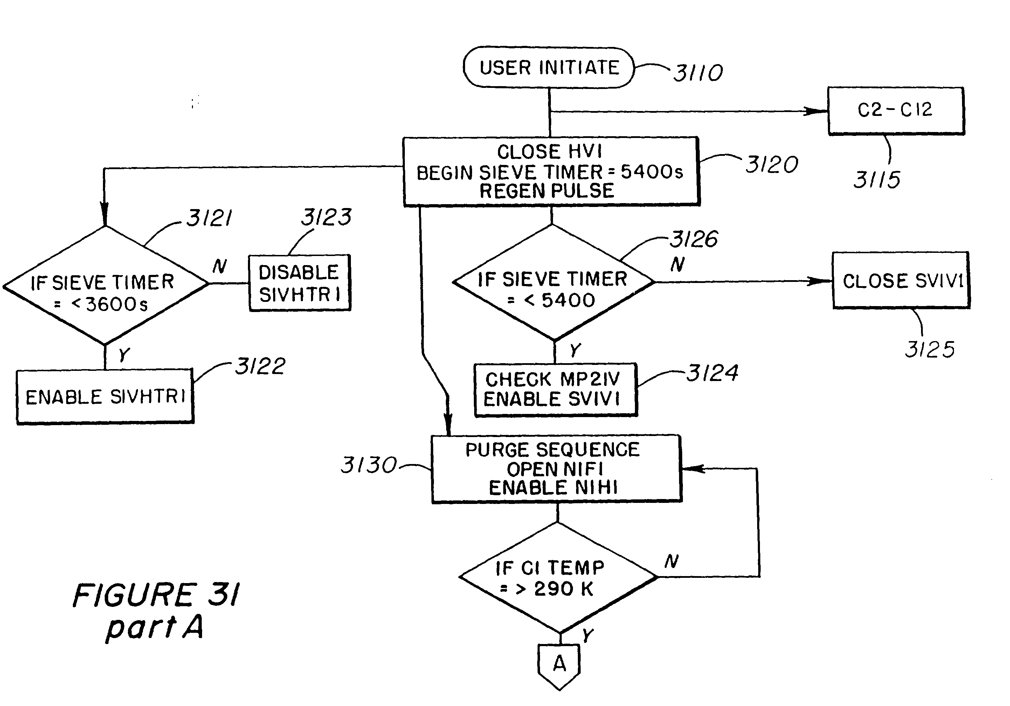

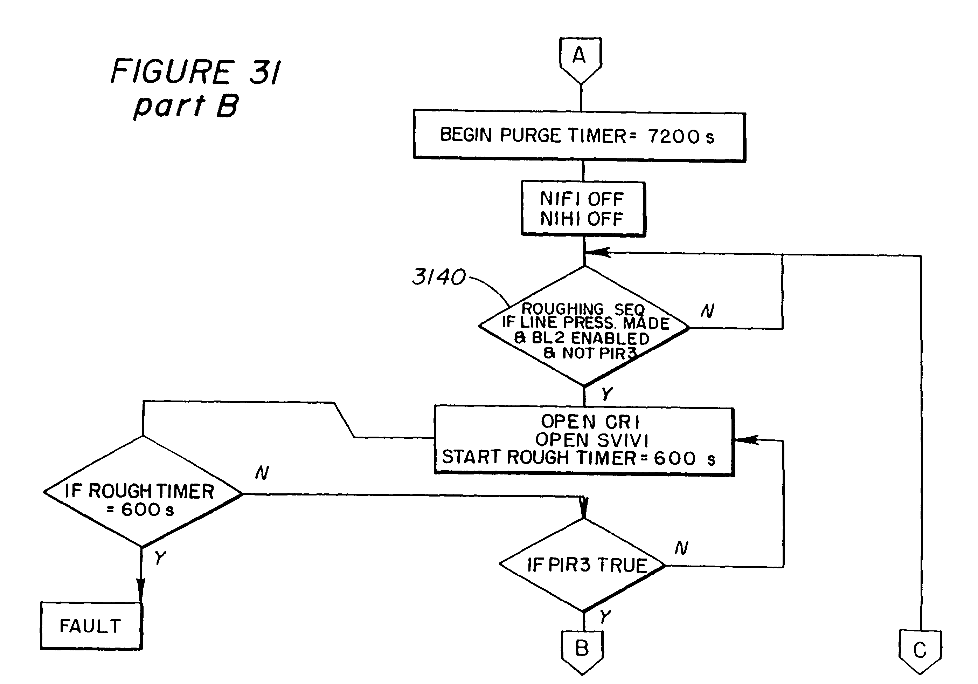

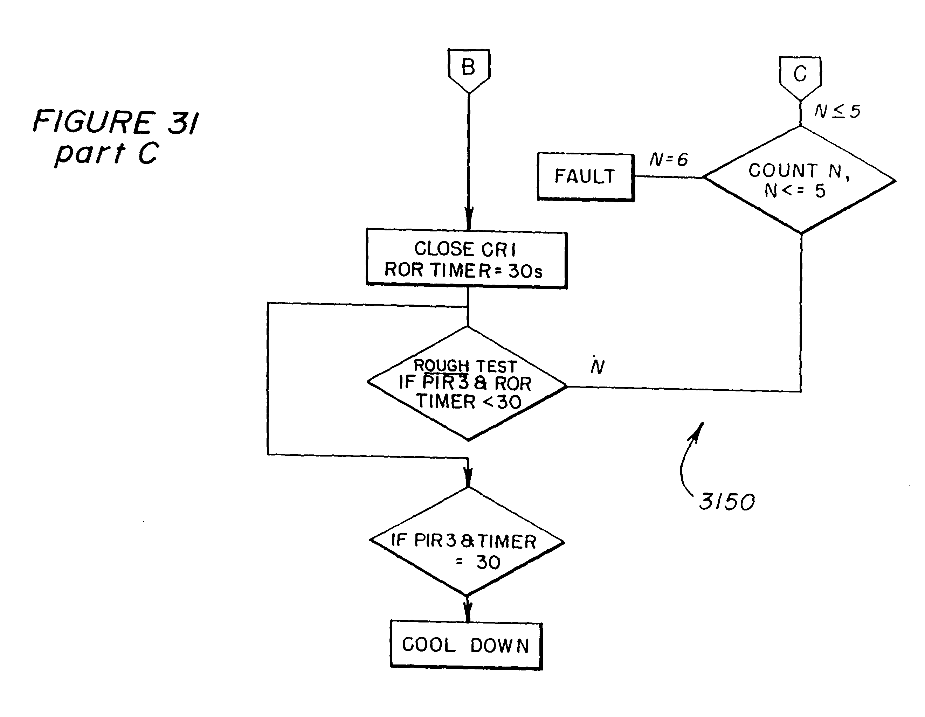

An automated process 3100 for regenerating (cleaning and purging) cryo pumps C1-C12 is also provided in the software of the present invention. Cryogenic pump regeneration process 3100 will be discussed with respect to Figure 31. Figure 31 is a flowchart showing the cryogenic pump regeneration process for a single cryogenic pump, C1. The regeneration processes for pumps C2-C12 are identical, using corresponding valves, gauges, and heaters, coupled to respective pumps C2-C12 as applicable, for each pump C2-C12 being regenerated.

In general, the cryogenic pump regeneration comprises raising the temperature of the cryogenic pumps, supplying the pumps with warm nitrogen, and enabling mechanical pump MP2 and blower BL2 to flush the contaminant materials agitated by the nitrogen flow out of the cryo pumps.

Cryogenic pump regeneration process 3100 is manually initiated by a user 3110. User initiation of the cryogenic pump regeneration process preferably enables simultaneous regeneration of all twelve cryogenic pumps 3115. The initial regeneration step 3120 entails closing HV1 and initiating a sieve trap timer with a total duration of 5400 seconds.

The sieve timer initiates enables sieve heater SIVHTR1 for 3600 seconds (3121, 3122). Further, mechanical pump isolation valve MP2IV is checked and sieve valve SVIV1 is opened (3124) for a duration of 5400 seconds (3126); valve SVIV1 is closed at the expiration of 5400 seconds (3125). In addition, the purge sequence 3130 is initiated.

Purge sequence 3130 opens nitrogen flow valve NIF1 and enables nitrogen heater NIH1. Sequence 3130 waits until the cryogenic pump has reached a temperature of 290° K before initiating the purge timer with a duration of 7200 seconds. Purging of the cryogenic pump thereafter continues for 7200 seconds. When complete, NIF1 and NIH1 are closed and roughing sequence 3140 begins.

The roughing sequence involved initially checking to ensure that line pressure (PIR10) is TRUE, BL2 is enabled and PIR3 outputs false (pressure less than 250 mTorr). If these condition are met, cryo roughing valve CR1 and sieve valve SVIV1 are opened, and a roughing timer having a duration of 600 seconds is started. If roughing takes place for longer than 600 seconds a fault is generated. Otherwise, the system waits for PIR3 to output a TRUE condition before closing CR1.

After CR1 is closed, a ROR timer waits for 30 seconds to ensure PIR3 remains TRUE. If at any time before the expiration of thirty seconds a $\overline{\text{PIR3}}$ signal is received, the system counts one and returns to restart the roughing sequence. The system will perform ROR test 3150 generally for up to five cycles (and up to 20 cycles for pump C1) before outputting a fault.

If PIR3 remains TRUE and the ROR timer = 30 seconds, the process goes to cool down -- allowing 7200 seconds for the cryogenic pump to reach a temperature of $\leq 20°K$. If the cryogenic pump does not reach 20° K within 7200 seconds, a fault is generated.

Figures 32A-32D are a logical diagram of one component of the electronic control system software showing input/output and process control of the auto run mode 3200 controlling substrate movement through apparatus 10. In the logical flow diagram of Figures 32A-32D, horizontal lines indicate software logic flow in relation to time, with time increasing in the direction of the arrows shown therein; vertical lines generally represent decision points.

As shown in Figures 32A and 32D, the system control software of the present invention utilizes motor control 2910, position sensors 2915, door control 2920 and pump valve and vent system 2930, to control movement of a substrate through sputtering apparatus 10. The addresses used in Figures 32A-32D correspond to those discussed above with respect to the functional elements of the electronic control system.

As shown in Figures 32A-32D, start point 3200 in entrance lock loop 3210 of the software represents a system status condition wherein sputtering apparatus 10 is prepared for a substrate to enter load lock 12. Start point 3200 may denote the first substrate entering apparatus 10, or may represent a point wherein a prior substrate cleared load lock 12 and passed into heater 14.

At the start point 3200, roughing valves RV1-R5 are closed, doors D4-D9 are open, doors D1-D3, D10-D12 are closed, and chamber vent valves CV1-CV5 are closed. The software also checks for a TRUE output from PIR17, RV5, and DROP10S, indicating, respectively, chamber 30 at crossover pressure, the closed state of roughing valve RV5, and whether door D10 is open.

When a substrate is moved into position at entrance platform 210, the system software is prepared to begin entrance sequence 3210. Position sensors SEN1-SEN3 must indicate a TRUE condition, signaling the presence of a pallet, in order for the software system to proceed. If entrance lock loop 3210 is in a state wherein a substrate has passed out of dwell heater chamber 14, point 3215 in the logic flow line, timer VDDR2CL, which runs for 2 seconds to verify that door D2 has closed, must have completed its sequence in order for processing of that substrate to proceed. Generally, when VDDR2CL is initiated, a substrate will be waiting at entrance platform 210. Thus, input conditions indicated at 3212 will be TRUE and timer VDDR2CL will control initiation of the software logic. After the target position is verified, door close sensor DRCL1S is checked to ensure door D1 is closed, and roughing valve sensor RVS2 is checked to ensure roughing valve RV1 is closed. Additionally, pressure switch PS2 must read FALSE ($\overline{PS2}$), sensor SEN1 is redundantly checked for a TRUE output, and position sensors SEN4-SEN6 must read FALSE to ensure the absence of a substrate in load lock 12. When all the above-mentioned conditions are met, signal OPCV1 is directed to open chamber vent valve CV1 to vent load lock 12. In logical terms, the condition -- DRCL1S AND RVS1 AND $\overline{PS2}$ AND $\overline{SEN4}$ AND $\overline{SEN5}$ AND SEN6 -- must be TRUE to open CV1, as indicated by the input description 3212. Signal OPCV1 causes pressure switch PS2 to output a TRUE state, and pirani gauge PIR1 to output a FALSE state (e.g., pressure above crossover level).

A timer CV1_DLY runs for 1 second before a signal is sent to close CV2. Timer PAL_GAT_TT is a 155 second duration timer provided to ensure a specified amount of time passes between the entrance of successive pallets into load lock 12. Timer PAL_GAT_TT is initialized when door D1 is closed, as signified by $\overline{DROP1}$ or $\overline{DROP1S}$, such signals being generally output after door D1 is closed subsequent to entrance of a substrate into load lock 12, as shown by loop 3214. If PAL_GAT_TT is FALSE ($\overline{PAL\_GAT\_TT}$ e.g., timer complete), and PS2, SEN3, and SEN5, are TRUE then signal DROP1 is sent to open outer door D1 to receive a substrate into apparatus 10. Signal DROP1 will cause door open sensor DROP1S to output TRUE, indicating door D1 is, in fact, open. Prior to activating motor assemblies M3 and M4, the logical condition -- (SEN3 or SEN4) AND $\overline{SEN6}$ AND DRCL2S -- must be TRUE. When this condition is met, motor assemblies M3 and M4 are activated to move the substrate at high motor setpoint speed from entrance platform 210 of the sputtering apparatus into load lock 12. Movement of the substrate will cause sensors SEN4 and SEN6 to output TRUE, and sensors SEN1 and SEN3 to output FALSE. When sensors SEN3 and SEN6 output FALSE and TRUE conditions, respectively, signaling the presence of the substrate in chamber 14, signal DRCL1 is provided to close outer door D1. Signal DRCL1 causes DROP1S to output a FALSE condition indicating door D1 is closed, and enabling timer PAL_GTE_TT, as discussed above.

Subsequently position sensor SEN6, and door close sensors DRCL1S and DRCL2S, when TRUE, enable timer SOFRUF for 1 second, thereby delaying opening of roughing valve RV1. When timer SOFRUF has completed, and the logical condition -- DRCL1S, $\overline{PIR1}$, $\overline{CV1}$, BL1, AND MPIIVOP -- is TRUE, signal OPRV1 is sent to open roughing valve RV1.

High speed, explosive pumping occurs in load lock 12 until such time as the preset requisite chamber pressure is achieved, causing PIR1 to output TRUE. Opening RV1 causes sensor RVS1 to output TRUE, enabling timer DROP2_DLY to run for two seconds to ensure pump MP1 and blower BL2 have sufficient time to pump load lock 12 down. When timer DROP2_DLY is done and PIR1 is TRUE, RVS1 outputs TRUE and PS2, FALSE. At the same time, signal OPTDR2 is sent to open door D2 to allow the substrate to move between load lock 12 and heater chamber 14.

Before motor assembly M4 will engage, sensor SEN6 must be TRUE, and SEN9 FALSE, to indicate the presence and absence of a target in load lock 12 and heater chamber 14, respectively. If all conditions are met, motor assembly M4 is activated at high speed setpoint; somewhat redundantly, the logical condition -- (SEN6 OR SEN7) AND $\overline{SEN9}$ -- must be TRUE in order for motor assembly M5 to engage at high speed. A substrate is thereby transferred between load lock 12 and heater chamber 14. The engagement of motor assembly M4 and M5 will cause sensors SEN7-SEN9 to output TRUE, and sensor SEN6 to become FALSE. Simultaneously, if the logical condition -- ($\overline{SEN4}$ OR SEN6) AND DR3CLS, SEN9, AND SEN7 -- is TRUE, signal DRCL2 will be sent to close door D2. Signal DRCL will cause sensor DRCL2S to become TRUE, thereby initiating timer VDDR2CL as discussed above.

At point 3215 in the logic diagram, the software and sputtering apparatus 10 are prepared to receive an additional substrate in load lock 12 while proceeding with the sputtering process on the substrate now present in heater chamber 14. Assuming position sensors SEN1 and SEN3 indicate the presence of a substrate, loop 3210 will return to start position 3200 and may continuously receive additional substrates while processing of other substrates continues at different points in apparatus 10 in accordance with the following discussion.

At this point, it is notable that the aforesaid redundant signal and sensor readings take on additional significance when multiple targets will be moving through the system. These fail safe sensor readings are provided to ensure smooth operation of apparatus 10, and the absence of pallet collisions or errors within the apparatus.

The substrate present in heater chamber 14 continues through apparatus 10 under the control of the system software as follows. Door close sensors DRCL2S and DRCL3S to ensure doors D2 and D3 are closed. Again, sensor SEN9 is checked to ensure the presence of a pallet in heater chamber 14. If all such conditions are true, HTR1TMR engages for 72 seconds; simultaneously, if no water faults are detected ($\overline{HSFG1F}$) heaters 1510A-1510D are driven to high power to act on the substrate present in chamber 14. Heating of the substrate in heater chamber 14 occurs for a specified duration as determined by HTR1TMR.

Upon completion of 72 seconds, two heater timers are initiated: HTRDLYTMR and HTR2ONDLY. If HTR1TMR is completed and no water faults are present ($\overline{HSFGIF}$), timer HTR2ONDLY, having a duration of 26 seconds, is enabled to control initiation of passby heaters 1818A-1818F and fault generation signal H2F upon its completion. Simultaneously HTRDLYTMR, having a duration of 25 seconds is enabled and measures out the substrate soak time in dwell heater chamber 14. Upon completion, timer HTRDLYTMR initiates the motor control and venting sequence 3220 which runs simultaneously with heater control timing sequence 3225, generally illustrated in Figure 32B. After 25 seconds, baffle 1210 is throttled by signal HV1_2 and timer DR3DT, having a duration of 5 seconds, is initiated. If $\overline{DROP3S}$ is TRUE and timer DR3DT is done, signal DROP3 is provided to open door D3 to allow the substrate to pass from heater chamber 14 into first buffer/passby heater chamber 16.

As will be noted by following parallel processes 3220 and 3225, heater banks 1818A-1818E will have been initiated by HTR2ONDLY prior to the substrate's entry into chamber 16 and are timed to remain on until a point at which the substrate is exiting chamber 16. DROP3 will cause door open sensor DROP3S to indicate door D3 is in an open state. When the logical condition -- SEN9, $\overline{SEN13}$, $\overline{SEN15}$ AND DROP4S -- is TRUE, motor assembly M5 is enabled at slow setpoint speed. When the logical condition -- DROP4S, $\overline{SEN12}$ AND (SEN9 OR SEN10) -- is TRUE, motor assembly M6 is activated at slow setpoint speed to pass the substrate through from heater chamber 14 first to buffer passby heater chamber 16.

As the substrate is passed through chambers 14 and 16, SEN10-SEN13 will output TRUE and SEN7, FALSE. Subsequently, if the condition -- (SEN11 OR SEN12) AND DROP4S AND $\overline{SEN15}$ -- is TRUE, motor assembly M6 is enabled, and if -- (SEN12 OR SEN13) AND DROP4S AND $\overline{SEN15}$ -- is TRUE, motor assembly M7 is enabled at slow setpoint speed to pass the substrate from passby chamber 16 into dwell chamber 18. It will be noted that movement of the substrate into chamber 18 triggers SEN13, which in turn initiates timer HTR2OFF. HTR2OFF is set with a duration of 13 seconds, a period which, when used with the motor setpoint speeds set out above (Table 1), shuts off passby heaters 1818A-1818E before the substrate fully exits chamber 16. This is to avoid overheating the trailing edge of the substrate, as discussed above. It is further noted that heater fault timer H2F runs for duration of 70 seconds before outputting a fault, indicating that the heater banks have been on too long, possibly resulting in burnout of the heating elements.

In like manner, movement of the substrate through sputtering apparatus 10 by motors M7-M19 continues as shown in Figs. 32C and 32D with associated inputs and outputs shown therein having like affect as the I/O discussed above. Each input condition shown must be met in order to activate subsequent motor assemblies along the substrate's path through sputtering apparatus 10. Likewise, each signal causes an output state change for each sensor or value indicated. In like manner, only those motor assemblies M6/M7, M7/M8, M8/M9, M9/M10, M10/M11, etc., necessary for particular platforms to transport the substrate present at that location are activated. Individual motor assembly speeds are set as discussed in Table 1 to vary the velocity of the substrate through particular chambers of sputtering apparatus 10 as the sputtering process requires. As noted with respect to Figures 32A-32D, and Table 1, motor assembly pairs operate at the same speed in order to assure smooth substrate transport.

As shown in Figure 32D, an exit lock loop 3250, similar to entrance lock loop 3210 discussed above, allows sequential passing of substrates through exit lock chamber 30 to ensure the integrity of the evacuated environment in sputtering apparatus 10 is maintained.

Beginning at point 3252, if -- DRCL10S, $\overline{CV5}$, $\overline{SEN54}$, AND RVS9 -- are TRUE, (indicating door D10 is closed, chamber vent CV5 is closed, substrate at SEN54, and roughing valve RV5 is open, respectively), signal DROP11 is sent to open door D11, thereby causing sensor DROP11S to output TRUE. If -- (SEN51 OR SEN52) AND $\overline{SEN54}$ --

then, motor assemblies M19 and M20 are enabled at high setpoint speeds, causing SEN52-SEN54 to be TRUE and SEN51 to be FALSE. Sensor SEN54 enables a signal to close RV5, thereby causing RVS9 to output TRUE, and also enables a signal to close door DR11, causing DRCL11S to output TRUE. A delay timer VDDR11CL delays CV5's closing for 1 second to allow venting of exit lock 30. Once the above conditions are met, and sensor SEN54 is TRUE (pallet in exit lock 30) and DRCL12S is TRUE (door D12 closed), chamber vent CV5 is opened. Subsequently, if roughing valve RVS9 is shown as TRUE, sensor SEN57 indicates FALSE, door close sensor DRCL11S and sensor SEN54 indicate TRUE, and pressure switch PS6 indicates TRUE, exit lock 30 will be vented to atmosphere (opening CV5) and a signal DROP12 will be sent to open door 12, thereby resulting in door open sensor DROP12S outputting a TRUE condition. When pressure switch PS6 outputs a TRUE condition, timer CV5_DLY having a duration of 1 second, will be enabled. Timer CV5_DLY will, upon completion, output a signal to close chamber vent valve CV5.

Once door D12 is open, if sensor SEN54 is TRUE, sensor SEN57 output FALSE, and door sensor DRCL11S outputs TRUE, motor assembly M20 will be enabled to proceed at its fast speed setpoint. Simultaneously, if sensor SEN54 or SEN55 output TRUE, and sensor SEN57 outputs FALSE, motor M21 will be enabled to proceed at its fast setpoint. The substrate present in exit lock 30 will thereafter proceed to exit platform 214.

At point 3260 in the software logic flow, the software branches in two directions, enabling the substrate to proceed to robot unloading station 45, if the logical condition -- SEN56 OR SEN57 -- is TRUE thereby enabling motor assembly M21 to proceed at its fast setpoint, or looping to prepare to receive an additional substrate in exit lock 30. To prepare to receive an additional substrate, chamber vent CV5 must be closed. Subsequently, sensor SEN54 must output FALSE and door close sensor DRCL11S output TRUE in order for a signal to be sent to close door D12. If the logical condition -- MP3IVOP, $\overline{CV5}$, BL3, $\overline{PIR17}$, $\overline{SEN54}$, AND DRCL11S -- is TRUE, a signal will be sent to open roughing valve RV5 to pump down chamber 30 to prepare for receiving an additional pallet therein. Opening roughing valve RV5 will cause roughing valve sensor RVS10 to output TRUE, and pirani gauge PIR17 will output TRUE when chamber 30 is below crossover. Apparatus 10 is then in a state which exists at software logic point 3252 to prepare to receive an additional substrate in exit lock 30.

As should be understood by those skilled in the art, the particular cross-over pumping levels described above with respect to the software of the present invention may be varied as desired to achieve the requisite atmospheric conditions in apparatus 10 for the particular sputtering application desired. In the preferred embodiment of the present invention, the pirani gauge pressure setpoints outputting digital signals to programmable logic controller 2902 are shown in Table 2:

TABLE 2

| Gauge | Setpoints (in mTorr) | |
|---|---|---|
| | Upper | Lower |
| PIR1 | 125 | 100 |
| PIR2 | 125 | 100 |
| PIR3 | 80 | 50 |
| PIR4 | 80 | 50 |
| PIR5 | 80 | 50 |
| PIR6 | 125 | 100 |
| PIR7 | 80 | 50 |
| PIR8 | 80 | 50 |
| PIR9 | 80 | 50 |
| PIR10 | 1000 | 50 |
| PIR11 | 125 | 50 |
| PIR12 | 80 | 50 |
| PIR13 | 80 | 50 |
| PIR14 | 80 | 50 |
| PIR15 | 150 | 125 |
| PIR16 | 125 | 100 |
| PIR17 | 125 | 100 |
| FIR18 | 80 | 50 |
| PIR19 | 80 | 50 |
| PIR20 | 80 | 50 |

It should be further understood by those skilled in the art that a multitude of control schemes and sensor I/O arrangements may be utilized within the scope of the present invention to provide an automated control sequence over a substrate or substrates moving through a sputtering apparatus in accordance with the present invention. The above-described automated run mode 3200 provides for a multitude of pallets, optimally seven pallets, moving through apparatus 10 as discussed in the present specification. It should be understood that all such modifications are contemplated as being within the scope of the invention described herein.

L. Process In General

Example 1 illustrates process parameters for sputtering apparatus 10 to produce 950 Oe and 1200 Oe, respectively, hard drive disks.

Example 1

As illustrated in Figure 2, once engaged by substrate carrier 1450, pallet 800 loaded with disk substrates 510 proceeds through door D1 into load lock chamber 12. After pallet 800 enters load lock chamber 12, door D1 closes. Load lock chamber 12 is pumped down to 50 microns (50 mTorr) in 20 seconds by mechanical roughing pump MP1. Door D2 opens, allowing pallet 800 to proceed at 6 ft/min into dwell heating chamber 14. Dwell heating chamber 14 has already been evacuated by cryo pump C1 to $10^{-5}$ Torr (0.01 microns). As pallet 800 proceeds through the chamber, it triggers proximity position sensors which in turn initiate heaters. Heating lamp warmup time is negligible since, during sputtering operations, the lamp filaments are kept warm by a low power level. Pallet 800 and disk substrates 510 soak in dwell heating chamber 14 for 30 seconds with the temperature about 220°C. During this soak period, the heating power applied is 3.1 kW per bank. Argon enters through gas manifolds to backfill dwell heating chamber 14 and equalize the internal pressure before door D3 opens, allowing pallet 800 to proceed. This backfill also maintains pressure equilibrium throughout the apparatus, essential to stabilizing sputtering processes. Door D3 opens to passby heating chamber 16, triggering the initiation of passby heaters. Pallet 800 enters passby heating chamber 16 and after clearing sensor SEN10, triggers the closure of door D3. This chamber also has been evacuated by cryo pump C2 to about $10^{-5}$ Torr (0.01 microns). Passby heating banks 1818A-1818F operate using 7.6 kW per bank. Lamps 1514 on the leading edge of the pallet reduce power as pallet 800 exits into dwell chamber 18 at 6 ft/min. Pallet 800 proceeds through dwell chamber 18 which has already been evacuated by cryo pump C3 to $10^{-5}$ Torr. The pallet proceeds at 6 ft/min past heat reflective panels 2120.

Pallet 800 enters chromium sputtering chamber 20 maintained at 9-12 microns (9-12 mTorr) of argon pressure with argon flow at 300 standard cubic centimeters per minute (sccm). Pallet 800 travels at 6 ft/min as it passes sputtering targets 2226-2229. The sputtering power is 7.5 kW per cathode, with a 1,000 Å thick chromium film deposited. Transport speed through dwell chamber 22A, buffer chamber 24A and dwell chamber 22B is 12 ft/min through open doors D5 and D6. These three chambers are pumped by cryo pumps C4, C5, and C6. Pallet 800 enters magnetic sputtering chamber 26 maintained at 9-12 microns [9-12 mTorr] of argon by cryo pumps C6 and C7 with argon flow at approximately 400 sccm. The transport speed through sputtering chamber 26 is 6 ft/min. The sputtering power is 7.5 kW per cathode, depositing a 800 Å thick CoCrTa film. Transport speed through dwell chambers 22C and 22D and buffer chamber 24B is 6 ft/min. Dwell chambers 22C, 22D and buffer chamber 24B are pumped by cryo pumps C7, C8 and C9. Pallet 800 enters carbon sputtering chamber 28 maintained at 9-12 microns (9-12 mTorr) by cryo pumps C9 and C10 with argon and up to 15% hydrocarbon gas like ethylene or acetylene flowing at 100 sccm. The transport speed is 2.8 ft/min as the pallet passes the sputtering targets in carbon sputtering chamber 28. Sputtering power is 7 kW per cathode with a film thickness of 350 Å. Transport speed through dwell chamber 22E, buffer chamber 24C and exit buffer chamber 29 is 6 ft/min with doors D9 and D10 opening and closing sequentially to allow pallet 800 to proceed. Dwell chamber 22E is pumped by cryo pumps C10 and C11, buffer chamber 24C and exit buffer chamber 29 are pumped by cryo pump C12. Argon is backfilled into exit buffer chamber 29 by cryo pump C12 to equalize the pressure differential existing with respect to exit lock chamber 30. Pallet 800 next proceeds through exit lock chamber 30 which is vented to the atmosphere by chamber vent valve CV5 in 10 seconds. Pallet 800 then proceeds to robotic unloading station 45.

To produce a 1,200 Oe magnetic film, the soak time in dwell heating chamber 14 may be increased to about 50 seconds to allow the substrate temperature to increase to approximately 250°C and/or the pallet transport speed through chromium sputtering chamber 20 may be reduced in order to allow a thicker deposition of a chromium underlayer. Adjustment of soak time and/or substrate temperature parameters depends on the life cycle of the pallet -- a pallet which has proceeded through numerous sputtering runs will have a thicker film deposition which can absorb more water and consequently would have more water to outgas before film deposition.

The many features and advantages of the apparatus and process of the present invention will be apparent to those skilled in the art from the description of the preferred embodiments and the drawings.

Thus, a high throughput process and apparatus which accomplishes the objectives of the invention and provides the above advantages by providing a comprehensive in-line sputtering system utilizing matched component elements to process multiple large single sheet or pallet transported discrete substrates in a continuous, variable speed, sputtering process has been described. Such an apparatus and method can process up to 3,000 95mm disk substrates, and 5,300 65mm disk substrates, per hour. Such high volume production offers both high volume production and, consequently, cost savings per disk on the order of $4.00 per disk over prior art sputtering apparatus and processes. As noted throughout this specification, such an apparatus and process is achieved through a novel combination of process and structural elements involved in disk preparation, provision of a sputtering environment, transportation of substrates through the sputtering environment at rapid speeds and in a contaminant free manner, heating the substrates to optimal thermal levels for sputtering, and sputtering the substrates through a series of substantially isolated, non-crosscontaminating sputtering steps.

The apparatus of the present invention provides a high-speed in-line sputtering apparatus for producing superior multilayer films on substrates, such as disks suitable for use in Winchester-type hard disk drives. The process of the present invention provides an improved method of providing multilayer coatings to a variety of substrate types at a much greater rate than prior art methods.

Also described herein are a novel means for heating substrates to be coated, a novel sputtering magnetron design, a novel, variable speed, overhead, noncontaminating substrate transportation system and a comprehensive, centralized, programmable electronic means for controlling the apparatus and process are provided. Still further, when the process and apparatus are used for providing magnetic coatings for substrates, such as disks, to be utilized in hard disk drives using Winchester-type technology, a unique disk texturing method for improving the disk's magnetic recording properties, and a novel disk carrier (or pallet) design which contributes to uniform substrate heating characteristics in a large, single, high capacity pallet, are also provided herein.

## Claims

1. A high throughput sputtering apparatus for providing a single or multi-layer coating to the surface of a plurality of substrates, said apparatus comprising:

   a plurality of substrate carriers (1450);
   a plurality of evacuated sputtering chambers (20, 26, 28) separated by evacuated buffer chambers (18, 22 A-E) said sputtering chambers having a pressure within a pressure range which enables sputtering operations;
   means (2323) for providing a gas in said sputtering chambers in a plasma state and within a pressure range to carry out sputtering operations;
   an input end (12) for introducing the substrates mounted on said substrate carriers into said chambers without substantially disrupting said pressure of said chambers;
   means (14, 16) for rapid and uniform heating of the substrates to optimize film integrity during subsequent sputtering steps;
   means (2400, 1405, 1400) for transporting substrates on said substrate carriers through said buffer and sputtering chambers at at least a first rate and a second, different rate of speed, including a coupling mechanism (1450, 1454, 1460, 1470) mounting the substrate carriers at the top thereof such that the substrate carriers are each suspended from the coupling mechanism during movement in the chambers of the apparatus;
   shield means (1480) disposed between the transporting means and the chambers for shielding the substrates from particulate matter caused by the means for transporting the substrates; and
   an output end (29) for removing the sputtered substrates without contaminating said chambers.

2. The high throughput sputtering apparatus of claim 1 wherein said transporting means is adapted to transport substrates at a first rate of at least 2.7 feet per minute (820mm per minute) through a sequence of sputtering process steps in said sputtering chambers and a second rate of at least 6 feet per minute (1828 mm per minute) through said buffer chambers to provide successive layers of thin films on the substrates.

3. The high throughput sputtering apparatus of claims l or 2 wherein said input end includes an entrance lock chamber (12), a stationary heater chamber (14), and a passby heater chamber (16), and said output end includes an exit lock, the exit lock comprising an exit buffer chamber and an exit lock chamber.

4. The high throughput sputtering apparatus of claims 1, 2 or 3 wherein said apparatus further includes an evacuation system (MP1-MP3) for reducing the ambient pressure within the buffer and sputtering chambers, and a control system (2902), coupled to the evacuation system and transport system.

5. The high throughput sputtering apparatus of any of claims 1 to 4 wherein said transporting means is adapted to transport substrates at a first rate of speed in a range of 2.7 to 7.5 ft. per min. (820 to 2475 mm per min.) and a second rate of speed in a range of 6.0 to 12.0 ft. per min, (1980 to 3960 mm per min.)

6. The high throughput sputtering apparatus of claim 1 wherein the sputtering chambers each have relative isolation from adjacent chambers to reduce cross contamination between the coating components being sputtered onto substrates therein, said sputtering chambers being isolated from ambient atmospheric conditions, and the apparatus further including:

means (MP1-MP3) for evacuating said means for sputtering to a vacuum level within a pressure range sufficient to enable sputtering operation;
means for heating (14, 16) said plurality of substrates to a temperature conducive to sputtering said multi-layer coatings thereon, said means for heating providing a substantially uniform temperature profile over the surface of said substrate; and
control means (2902) for providing control signals to, and for receiving feedback input from, said means for sputtering, means for transporting, means for evacuating, and means for heating, said control means being programmable to automatically control said means for sputtering, means for transporting, means for evacuating and means for heating to synchronize said means for sputtering, means for transporting, and means for heating, the control means providing the feedback input to a user interface and being responsive to input from the user interface;
wherein the control means alters the control signals in real time responsive to the input from the user interface, the control means thereby allowing a system operator to precisely control the multi-layer coating applied to the substrates.

7. The sputtering apparatus of claim 6, wherein the means for heating includes a dwell heater chamber (14) wherein the substrate remains for a pre-determined period of time, and a passby heater chamber (16), through which the substrate is transported at the first or second velocity.

8. The sputtering apparatus of claim 6 or 7, wherein said control means includes position sensor means (2915) for detecting a position of the substrate in the apparatus, heat detector means (2955) for determining the heat of the substrate within the apparatus, pressure detection means (PIR1 - PIR20) for determining the pressure within the means for sputtering, and at least one microprocessing unit, for operating control software, said position detecting means. heat detecting means, and pressure detecting means comprising the feedback input to the control means, said software providing a user interface for the system operator to make said adjustments.

9. The sputtering apparatus of claim 8 wherein the means for transporting includes a plurality of motors and the control means is coupled to each of said motors, and wherein said plurality of position sensor means is associated with said sputtering and buffer chambers, the outputs of each of the position sensor means providing input signals to said control means, wherein said control means individually controls said motors to control the velocity of the substrates in said chambers.

10. A high throughput direct current magnetron sputtering process for producing single or multilayer thin films, comprising the steps of:

providing substrates to be sputtered;
creating a plurality of evacuated sputtering chambers (20,26,28) separated by evacuated buffer chambers (18,22A-E), said sputtering chambers having a pressure within a pressure range which enables sputtering operations;
providing a gas in said sputtering chambers in a plasma state and within a pressure range to carry out sputtering operations;
introducing the substrates into said chambers without substantially disrupting said pressure of said chambers:
providing rapid and uniform heating of the substrates to optimize film integrity during subsequent sputtering steps;
transporting substrates at different velocities including a first rate of at least 2.7 feet per minute (820mm per minute) through a sequence of sputtering process steps in said sputtering chambers and a second rate of 6 feet per minute (1828 mm) per minute through said buffer chambers such that the total rate of speed of the substrate is a constant for each of said substrates by supporting the substrates suspended from a moving overhead coupling mechanism at the top of the substrate to provide successive layers of thin films on the substrates, the substrates being shielded from particulate matter caused by the means for transporting the substrates, the shield means being positioned adjacent to the transporting means, and

removing the sputtered substrates without contaminating said chambers.

**11.** The sputtering process of claim 10 wherein said first rate of speed is between 2.7 ft. per min. (820mm per min.) and of 7.5 ft. per min.(2475mm per min.), and the second rate of speed is between 6.0 ft. per min (1980mm per min.), and 12.0 ft. per min (3960mm per min.)

**12.** The sputtering process of claim 10 wherein the sputtering process steps comprise the substeps of:

sputtering a chromium underlayer
sputtering a magnetic layer over the chromium layer, and
sputtering a carbon layer over the magnetic layer.

## Patentansprüche

**1.** Eine Vorrichtung zum Sputtern mit hohem Durchsatz zum Vorsehen einer einlagigen oder mehrlagigen Beschichtung auf der Oberfläche einer Mehrzahl von Substraten, wobei die Vorrichtung umfaßt:

eine Mehrzahl von Substratträgern (1450);
eine Mehrzahl von durch evakuierte Puffer-Kammern (18, 22A-E) getrennten evakuierten Sputter-Kammern (20, 26, 28), wobei die Sputter-Kammern einen Druck innerhalb eines Druckbereichs aufweisen, welcher Sputtervorgänge ermöglicht;
Mittel (2323) zum Bereitstellen eines Gases in den Sputter-Kammern in einem Plasma-Zustand sowie innerhalb eines Druckbereichs, um Sputtervorgänge durchzuführen;
ein Eingangs-Ende (12) zum Einführen der auf den Substratträgern angebrachten Substrate in die Kammern, ohne den Druck der Kammern wesentlich zu stören;
Mittel (14, 16) zum schnellen und gleichförmigen Aufheizen der Substrate, um die Filmintegrität während nachfolgender Sputterschritte zu optimieren;
Mittel (2400, 1405, 1400) zum Transportieren von Substraten auf den Substratträgern durch die Puffer- und Sputter-Kammern mit wenigstens einer ersten Geschwindigkeitsrate und einer zweiten, anderen Geschwindigkeitsrate, umfassend einen Kopplungsmechanismus (1450, 1454, 1460, 1470), welcher die Substratträger an deren Oberseite befestigt, so daß jeder Substratträger am Kopplungsmechanismus während der Bewegung in den Kammern der Vorrichtung aufgehängt ist;
zwischen den Transportmitteln und den Kammern angeordnete Abschirmmittel (1480) zum Abschirmen der Substrate vor Partikeln, welche durch die Mittel für den Transport der Substrate verursacht werden; und
ein Ausgangs-Ende (29) zum Entfernen der gesputterten Substrate, ohne die Kammern zu verunreinigen.

**2.** Vorrichtung zum Sputtern mit hohem Durchsatz nach Anspruch 1, wobei die Transportmittel dazu ausgebildet sind, Substrate mit einer ersten Rate von wenigstens 2,7 Fuß pro Minute (820 mm pro Minute) durch eine Folge von Sputter-Prozeßschritten in den Sputter-Kammern hindurch sowie mit einer zweiten Rate von wenigstens 6 Fuß pro Minute (1828 mm pro Minute) durch die Puffer-Kammern zu transportieren, um auf den Substraten aufeinanderfolgende Lagen dünner Filme vorzusehen.

**3.** Vorrichtung zum Sputtern mit hohem Durchsatz nach Anspruch 1 oder 2, wobei das Eingangs-Ende eine Eingangsschleusenkammer (12), eine stationäre Heizkammer (14) und eine Durchlaufheizkammer (16) umfaßt und wobei das Ausgangs-Ende eine Ausgangsschleuse aufweist, wobei die Ausgangsschleuse eine Ausgangs-Pufferkammer und eine Ausgangs-Schleusenkammer umfaßt.

**4.** Vorrichtung zum Sputtern mit hohem Durchsatz nach den Ansprüchen 1, 2 oder 3, wobei die Vorrichtung weiterhin ein Evakuierungssystem (MP1 - MP3) zum Reduzieren des Umgebungsdrucks innerhalb der Puffer- und Sputter-Kammern sowie ein mit dem Evakuierungssystem und dem Transportsystem gekoppeltes Steuer-/Regelsystem (2902) umfaßt.

**5.** Vorrichtung zum Sputtern mit hohem Durchsatz nach einem der Ansprüche 1 bis 4, wobei die Transportmittel dazu ausgebildet sind, Substrate mit einer ersten Geschwindigkeitsrate in einem Bereich von 2,7 bis 7,5 Fuß pro min (820 bis 2475 mm pro min) und mit einer zweiten Geschwindigkeitsrate in einem Bereich von 6,0 bis 12,0 Fuß pro min (1980 bis 3960 mm pro min) zu befördern.

**6.** Vorrichtung zum Sputtern mit hohem Durchsatz nach Anspruch 1, wobei jede Sputter-Kammer eine relative Isolierung zu ihrer angrenzenden Kammer aufweist, um eine Querverunreinigung zwischen den Beschichtungskomponenten, die dort auf die Substrate gesputtert werden, zu reduzieren, wobei die Sputter-Kammern von den umgebenden atmosphärischen Bedingungen isoliert sind und die Vorrichtung weiterhin umfaßt:

Mittel (MP1 - MP3) zum Evakuieren der Sputter-Mittel auf ein Vakuumniveau innerhalb eines Druckbereiches, welcher ausreicht, Sputtervorgänge zu ermöglichen;

Mittel zum Aufheizen (14, 16) der Mehrzahl von Substraten auf eine Temperatur, welche geeignet ist, die mehrlagigen Beschichtungen auf die Substrate zu sputtern, wobei die Aufheizmittel ein im wesentlichen gleichförmiges Temperaturprofil über die Oberfläche des Substrats vorsehen; und

Steuer-/Regelmittel (2902) zum Bereitstellen von Steuer-/Regelsignalen an die und zum Empfangen von Rückmeldungseingaben von den Sputtermitteln, den Transportmitteln, den Evakuierungsmitteln und den Aufheizmitteln, wobei die Steuer-/Regelmittel programmierbar sind, um die Sputtermittel, Transportmittel, Evakuierungsmittel sowie Aufheizmittel automatisch zu steuern/regeln, um die Sputtermittel, die Transportmittel sowie die Aufheizmittel zu synchronisieren, wobei die Steuer-/Regelmittel die Rückmeldungseingabe an eine Benutzerschnittstelle bereitstellen und auf Eingaben von der Benutzerschnittstelle reagieren; wobei die Steuer-/Regelmittel die Steuer-/Regelsignale als Reaktion auf die Eingabe von der Benutzerschnittstelle in Echtzeit verändern und die Steuer-/Regelmittel dadurch einem Systembediener erlauben, die auf die Substrate aufgebrachte mehrlagige Beschichtung präzise zu steuern.

**7.** Sputtervorrichtung nach Anspruch 6, wobei die Heizmittel eine Verweil-Heizkammer (14), worin das Substrat für eine vorbestimmte Zeitdauer verweilt, sowie eine Durchlauf-Heizkammer (16), durch welche hindurch das Substrat mit der ersten oder der zweiten Geschwindigkeit transportiert wird, umfassen.

**8.** Sputtervorrichtung nach Anspruch 6 oder 7, wobei die Steuer/Regelmittel Positionssensormittel (2915) zum Erfassen einer Position des Substrats in der Vorrichtung, Wärme-Erfassungsmittel (2955) zum Bestimmen der Wärme des Substrats innerhalb der Vorrichtung, Druckerfassungsmittel (PIR1 - PIR20) zum Bestimmen des Drucks innerhalb der Sputtermittel sowie wenigstens eine Mikroprozessoreinheit für den Betrieb der Steuer-/Regelsoftware umfassen, wobei die Positionserfassungsmittel, Wärmeerfassungsmittel sowie Druckerfassungsmittel die Rückmeldungs-Eingabe an die Steuer/Regelmittel umfassen, wobei die Software eine Benutzerschnittstelle für den Systembediener bereitstellt, um die Einstellungen vorzunehmen.

**9.** Sputtervorrichtung nach Anspruch 8, wobei die Transportmittel eine Mehrzahl von Motoren umfassen und die Steuer-/Regelmittel mit jedem dieser Motoren gekoppelt sind, und wobei die Mehrzahl von Positionssensormitteln mit den Sputter- und Pufferkammern zugeordnet ist, und die Ausgänge eines jeden Positionssensormittels Eingangssignale an die Steuer-/Regelmittel bereitstellen, wobei die Steuer-/Regelmittel die Motoren einzeln steuern/regeln, um die Geschwindigkeit der Substrate in den Kammern zu steuern/regeln.

**10.** Ein Gleichstrom-Magnetron-Sputter-Verfahren mit hohem Durchsatz zum Herstellen von einlagigen oder mehrlagigen dünnen Filmen, umfassend folgende Schritte:

Bereitstellen von zu sputternden Substraten;

Erzeugen einer Mehrzahl evakuierter, durch evakuierte Pufferkammern (18, 22A-E) getrennter Sputterkammern (20, 26, 28), wobei die Sputterkammern einen Druck innerhalb eines Druckbereichs aufweisen, welcher Sputtervorgänge ermöglicht;

Bereitstellen eines Gases in den Sputterkammern in einem Plasmazustand und innerhalb eines Druckbereichs, um Sputtervorgänge durchzuführen;

Einführen der Substrate in die Kammern, ohne den Druck der Kammern wesentlich zu stören;

Vorsehen einer schnellen und gleichförmigen Beheizung der Substrate, um die Filmintegrität während nachfolgender Sputterschritte zu optimieren;

Transportieren von Substraten mit unterschiedlichen Geschwindigkeiten, umfassend eine erste Rate von wenigstens 2,7 Fuß pro Minute (820 mm pro Minute) durch eine Folge von Sputterverfahrensschritten in den Sputterkammern und eine zweite Rate von 6 Fuß pro Minute (1828 mm pro Minute) durch die Pufferkammern, so daß die Gesamtgeschwindigkeitsrate des Substrats für jedes der Substrate eine Konstante ist, durch Aufnehmen der Substrate an der Oberseite des Substrats von einem sich bewegenden Überkopf-Kopplungsmechanismus hängend, um aufeinanderfolgende Schichten dünner Filme auf den Substraten vorzusehen, wobei die Substrate von durch die Transportmittel der Substrate verursachten Partikeln abgeschirmt werden, wobei die Abschirmmittel an die Transportmittel angrenzend angeordnet sind, sowie

Entfernen der gesputterten Substrate, ohne die Kammern zu verunreinigen.

**11.** Sputterverfahren nach Anspruch 10, wobei die erste Geschwindigkeitsrate zwischen 2,7 Fuß pro min (820 mm pro min) und 7,5 Fuß pro min (2475 mm pro min) liegt und die zweite Geschwindigkeitsrate zwischen 6,0 Fuß pro min (1980 mm pro min) und 12,0 Fuß pro min (3960 mm pro min) liegt.

**12.** Sputterverfahren nach Anspruch 10, wobei die Sputterverfahrensschritte folgende Unterschritte umfassen:

Sputtern einer Chrom-Unterschicht
Sputtern einer magnetischen Schicht über der Chromschicht sowie
Sputtern einer Kohlenstoffschicht über der magnetischen Schicht.

## Revendications

**1.** Appareil de pulvérisation cathodique à haut débit pour fournir un revêtement à une seule couche ou à plusieurs couches sur la surface d'une pluralité de substrats, ledit appareil comprenant :

une pluralité de supports de substrat (1450) ;
une pluralité de chambres de pulvérisation sous vide (20, 26, 28), séparées par des chambres de tampon sous vide (18, 22 A-E), lesdites chambres de pulvérisation ayant une pression se situant dans une plage de pression qui permet des opérations de pulvérisation ;
des moyens (2323) pour fournir un gaz dans lesdites chambres de pulvérisation à l'état de plasma et dans une plage de pression permettant de réaliser des opérations de pulvérisation ;
une extrémité d'entrée (12) pour introduire les substrats montés sur lesdits supports de substrats dans lesdites chambres sans rompre essentiellement ladite pression desdites chambres,
des moyens (14, 16) pour chauffer les substrats de façon rapide et uniforme en vue d'optimiser l'intégrité du film pendant les étapes ultérieures de pulvérisation cathodique ;
des moyens (2400, 1405, 1400) pour transférer les substrats sur lesdits supports de substrats à travers lesdites chambres de pulvérisation et lesdites chambres de tampon à une première vitesse au moins et à une seconde vitesse différente, incluant un mécanisme de couplage dont le dessus (1450, 1454, 1460, 1470) supporte les supports de substrat de telle façon que les supports de substrat soient, chacun, suspendus à partir du mécanisme de couplage pendant un déplacement à travers les chambres de l'appareil ;
des moyens de protection (1480) disposés entre les moyens de transfert et les chambres en vue de protéger les substrats de la matière particulaire provoquée par les moyens de transfert des substrats, et
une extrémité de sortie (29) pour évacuer les substrats sans contaminer lesdites chambres.

**2.** Appareil de pulvérisation cathodique à haut débit selon la revendication 1 dans lequel lesdits moyens de transfert sont adaptés pour transférer les substrats à une première vitesse d'au moins 820 mm (2,7 pieds) par minute pendant une succession d'étapes du processus de pulvérisation à travers lesdites chambres de pulvérisation et à une seconde vitesse d'au moins 1828 mm (6 pieds) par minute à travers lesdites chambres de tampon pour fournir des couches successives de films minces sur les substrats.

**3.** Appareil de pulvérisation cathodique à haut débit selon les revendications 1 ou 2, dans lequel ladite extrémité d'entrée comprend une chambre de verrouillage d'entrée (12), une chambre chauffante fixe (14), et une chambre chauffante de passage (16), et ladite extrémité de sortie comprend un verrouillage de sortie, le verrouillage de sortie comprenant une chambre de tampon de sortie et une chambre de verrouillage de sortie.

**4.** Appareil de pulvérisation cathodique à haut débit selon les revendications 1, 2 ou 3, dans lequel ledit appareil comprend, de plus, un système de mise sous vide (MP1-MP3) pour réduire la pression ambiante à l'intérieur des chambres de pulvérisation et des chambres de tampon, et un système de commande (2902), couplé au système de mise sous vide et au système de transfert.

**5.** Appareil de pulvérisation cathodique à haut débit selon l'une quelconque des revendications 1 à 4, dans lequel lesdits moyens de transfert sont adaptés pour transférer les substrats à une première vitesse située dans une plage de 820 à 2475 mm (2,7 à 7,5 pieds) par minute et à une seconde vitesse située dans une plage de 1980 à 3960 mm (6,0 à 12,0 pieds) par minute.

6. Appareil de pulvérisation cathodique à haut débit selon la revendication 1 dans lequel les chambres de pulvérisation sont, chacune, relativement isolées des chambres adjacentes afin de réduire une contamination croisée entre les composants des revêtements qui y sont pulvérisés sur les substrats, lesdites chambres de pulvérisation étant isolées des conditions atmosphériques ambiantes, l'appareil comprenant de plus:

des moyens (MP1-MP3) pour mettre sous vide lesdits moyens de pulvérisation cathodique à un niveau de vide suffisant pour permettre une opération de pulvérisation;

des moyens pour chauffer (14, 16) ladite pluralité de substrats à une température favorable à la pulvérisation sur un substrat desdits revêtements à plusieurs couches, lesdits moyens de chauffage fournissant un profil de température essentiellement uniforme sur la surface dudit substrat, et

des moyens de commande (2902) pour fournir des signaux de commande auxdits moyens de pulvérisation, moyens de transfert, moyens de création de vide et moyens de chauffage, et recevoir une entrée de réaction de la part de cesdits moyens, lesdits moyens de commande étant programmables pour commander automatiquement lesdits moyens de pulvérisation, moyens de transfert, moyens de création de vide et moyens de chauffage, afin de synchroniser lesdits moyens de pulvérisation, moyens de transfert, et moyens de chauffage, les moyens de commande fournissant l'entrée de réaction à une interface utilisateur et répondant à l'entrée venant de l'interface utilisateur ;

dans lequel les moyens de commande modifiant les signaux de commande en temps réel en réponse à l'entrée venant de l'interface utilisateur, les moyens de commande permettant de ce fait à un opérateur du système de contrôler de façon précise le revêtement à plusieurs couches appliqué aux substrats.

7. Appareil de pulvérisation cathodique selon la revendication 6, dans lequel les moyens de chauffage comprennent une chambre chauffante de stationnement (14) dans laquelle les substrats sont maintenus durant une période prédéterminée, et une chambre chauffante de passage (16), à travers laquelle le substrat est transféré à la première ou à la seconde vitesse.

8. Appareil de pulvérisation cathodique selon la revendication 6 ou 7, dans laquelle lesdits moyens de commande comprennent des moyens de détection de position (2915) pour détecter une position du substrat dans l'appareil, des moyens de détection de chaleur (2955) pour déterminer l'échauffement du substrat à l'intérieur de l'appareil, des moyens de détection de pression (PIR1-PIR20) pour déterminer la pression à l'intérieur des moyens pulvérisation, et au moins une unité de microprocesseur pour mettre en fonction un logiciel de commande, lesdits moyens de détection de position, moyens de détection de chaleur et moyens de détection de pression composant l'entrée de réaction dans les moyens de commande, ledit logiciel fournissant une interface utilisateur à l'opérateur du système pour opérer lesdits réglages.

9. Appareil de pulvérisation cathodique selon la revendication 8, dans lequel les moyens de transfert comprennent une pluralité de moteurs et dans lequel les moyens de commande sont couplés à chacun desdits moteurs, et dans lequel ladite pluralité de moyens de détection de position est associée auxdites chambres de pulvérisation et chambres de tampon, les sorties de chacun des moyens de détection de position fournissant des signaux d'entrée auxdits moyens de commande, dans lequel lesdits moyens de commande commandent individuellement lesdits moteurs pour commander la vitesse des substrats dans lesdites chambres.

10. Procédé de pulvérisation par magnétron en courant continu à haut débit pour produire des films minces à une seule couche ou à plusieurs couches, comprenant les étapes consistant à :

fournir des substrats à pulvériser ;

créer une pluralité de chambres de pulvérisation sous vide (20, 26, 28) séparées par des chambres de tampon sous vide (18, 22A-E), lesdites chambres de pulvérisation étant sous une pression située dans une plage de pression qui permet de réaliser les opérations de pulvérisation;

introduire un gaz dans lesdites chambres de pulvérisation à l'état de plasma et sous une gamme de pression pour réaliser des opérations de pulvérisation;

introduire les substrats dans lesdites chambres sans rompre essentiellement ladite pression desdites chambres ;

fournir un chauffage rapide et uniforme des substrats pour rendre optimale l'intégrité des films pendant les étapes de pulvérisation ultérieures ;

transférer les substrats à des vitesses différentes incluant une première vitesse d'au moins 820 mm (2,7 pieds) par minute à travers une succession d'étapes du procédé de pulvérisation dans lesdites chambres de pulvérisation et à une seconde vitesse de 1828 mm (6 pieds) par minute à travers lesdites chambres de tampon de façon que la vitesse totale du substrat soit constante pour chacun desdits substrats en supportant les substrats suspendus à partir d'un déplacement d'un mécanisme de couplage commandé par le haut au niveau du dessus du substrat pour fournir des couches successives de films minces sur les substrats, les substrats étant protégés de la matière particulaire provoquée par les moyens de transfert des substrats, les moyens de protection étant placés de façon adjacente aux moyens de transfert ; et
retirer les substrats pulvérisés sans contaminer lesdites chambres.

11. Procédé de pulvérisation selon la revendication 10, dans lequel ladite première vitesse se situe entre 820 mm (2,7 pieds) par minute et 2475 mm (7,5 pieds) par minute, et la seconde vitesse se situe entre 1980 mm (6,0 pieds) par minute et 3960 mm (12,0 pieds) par minute.

12. Procédé de pulvérisation cathodique selon la revendication 10 dans lequel les étapes du procédé de pulvérisation comprennent les sous-étapes consistant à:

pulvériser une sous-couche de chrome ;
pulvériser une couche magnétique sur la couche de chrome ;
pulvériser une couche de carbone sur la couche magnétique.

EP 0 577 766 B1

FIGURE 1 part A

FIGURE 2 part A

Legend

| FIGURE 1 part A | FIGURE 1 part B |
| FIGURE 2 part A | FIGURE 2 part B |

FIGURE 1
part B

FIGURE 2 part B

FIGURE 3

EP 0 577 766 B1

```
┌─────────────────────────────────────────────────────────────────────────────────────────────────┐
│  ┌─────────┐   ┌──────────┐   ┌──────────┐    ┌─────────┐   ┌──────────────────────┐              │
│  │ KITTING │ → │TEXTURING │ → │ PRECLEAN │ →  │H₂O RINSE│ → │ ULTRASONIC CLEANING  │              │
│  └─────────┘   └──────────┘   └──────────┘    └─────────┘   │ WITH CAUSTIC CLEANER │              │
│       412           414            416             418      │      ( 3V. % )       │              │
│                                                             └──────────────────────┘              │
│                                                                          420                       │
└───────────────────────────────────────────────────────────────────────────────────────────────────┘
```

KITTING — 412  
TEXTURING — 414  
PRECLEAN — 416  
H₂O RINSE — 418  
ULTRASONIC CLEANING WITH CAUSTIC CLEANER ( 3V. % ) — 420

SPONGE SCRUBBING IN H₂O — 422  
ULTRASONIC CLEANING WITH HOT DEIONIZED WATER — 424  
SCRUBBING and DEIONIZED WATER SPRAY RINSE — 426  
OVER-FLOW RINSE WITH DEION-IZED WATER — 428  
ULTRA-SONIC CLEANING WITH WARM FREON TES — 430  
435

COOL FREON TES RINSE — 432  
VAPOR DISPLACE-MENT DRY IN WARM FREON TES — 434

PALLET LOADING — 450  
SYSTEM EVACUATION — 472  
SUBSTRATE HEATING — 476  
SPUTTERING — 478  
PALLET UNLOADING — 480  
460

PALLET TRANSPORT — 474

## FIGURE 4

FIGURE 5

FIGURE 7

FIGURE 6A

FIGURE 6B

FIGURE 8

FIGURE 9

FIGURE 10

FIGURE II

FIGURE 12
part A

*FIGURE 12 part B*

FIGURE 12
part C

FIGURE 12
part D

| | |
|---|---|
| part A | part B |
| part C | part D |

*Legend*

EP 0 577 766 B1

FIGURE 13

FIGURE 14

FIGURE 16

FIGURE 15

FIGURE 17

FIGURE 20

FIGURE 18

FIGURE 19

EP 0 577 766 B1

FIGURE 21

FIGURE 22

FIGURE 23

61

FIGURE 24

FIGURE 26

FIGURE 25

FIGURE 27A

FIGURE 27B

FIGURE 28

FIGURE 29

# FIGURE 30 part A

USER INITIATE

**3020** — CHECK SEQUENCE
PUMP DOWN SYSTEM ENABLE
START PDSE TIMER = 60 S

**3022** — SET RVI-RV5 CLOSED
READ RVS1, RVS3, RVS5, RVS7, RVS9
ENABLE MP1-MP3, STAGGERED
OPEN DOORS 2-11
DOOR TIMER LIM = 3S
CLOSE DOORS 1 & 12
ENABLE CY1 - CY 8

**3012** — ARGON PRESSURE READOUT
SUBSTRATE TEMPERATURE
POWER SUPPLY OUTPUT SETPOINT
MOTOR SPEED SETPOINTS
ION/PIRANI GAUGE READINGS

**3100** — CRYOPUMP REGENERATION

**3024** — IF PIR2, PIR6 PIR 11, PIR15, PIR16 LESS THAN 250m TORR

**3082** — MAINTENANCE

**3010** — SECTION 1-5 PUMP SEQUENCE = ROUGH PUMP SEC = 1-5

**3026** — OPEN BAFFLE 1210, 1214

**3028** — SYSTEM ROUGHED DOWN (CROSSOVER)

**3029** — CLOSE BL1 - BL3, MP1 - MP3

**3080** — GAS FLOW
GF1 - GF 8
RGA ISOLATION HEATER SETPTS,
PWR SUP. & MOT. SPEED SETPTS.
HEATER DELAY & DWELL TIMERS
PAUSE LATCH
EMERGENCY STOP

A   B   C   D

EP 0 577 766 B1

FIGURE 30
part B

A B C D

IF PIR I PIR 2, OPEN HVI-HV2
IF PIR 6, OPEN HV3-HV5
IF PIR II, OPEN HV6-HV8
IF PIR 15, OPEN HV 12
IF PIR 16, OPEN HV 9 - HV II  —3030

SYSTEM PUMPED DOWN
HIGH VACUUM STANDBY  —3032

IF USER
INPUT & PUMPED
DOWN  —3032a

3015

CHAMBER VENT CONTROL
ALL RVS CLOSED
OPEN CVI - CV5
IF PIR I, PIR 17,
OPEN CVI & CV 5

3070

AUTO RUN PREPARATION
SET GF 3, GF 5, GF 7, GF 8
CHECK: DOORFAULT, MPI, MP3, BLI, BL3
COMPUTER SIGNAL
HEATER CONTROL
CHECK: DI-D3, DIO-DI2 CLOSED;
D4-D9 OPEN
THROTTLE HV2- HV I2
ENABLE MPI/BL I, MP3/ BL 3  —3034

COOLANT CONTROL
H₂O VLV-CHROME CHAMBER 20
MAGNETIC CHAMBER 26
CARBON CHAMBER 28
HEATER SHIELDS

HEATER CONTROL
SET ALL HEATERS LOW
SET ALL HEATERS HIGH

E F G H I

3075

EP 0 577 766 B1

68

EP 0 577 766 B1

E  F  G  H

## FIGURE 30
## part C

I

```
       ◇  IF PREPED AND
          USER INITIATE        ──3035
```

──3050

**AUTO MODE ENABLED**
THROTTLE MAINTAINED HV2-HV12
ENABLE RETURN CONVEYOR

MOTOR ASSEMBLY/DOOR CONTROL *FIG. 32*
LOAD/EXIT LOCK SEQUENCE                  ──3200
HIGH HEAT CONTROL
HIGH POWER SUPPLY CONTROL

SPUTTERING POWER SUPPLIES
ON OFF
HIGH BY SENSOR INPUT
ARC FAILURE

FAULTS INPUT: NO ARGON NO FIX COMM, MOTOR FAULTS, NO VACUUM
CRYO > 20K LLVENT > 60S, EXLOCK VENT > 60S, INTERLOCKS
MP FAIL, ARC DETECT, APS, HEATER ALARM/FAULT
P.S. SETPOINT ALARMS, DOOR FAULTS, VALVE FAULTS, COOLANT FLOW FAULTS

FIGURE 31
part A

FIGURE 31
*part B*

FIGURE 31
part B

A

BEGIN PURGE TIMER = 7200 s

NIFI OFF
NIHI OFF

3140

ROUGHING SEQ
IF LINE PRESS. MADE
& BL2 ENABLED
& NOT PIR3        N

Y

OPEN CRI
OPEN SVIVI
START ROUGH TIMER = 600 s

IF ROUGH TIMER
= 600 s        N

Y

FAULT

IF PIR3 TRUE        N

Y

B

C

EP 0 577 766 B1

FIGURE 31
part C

EP 0 577 766 B1

B

C

$N \leq 5$

FAULT ——$N=6$—— COUNT N,
N <= 5

CLOSE CRI
ROR TIMER = 30s

ROUGH TEST
IF PIR3 & ROR
TIMER < 30 ——$N$——

3150

IF PIR3 & TIMER
= 30

COOL DOWN

FIGURE 32A

FIGURE 32 B

EP 0 577 766 B1

SEN 21
SEN 19
SEN 18
SEN 15 or SEN 16
↓ M7(SLOW)

SEN 21
M9 S
SEN 16 or SEN 18
↓ M8(SLOW)

SEN 27
DROP 55, DROP 65
SEN 21
SEN 25
↓ M9(FAST)

DROP 55, DROP 65
SEN 27
SEN 21, SEN 22 or SEN 24
↓ M10(FAST)

SEN 33
SEN 31
SEN 30
SEN 27 or SEN 28
↓ M11(SLOW)

B ▷ → CHROME / M8(SLOW) → DWELL 2 / M9(SLOW) → BUFFER 2 / M10(FAST) → DWELL 3 / M11(FAST) → MAG / M12(SLOW)

SEN 15 or SEN 16 / M7 S / SEN 21
SEN 16 / SEN 17 / SEN 18
SEN 18 or SEN 19 / SEN 21
SEN 19 / SEN 20 / SEN 21
SEN 21 or SEN 22 or SEN 24 / SEN 27 / DROP 55, DROP 65
SEN 21 - SEN 25
DROP 55 / DROP 65 / SEN 24 or SEN 25 / SEN 27
SEN 25 / SEN 26 / SEN 27 / SEN 24
SEN 27 or SEN 28 or SEN 30 / M9 S / SEN 33
SEN 28 / SEN 29 / SEN 30 / SEN 27

SEN 33
M11 S
SEN 30 or
SEN 27 or SEN 28
↓ M12(SLOW)

SEN 39
SEN 37
SEN 33
DROP 85, DROP 75
↓ M13(FAST)

SEN 39
SEN 34 or
SEN 33 or SEN 36
DROP 85, DROP 75
↓ M14(FAST)

SEN 42
SEN 39 or SEN 40
↓ M15(SLOW)

SEN 40 or SEN 41
or SEN 42
M 16 S
↓ M16(SLOW)

→ DWELL 4 / M13(SLOW) → BUFFER 3 / M14(FAST) → DWELL 5 / M15(FAST) → CARBON / M16(SLOW) → DWELL 6 / M17(SLOW) → ▷ C

SEN 30 or / SEN 31 / SEN 33
SEN 31 / SEN 32 / SEN 33 / SEN 30
DROP 75 / DROP 85 / SEN 33 or SEN 34 or SEN 36 / SEN 39
SEN 34 / SEN 35 / SEN 36
DROP 75 / DROP 85 / SEN 36 or / SEN 37 / SEN 39
SEN 34 / SEN 35 / SEN 36 / SEN 37 / SEN 38, SEN 39
SEN 39 or SEN 40 or SEN 41 or SEN 42 / M15 S
SEN 43 - SEN 45 / SEN 42
SEN 42 or SEN 43 / SEN 45

*FIGURE 32 C*

FIGURE 32D

FIGURE 32 E

EP 0 577 766 B1